# EUROPEAN PATENT SPECIFICATION

(11) **EP 4 306 613 B1**
(45) Date of publication and mention of the grant of the patent: **09.10.2024**
(21) Application number: 23184687.4
(22) Date of filing: 11.07.2023
(51) Int. Cl.: C09K 11/06, H10K 85/30, H10K 50/11

(54) **ORGANOMETALLIC COMPOUND, LIGHT-EMITTING DEVICE INCLUDING THE ORGANOMETALLIC COMPOUND, AND ELECTRONIC APPARATUS AND ELECTRONIC DEVICE INCLUDING THE LIGHT-EMITTING DEVICE**
ORGANOMETALLISCHE VERBINDUNG, LICHTEMITTIERENDE VORRICHTUNG MIT DER ORGANOMETALLISCHEN VERBINDUNG UND ELEKTRONISCHE VORRICHTUNG MIT DER LICHTEMITTIERENDEN VORRICHTUNG
COMPOSÉ ORGANOMÉTALLIQUE, DISPOSITIF ÉLECTROLUMINESCENT COMPRENANT LE COMPOSÉ ORGANOMÉTALLIQUE, ET APPAREIL ÉLECTRONIQUE ET DISPOSITIF ÉLECTRONIQUE COMPRENANT LE DISPOSITIF ÉLECTROLUMINESCENT

(30) Priority: 13.07.2022 KR 20220086546
(43) Date of publication of application: 17.01.2024
(73) Proprietor: Samsung Display Co., Ltd., Yongin-si, Gyeonggi-do 17113 (KR)
(72) Inventor: Kim, Sohae, 17113 Giheung-gu, Yongin-si, Gyeonggi-do (KR); Cho, Sooryun, 17113 Giheung-gu, Yongin-si, Gyeonggi-do (KR); Kim, Gyeongheon, 17113 Giheung-gu, Yongin-si, Gyeonggi-do (KR); Yoo, Dongsun, 17113 Giheung-gu, Yongin-si, Gyeonggi-do (KR); Kim, Jihye, 17113 Giheung-gu, Yongin-si, Gyeonggi-do (KR); Kim, Hoilim, 17113 Giheung-gu, Yongin-si, Gyeonggi-do (KR); Park, Saerom, 17113 Giheung-gu, Yongin-si, Gyeonggi-do (KR); Cho, Youngmi, 17113 Giheung-gu, Yongin-si, Gyeonggi-do (KR)
(74) Representative: Dr. Weitzel & Partner

(56) References cited:
- US-A1- 2005 031 903

## Description

### BACKGROUND

### 1. Field

The present invention relates to an organometallic compound, a light-emitting device including the organometallic compound, an electronic apparatus and an electronic device including the light-emitting device.

### 2. Description of the Related Art

Self-emissive devices (for example, organic light-emitting devices) in light-emitting devices have relatively wide viewing angles, high contrast ratios, short response times, and excellent or suitable characteristics in terms of luminance, driving voltage, and response speed.

In a light-emitting device, a first electrode is located on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transition and relax from an excited state to a ground state to thereby generate light.

Examples of light-emitting devices comprising organometallic compounds are disclosed in US2005031903.

### SUMMARY

An organometallic compound according to the invention having high emission efficiency and long lifespan is defined by the features of claim 1. The dependent claims describe preferred embodiments, a light-emitting device including the organometallic compound, an electronic apparatus and an electronic device including the light-emitting device.

Additional aspects will be set forth in part in the description which follows and, in part, will be apparent from the description, or may be learned by practice of the presented embodiments of the disclosure.

According to the present invention an organometallic compound is represented by Formula 1

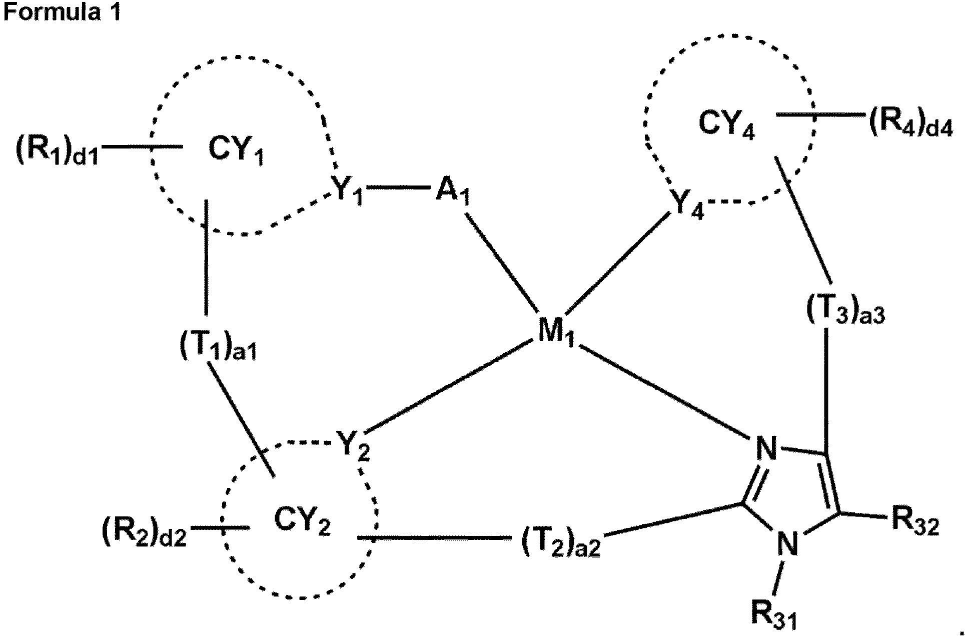

In Formula 1,
M₁ is a transition metal,
CY₁, CY₂, and CY₄ are each independently a C₃-C₆₀ carbocyclic group or a C₁-C₆₀ heterocyclic group,
Y₁, Y₂, and Y₄ are each independently C or N,
A₁ is O or S,
T₁ to T₃ are each independently a single bond, a double bond, *-N[(L₁)_{b1}-(R₁ₐ)]-*', *-B(R₁ₐ)-*', *-P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*', or *-C=C-*',
a1 to a3 are each independently an integer from 1 to 3,
* and *' each indicate a binding site to a neighboring atom,
L₁ is a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
b1 is an integer from 1 to 3,
R₁, R₂, R₃₁, R₃₂, R₄, R₁ₐ, and R_{1b} are each independently hydrogen, deuterium (D), -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
d1, d2, and d4 are each independently an integer from 0 to 20,
neighboring two or more groups of R₁, R₂, R₃₁, R₃₂, R₄, R₁ₐ, and R_{1b} may optionally be bonded to each other to form a C₅-C₆₀ carbocyclic group that is unsubstituted or substituted with at least one R₁₀ₐ or a C₂-C₆₀ heterocyclic group that is unsubstituted or substituted with at least one R₁₀ₐ,
R₁₀ₐ is:
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof, or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ are each independently hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof, a C₇-C₆₀ arylalkyl group, or a C₂-C₆₀ heteroarylalkyl group.

According to one or more embodiments of the present disclosure, a light-emitting device may include a first electrode, a second electrode facing the first electrode, an interlayer between the first electrode and the second electrode and including an emission layer, and at least one of the organometallic compound.

According to one or more embodiments of the present disclosure, an electronic apparatus may include the light-emitting device.

According to one or more embodiments of the present disclosure, an electronic device may include the light-emitting device.

### BRIEF DESCRIPTION OF THE DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. The above and other aspects, features, and advantages of certain embodiments of the disclosure will be more apparent from the following description taken in conjunction with the accompanying drawings, in which:
FIG. 1 is a schematic view of a structure of a light-emitting device according to one or more embodiments of the present disclosure;
FIG. 2 is a schematic view of a structure of an electronic apparatus according to one or more embodiments of the present disclosure;
FIG. 3 is a schematic view of a structure of an electronic apparatus according to one or more embodiments of the present disclosure;
FIG. 4 is a schematic perspective view of an electronic device 1 including a light-emitting device according to one or more embodiments of the present disclosure;
FIG. 5 is a schematic view illustrating an exterior of a vehicle 1000 as an electronic device including a light-emitting device according to one or more embodiments of the present disclosure;
FIGs. 6A-6C are each a schematic view illustrating an interior of a vehicle 1000 according to one or more embodiments of the present disclosure; and
FIG. 7 is a view illustrating an NMR graph of Compound D11 synthesized according to Synthesis Example 1 of the present disclosure.

### DETAILED DESCRIPTION

Reference will now be made in more detail to embodiments, examples of which are illustrated in the accompanying drawings, wherein like reference numerals refer to like elements throughout the present disclosure, and duplicative descriptions thereof may not be provided for conciseness. In this regard, embodiments of the present disclosure may have different forms and should not be construed as being limited to the descriptions set forth herein. Accordingly, embodiments of the present disclosure are merely described, by referring to the drawings, to explain aspects of the present disclosure. As utilized herein, the terms "and/or" or "or" may include any and all combinations of one or more of the associated listed items. Throughout the present disclosure, the expression "at least one of a, b or c", "at least one selected from a, b, and c", etc., may indicate only a, only b, only c, both (e.g., simultaneously) a and b, both (e.g., simultaneously) a and c, both (e.g., simultaneously) b and c, all of a, b, and c, or variations thereof.

In one or more embodiments, an organometallic compound may be represented by Formula 1: 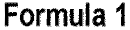 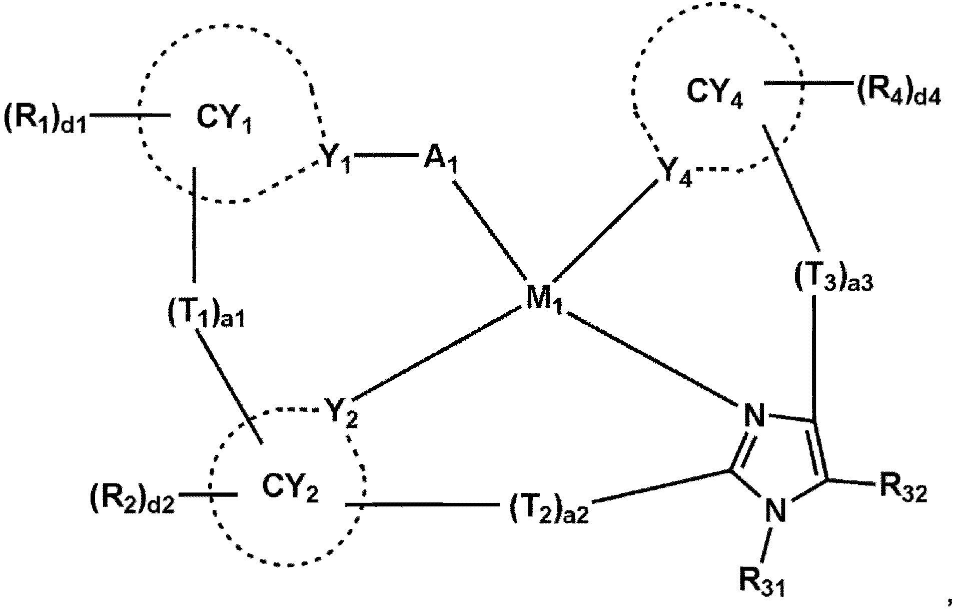
wherein, in Formula 1,
M₁ may be a transition metal.

In one or more embodiments, M₁ may be platinum (Pt), palladium (Pd), copper (Cu), silver (Ag), gold (Au), rhodium (Rh), iridium (Ir), ruthenium (Ru), or osmium (Os).

CY₁, CY₂, and CY₄ may each independently be a C₃-C₆₀ carbocyclic group or a C₁-C₆₀ heterocyclic group.

In one or more embodiments, CY₁ and CY₂ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzotriazole, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In one or more embodiments, CY₁ may be a group represented by one selected from among Formulae CY1-1 to CY1-70, and CY₂ may be a group represented by one selected from among Formulae CY2-1 to CY2-14: 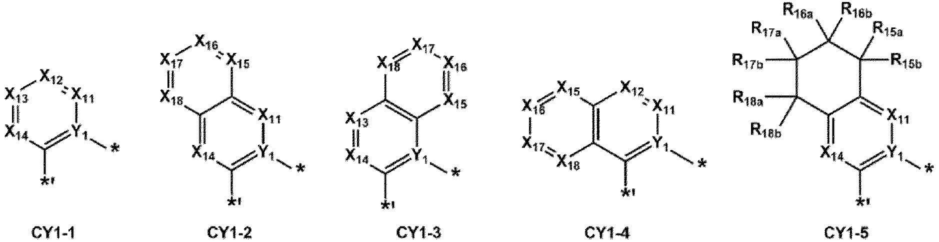 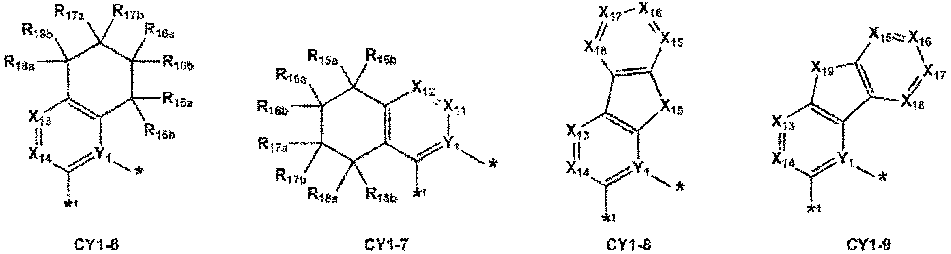 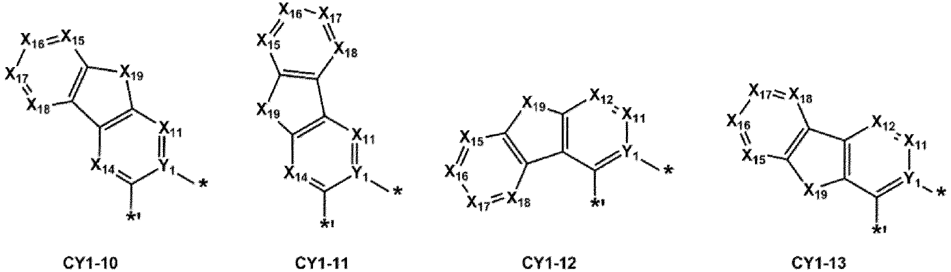 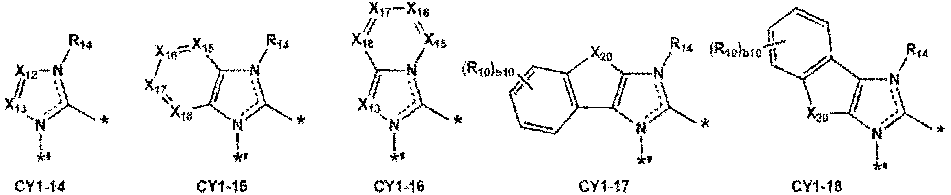 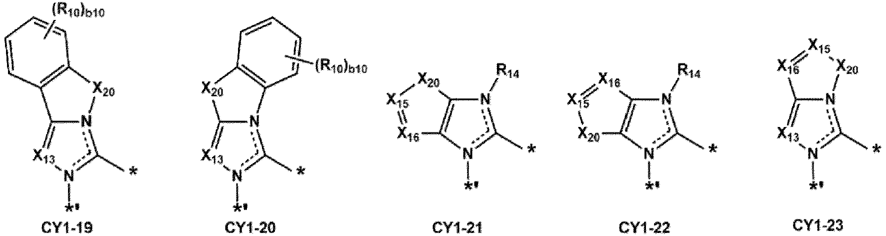 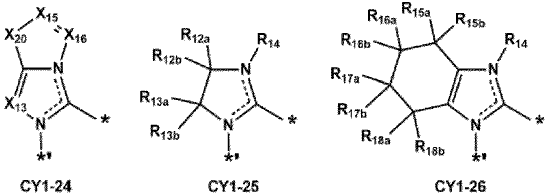 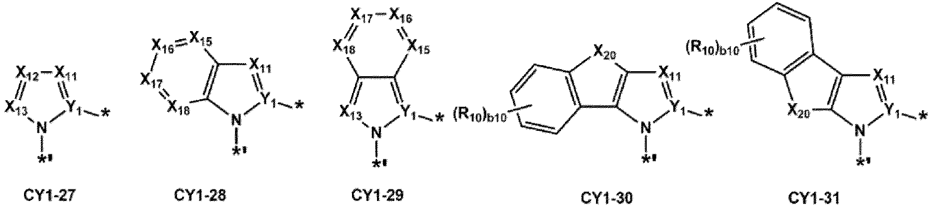 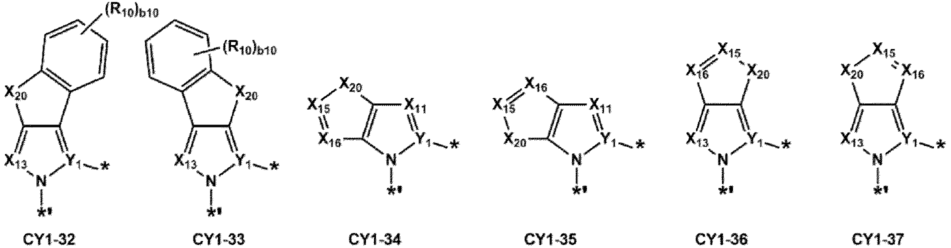 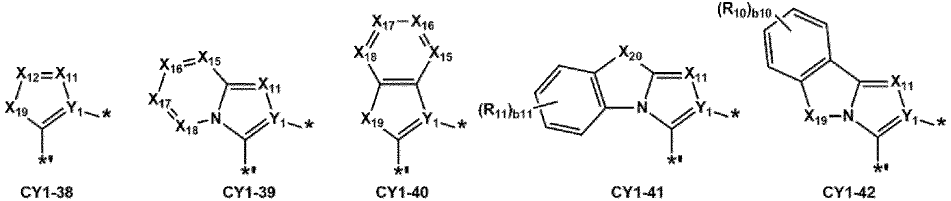 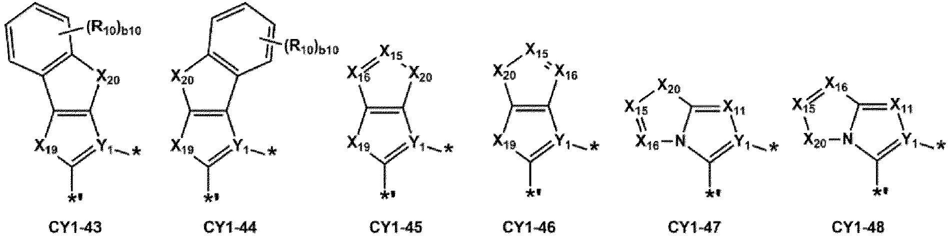 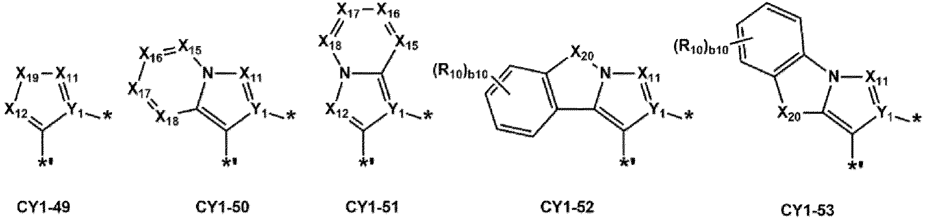 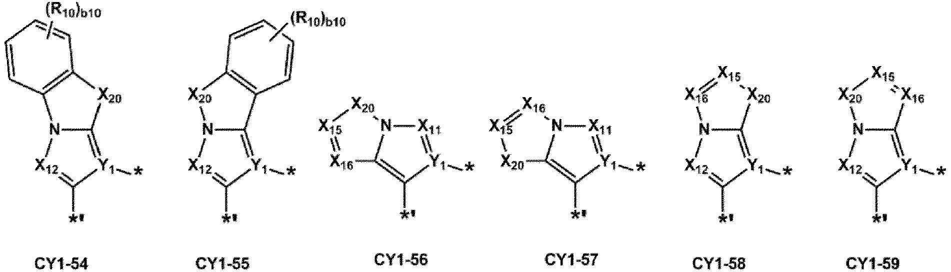 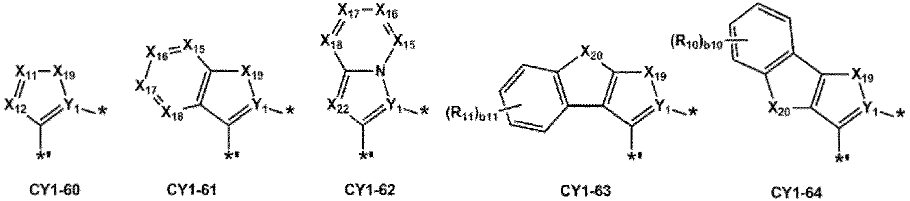 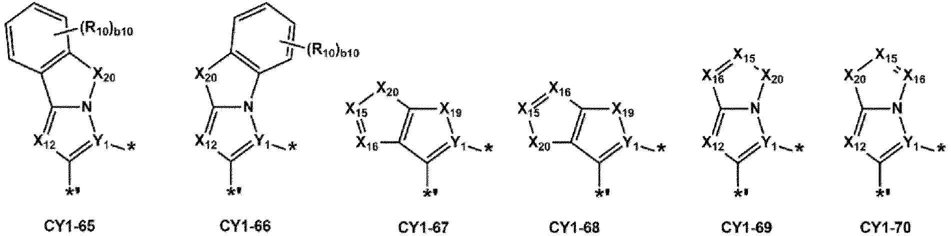 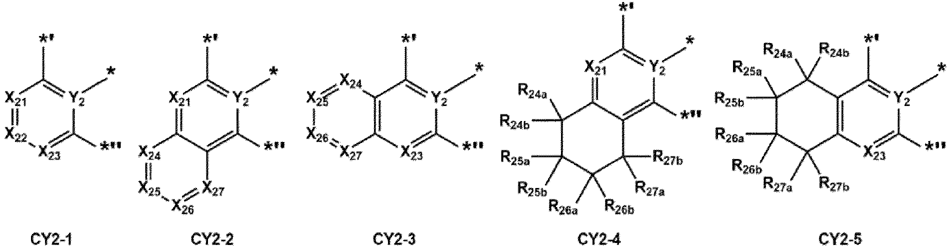 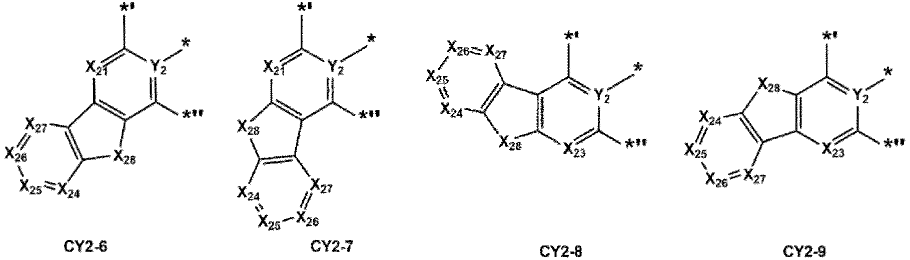 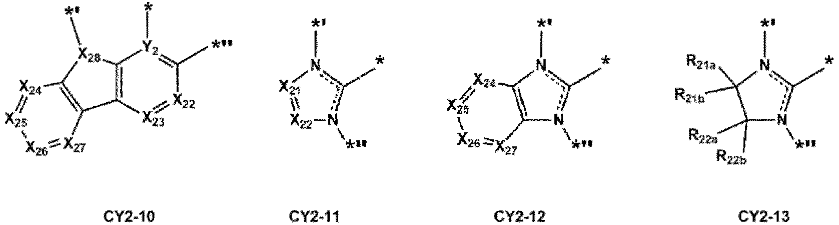 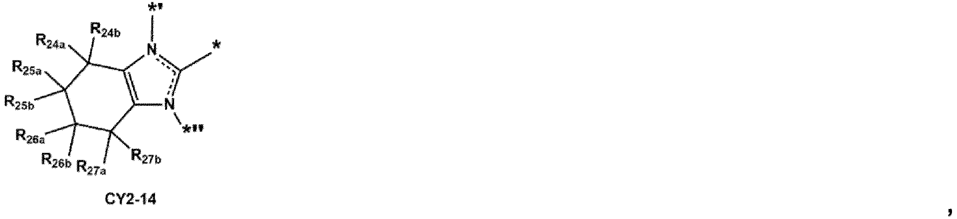
wherein, in Formula CY1-1 to CY1-70 and Formulae CY2-1 to CY2-14,
Y₁ and Y₂ may each independently be C or N,
X₁₁ may be C(R₁₁) or N, X₁₂ may be C(R₁₂) or N, X₁₃ may be C(R₁₃) or N, X₁₄ may be C(R₁₄) or N, X₁₅ may be C(R₁₅) or N, X₁₆ may be C(R₁₆) or N, X₁₇ may be C(R₁₇) or N, and X₁₈ may be C(R₁₈) or N,
X₁₉ may be C(R₁₉ₐ)(R_{19b}), Si(R₁₉ₐ)(R_{19b}), N(R₁₉), O, or S,
X₂₀ may be C(R₂₀ₐ)(R_{20b}), Si(R₂₀ₐ)(R_{20b}), N(R₂₀), O, or S,
X₂₁ may be C(R₂₁) or N, X₂₂ may be C(R₂₂) or N, X₂₃ may be C(R₂₃) or N, X₂₄ may be C(R₂₄) or N, X₂₅ may be C(R₂₅) or N, X₂₆ may be C(R₂₆) or N, and X₂₇ may be C(R₂₇) or N,
X₂₈ may be C(R₂₈ₐ)(R_{28b}), Si(R₂₈ₐ)(R_{28b}), N(R₂₈), O, or S,
R₁₀ to R₂₀, R₁₂ₐ, R₁₃ₐ, R₁₅ₐ to R₂₀ₐ, R_{12b}, R_{13b}, and R_{15b} to R_{20b} may each independently be the same as in the description of R₁,
R₂₁ to R₂₈, R₂₁ₐ, R₂₂ₐ, R₂₄ₐ to R₂₈ₐ, R_{21b}, R_{22b}, and R_{24b} to R_{28b} may each independently be the same as in the description of R₂,
b10 and b11 may each independently be an integer from 1 to 4,
* indicates a binding site to M₁, and
*' in Formulae CY1-1 to CY1-70 indicates a binding site to T₁, *' in Formulae CY2-1 to CY2-14 indicates a binding site to T₁, and *" in Formulae CY2-1 to CY2-14 indicates a binding site to T₂.

In one or more embodiments, CY₄ may be a polycyclic group including a condensed ring of at least two rings (for example, a benzene group, a pyridine group, a pyrimidine group, a triazine group, a tetrazine group, a cyclohexane group, etc.).

In one or more embodiments, CY₄ may be a group represented by Formula 4: 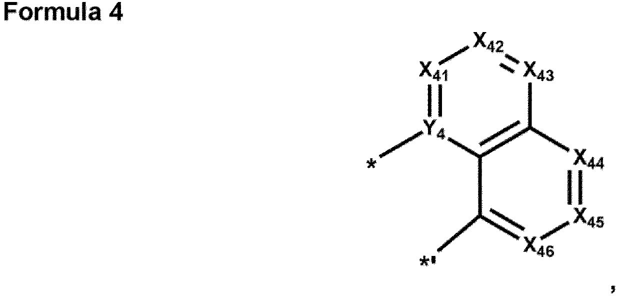
wherein, in Formula 4,
Y₄ may be C or N,
X₄₁ may be C(R₄₁) or N, X₄₂ may be C(R₄₂) or N, X₄₃ may be C(R₄₃) or N, X₄₄ may be C(R₄₄) or N, X₄₅ may be C(R₄₅) or N, and X₄₆ may be C(R₄₆) or N,
R₄₁ to R₄₆ may each be the same as in the description of R₄,
two or more groups of R₄₁ to R₄₆ may optionally be bound to each other to form a C₅-C₆₀ carbocyclic group that is unsubstituted or substituted with at least one R₁₀ₐ or a C₂-C₆₀ heterocyclic group that is unsubstituted or substituted with at least one R₁₀ₐ, and
*' indicates a binding site to T₃ in Formula 1, and * indicates a binding site to M₁ in Formula 1.

In one or more embodiments, CY₄ may be a group represented by one selected from among Formulae 4-1 to 4-5: 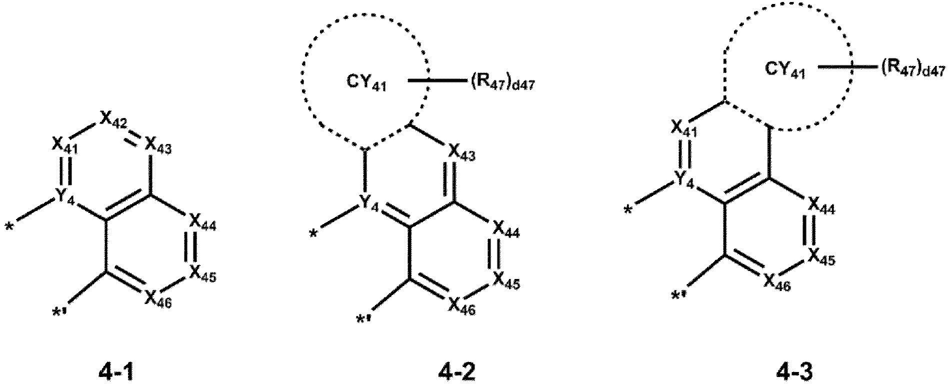 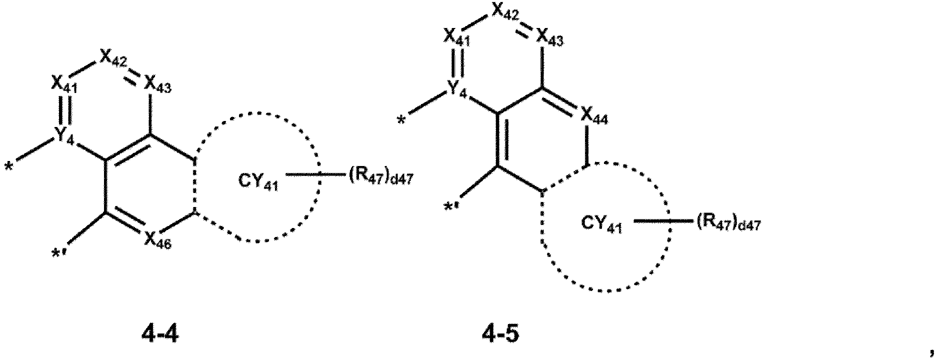
wherein, in Formulae 4-1 to 4-5,
Y₄ may be C or N,
X₄₁ may be C(R₄₁) or N, X₄₂ may be C(R₄₂) or N, X₄₃ may be C(R₄₃) or N, X₄₄ may be C(R₄₄) or N, X₄₅ may be C(R₄₅) or N, and X₄₆ may be C(R₄₆) or N,
CY₄₁ may be a C₃-C₂₀ carbocyclic group or a C₁-C₂₀ heterocyclic group,
R₄₁ to R₄₇ may each be the same as in the description of R₄,
d47 may be an integer from 0 to 10, and
*' indicates a binding site to T₃ in Formula 1, and * indicates a binding site to M₁ in Formula 1.
Y₁, Y₂, and Y₄ may each independently be C or N.
Y₁ may be C, Y₂ may be N, and Y₄ may be C; Y₁ may be C, Y₂ may be C, and Y₄ may be N; Y₁ may be C, Y₂ may be N, and Y₄ may be N; Y₁ may be C, Y₂ may be C, and Y₄ may be C; Y₁ may be N, Y₂ may be N, and Y₄ may be C; Y₁ may be N, Y₂ may be C, and Y₄ may be N; Y₁ may be N, Y₂ may be N, and Y₄ may be N; or Y₁ may be N, Y₂ may be C, and Y₄ may be C.
In one or more embodiments, at least one selected from among Y₂ and Y₄ may be N.
For example, in some embodiments, Y₂ may be N and Y₄ may be C; in some embodiments, Y₂ may be C and Y₄ may be N; in some embodiments, Y₂ may be N and Y₄ may be N.
A₁ may be O or S.
T₁ to T₃ may each independently be a single bond, a double bond, *-N[(L₁)_{b1}-(R₁ₐ)]-*', *-B(R₁ₐ)-*', *-P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*', or *-C=C-*'.

In one or more embodiments, at least one selected from among T₁ to T₃ may be a single bond. For example, in some embodiments, T₁ and T₃ may be a single bond, in some embodiments, T₂ and T₃ may be a single bond, in some embodiments, T₁ to T₃ may each be a single bond.
a1 to a3 may each independently be an integer from 1 to 3.
* and *' each indicate a binding site to a neighboring atom.
L₁ may be a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.
b1 may be an integer from 1 to 3.
R₁, R₂, R₃₁, R₃₂, R₄, R₁ₐ, and R_{1b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂).

In one or more embodiments, R₁, R₂, R₃₁, R₃₂, R₄, R₁ₐ, and R_{1b} may each independently be: hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₇-C₁₆ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium,-F,-Cl,-Br,-I,-CD₃,-CD₂H,-CDH₂,-CF₃,-CF₂H,-CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
wherein Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In one or more embodiments, R₁, R₂, R₃₁, R₃₂, R₄, R₁ₐ, and R_{1b} may each independently be:
hydrogen, deuterium, -F, -Cl, -Br, -I, -CD₃, -CD₂H, -CDH₂, -CF₃, -CF₂H, - CFH₂, a cyano group, a nitro group, a C₁-C₆₀ alkyl group, a C₂-C₆₀ alkenyl group, a C₂-C₆₀ alkynyl group, or a C₁-C₆₀ alkoxy group;
a group represented by one selected from among Formulae 9-1 to 9-61 or a group represented by one selected from among Formulae 10-1 to 10-246; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂), 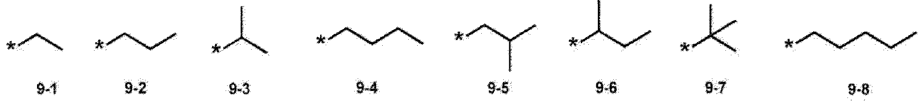 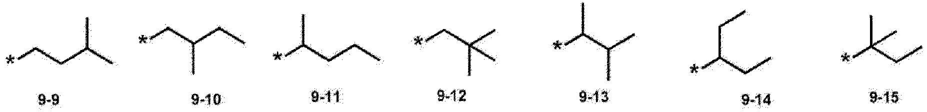 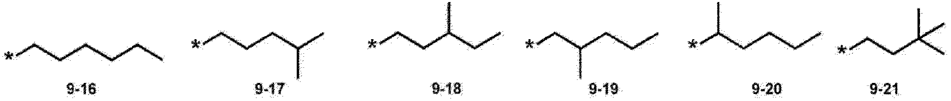 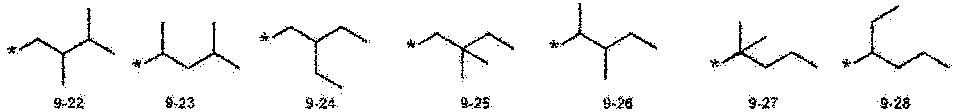 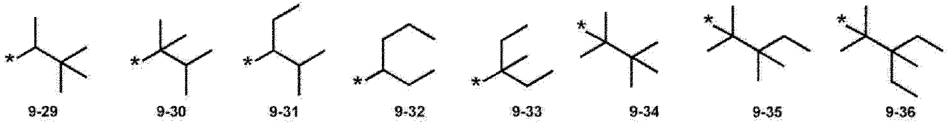 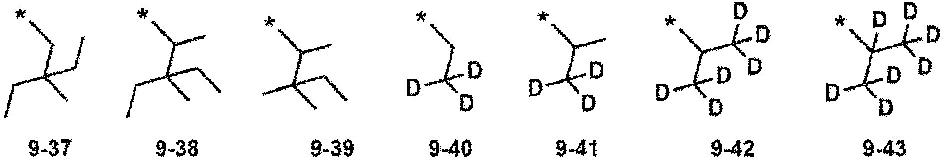 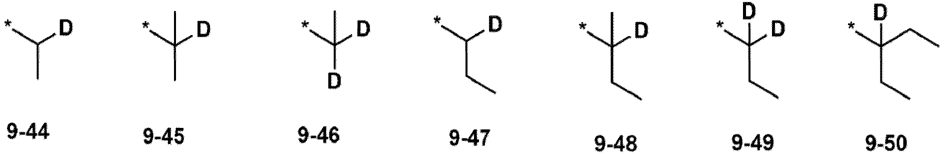 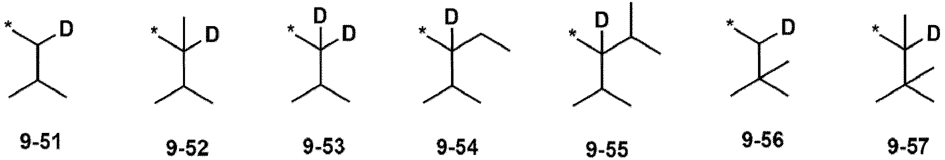 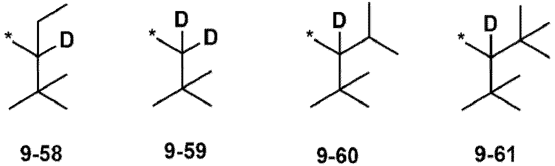 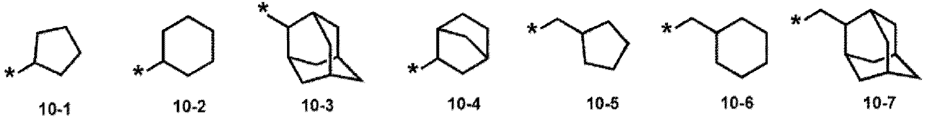 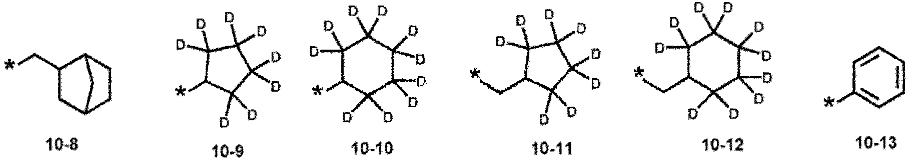 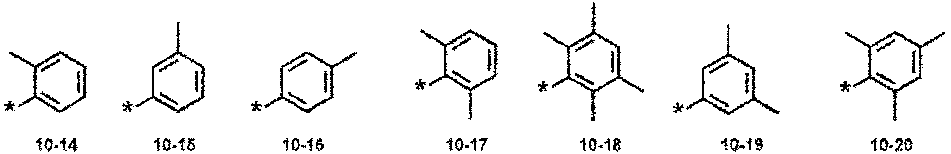 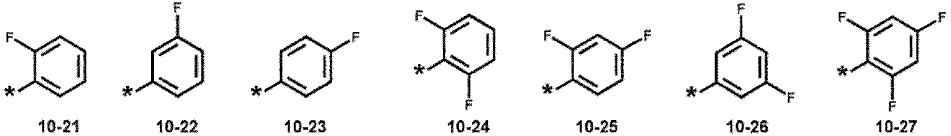 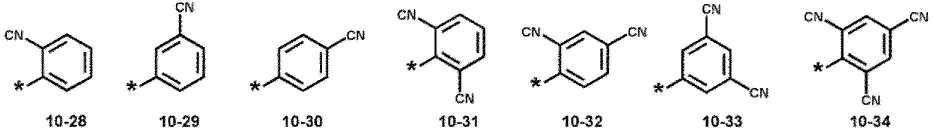 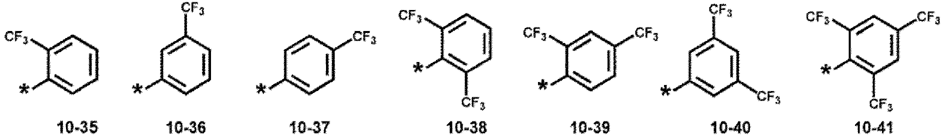 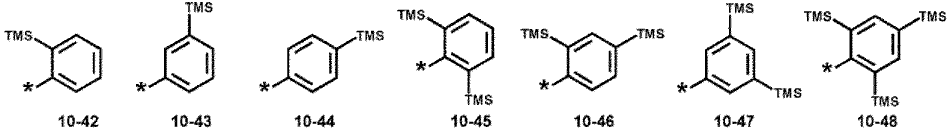 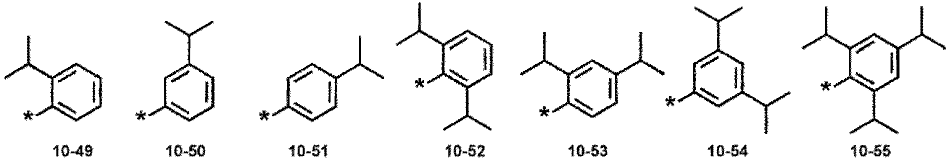 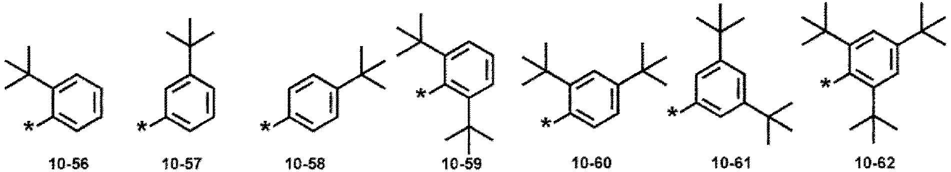 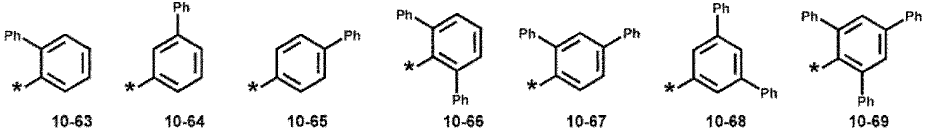 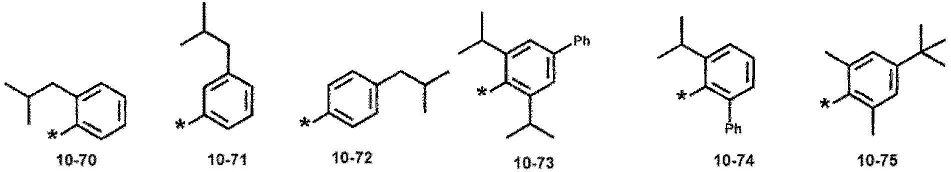 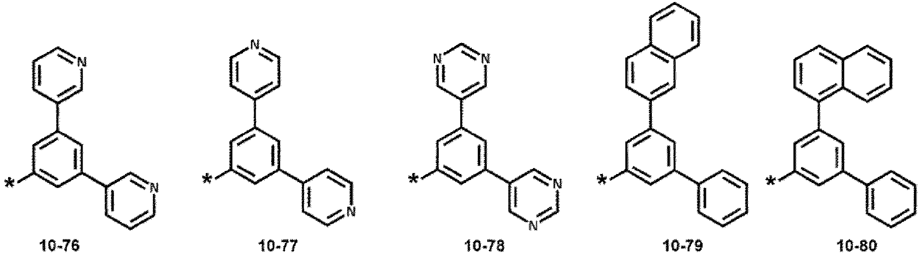 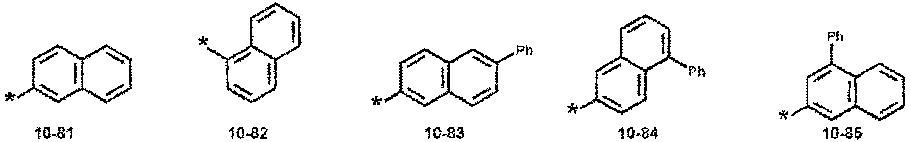 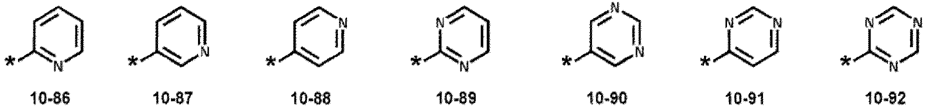 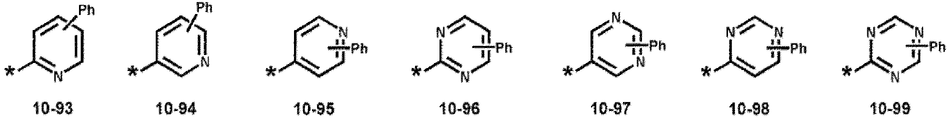 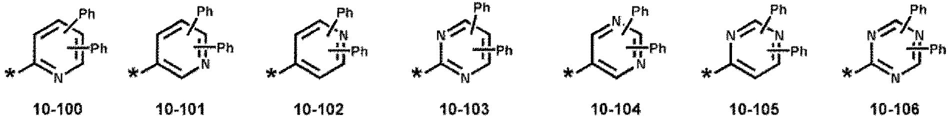 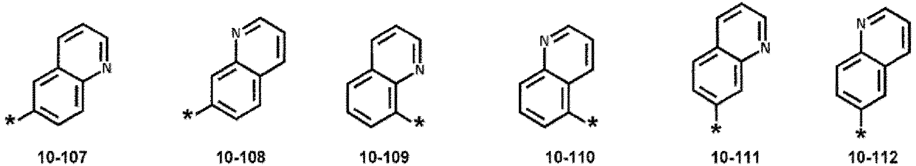 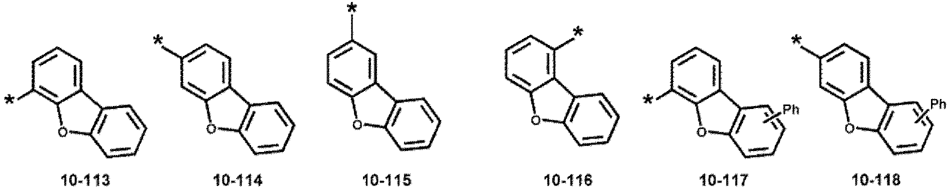 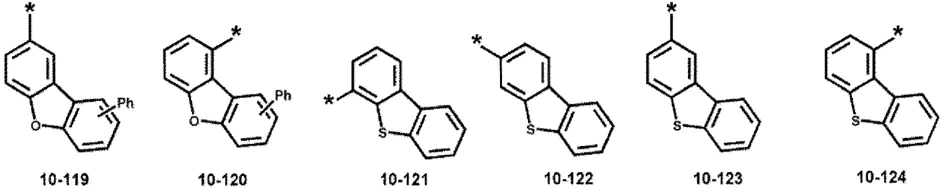 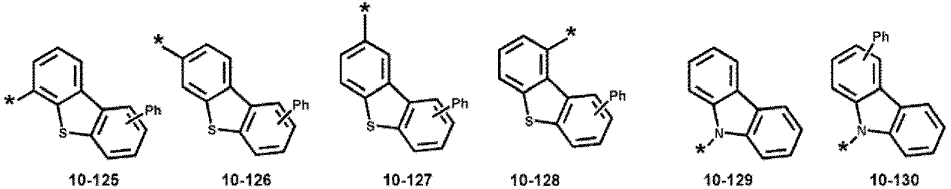 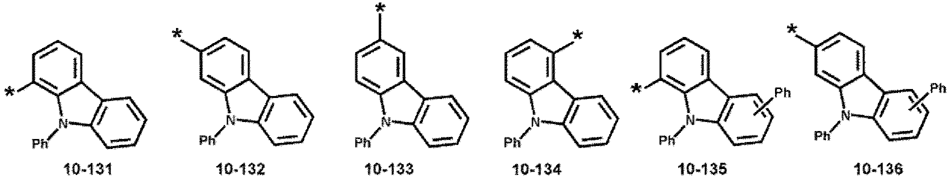 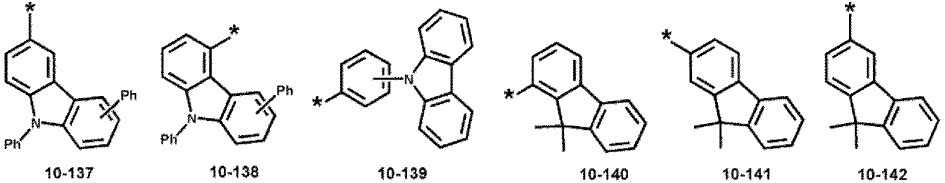 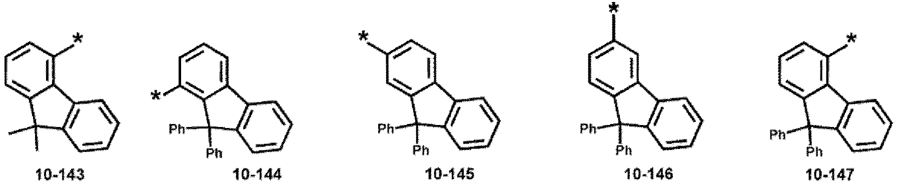 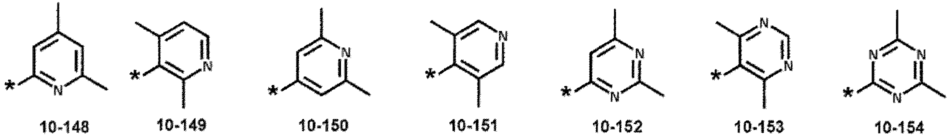 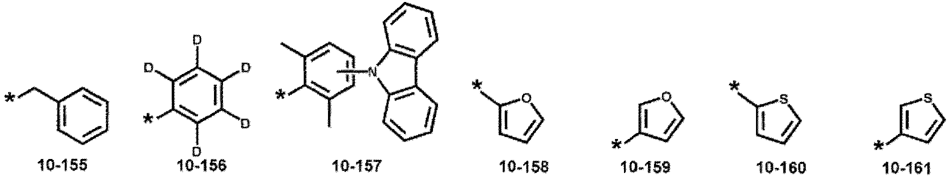 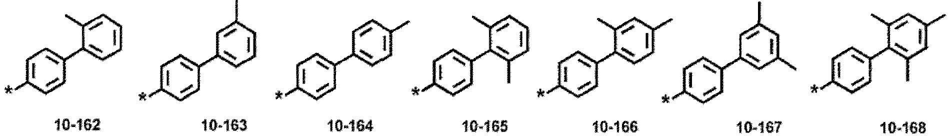 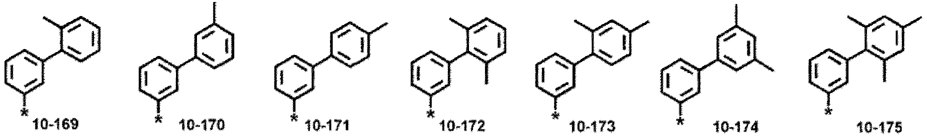 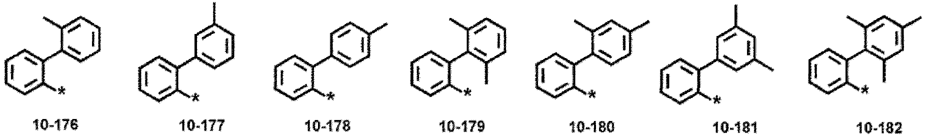 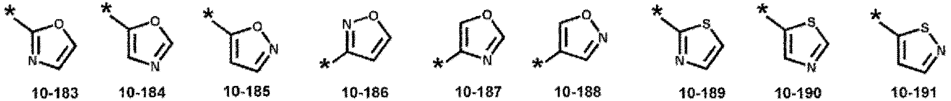 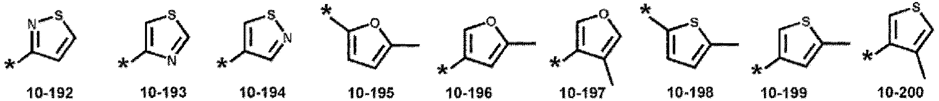 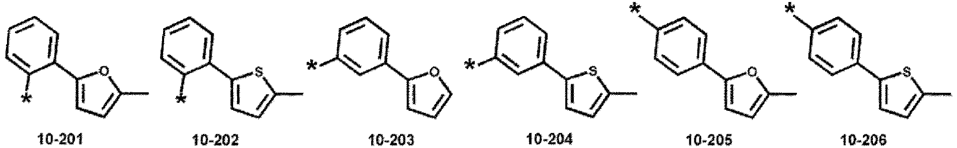 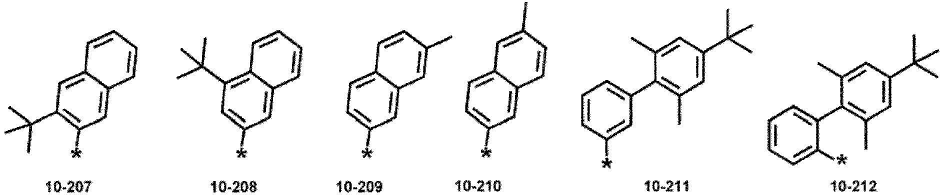 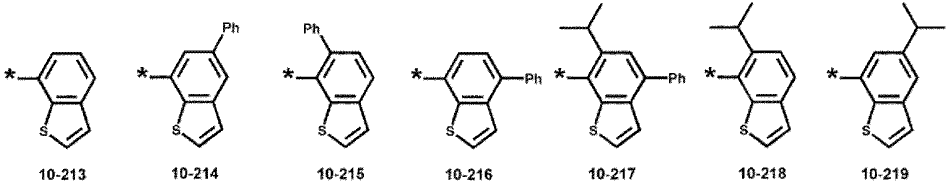 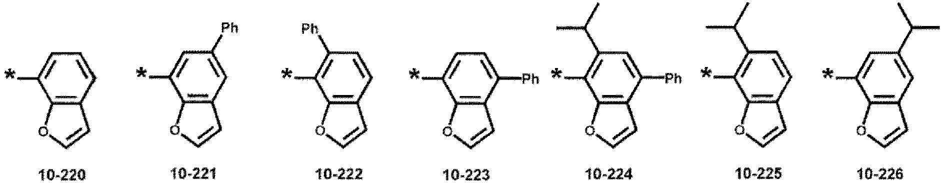 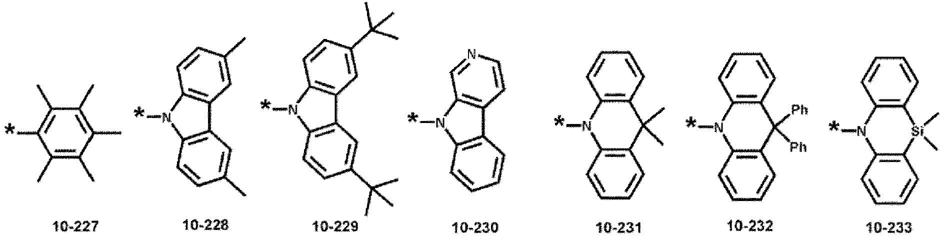 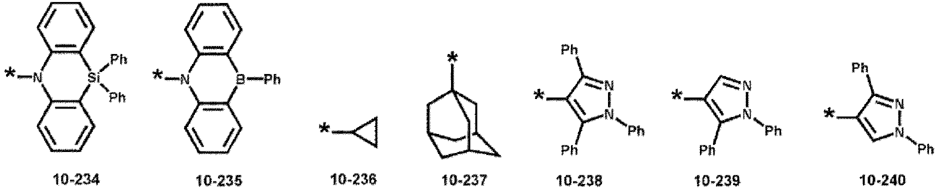 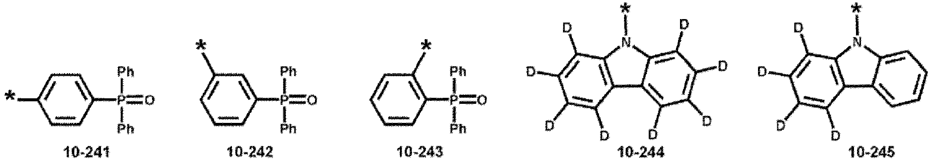 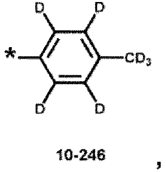
wherein, in Formulae 9-1 to 9-61 and 10-1 to 10-246, * indicates a binding site to an adjacent atom, "Ph" represents a phenyl group, and "TMS" represents a trimethylsilyl group.
d1, d2, and d4 may each independently be an integer from 0 to 20.
d1, d2, and d4 in Formula 1 indicate the number of R₁(s), R₂(s), and R₄(s), respectively, and may each independently be an integer from 0 to 20. When d1 is 2 or greater, two or more R₁(s) may be identical to or different from each other, when d2 is 2 or greater, two or more R₂(s) may be identical to or different from each other, and when d4 is 2 or greater, two or more R₄(s) may be identical to or different from each other.

Neighboring two or more groups of R₁, R₂, R₃₁, R₃₂, R₄, R₁ₐ, and R_{1b} may optionally be bonded to each other to form a C₅-C₆₀ carbocyclic group that is unsubstituted or substituted with at least one R₁₀ₐ or a C₂-C₆₀ heterocyclic group that is unsubstituted or substituted with at least one R₁₀ₐ.

In Formula 1, i) two or more R₁(s) in the number of d1 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, ii) two or more R₂(s) in the number of d2 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, iii) R₃₁ and R₃₂ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, iv) two or more R₄(s) in the number of d4 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, v) R₁ₐ and R_{1b} may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, vi) at least one of R₁(s) in the number of d1 and at least one of R₂(s) in the number of d2 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

The term "R₁₀ₐ" as utilized herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ arylalkyl group; or a C₂-C₆₀ heteroarylalkyl group.

In one or more embodiments, R₃₁ may be a group represented by Formula 3: 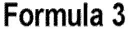 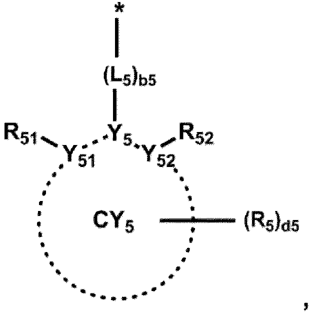
wherein, in Formula 3,
Y₅, Y₅₁, and Y₅₂ may each independently be C or N,
CY₅ may be a C₃-C₆₀ carbocyclic group or a C₁-C₆₀ heterocyclic group,
L₅ may be a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
b5 may be an integer from 1 to 3,
R₅, R₅₁, and R₅₂ may each be the same as in the description of R₁,
d5 may be an integer from 0 to 10, and
* indicates a binding site to a neighboring atom.

In one or more embodiments, R₅₁ and R₅₂ may not be hydrogen.

For example, in some embodiments, R₃₁ may be a group represented by Formula 3-1: 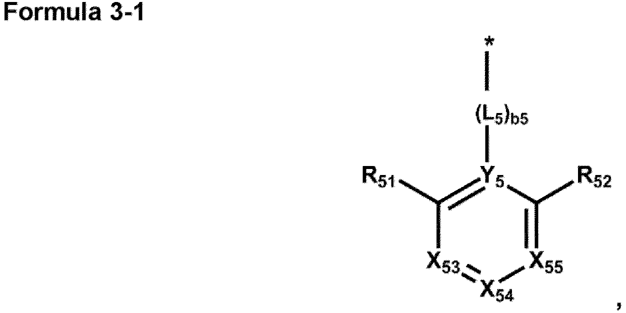
wherein, in Formula 3-1,
Y₅ may be C or N,
X₅₃ may be C(R₅₃) or N,
X₅₄ may be C(R₅₄) or N,
X₅₅ may be C(R₅₅) or N,
L₅ may be a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
b5 may be an integer from 1 to 3,
R₅₁ to R₅₅ may each be the same as in the description of R₁, and R₅₁ and R₅₂ may not be hydrogen, and
* indicates a binding site to a neighboring atom.

In one or more embodiments, at least one of R₁ in the number of d1 and at least one of R₂ in the number of d2 may be linked to each other to form a C₅-C₆₀ carbocyclic group unsubstituted or substituted with at least one R₁₀ₐ or a C₂-C₆₀ heterocyclic group unsubstituted or substituted with at least one R₁₀ₐ, and R₁₀ₐ is the same as described herein.

In one or more embodiments, a group represented by 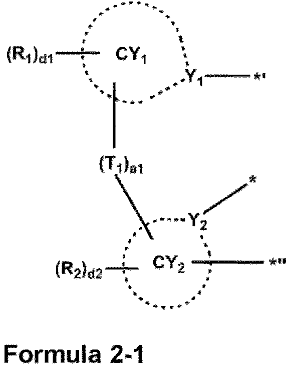 in Formula 1 may be represented by Formula 2-1 or 2-2: 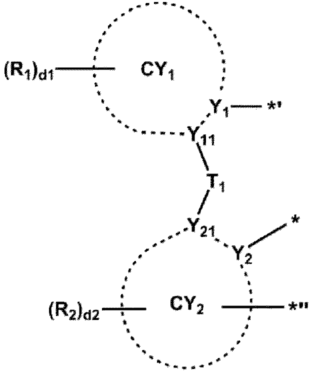 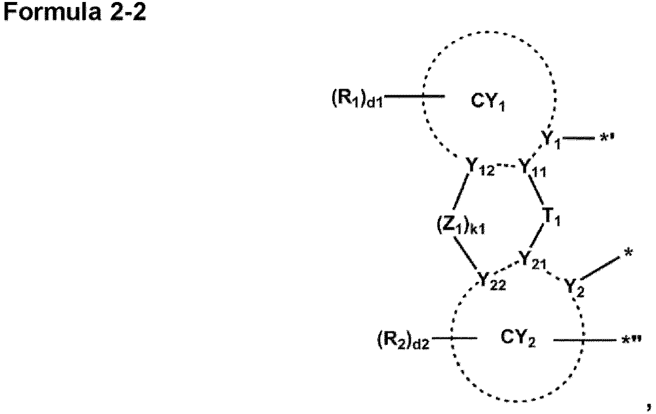
wherein, in Formulae 2-1 and 2-2,
CY₁, CY₂, Y₁, Y₂, and T₁ may each be the same as described herein,
Y₁₁, Y₁₂, Y₂₁, and Y₂₂ may each independently be C or N,
Z₁ may be a single bond, a double bond, *'"-N[(L₆₀)_{b60}-(R₆₀)]-*'"', *'"-B(R₆₀)-*'"', *'"-P(R₆₀)-*'"', *'"-C(R₆₀ₐ)(R_{60b})-*'"', *'"-Si(R₆₀ₐ)(R_{60b})-*'"', *'"-Ge(R₆₀ₐ)(R_{60b}) -*'"', *'"-S-*'"', *'"-Se-*'"', *'"-O-*'"', *'"-C(=O)-*'"', *'"-S(=O)-*'"', *'"-S(=O)₂-*'"', *'"-C(R₆₀)=*'"', or *'"=C(R₆₀)-*'"',
k1 may be an integer from 1 to 3,
L₆₀ may be a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
b60 may be an integer from 1 to 3,
R₆₀, R₆₀ₐ, and R_{60b} may each be the same as in the description of R₁,
R₁₀ₐ may be the same as described herein,
*' indicates a binding site to A₁ in Formula 1,
* indicates a binding site to M₁ in Formula 1,
*" indicates a binding site to T₂ in Formula 1, and
*'" and *'"' each indicate a binding site to a neighboring atom.

In one or more embodiments, a group represented by 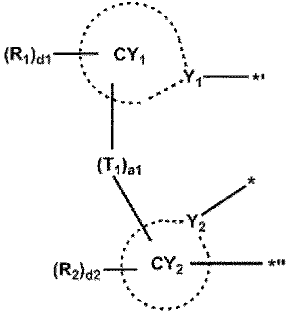 in Formula 1 may be a group represented by one selected from among Formulae 2-11 to 2-13: 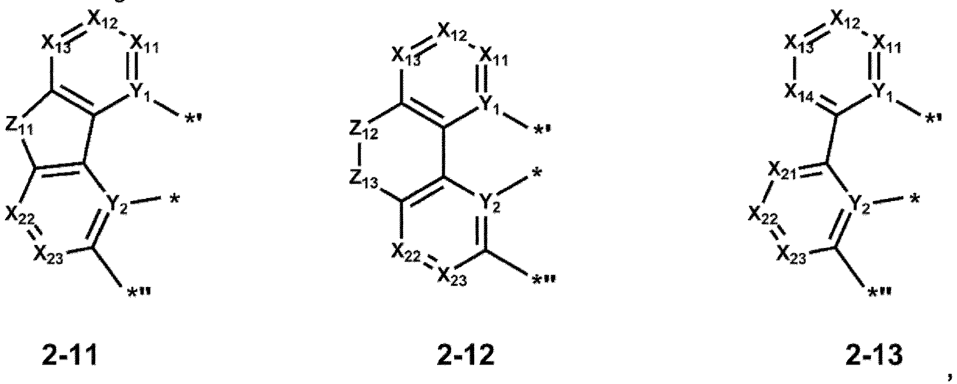
wherein, in Formulae 2-11 to 2-13,
Y₁ and Y₂ may each be C or N,
X₁₁ may be C(R₁₁) or N, X₁₂ may be C(R₁₂) or N, X₁₃ may be C(R₁₃) or N, and X₁₄ may be C(R₁₄) or N,
X₂₁ may be C(R₂₁) or N, X₂₂ may be C(R₂₂) or N, and X₂₃ may be C(R₂₃) or N,
R₁₁ to R₁₄ may each be the same as in the description of R₁,
R₂₁ to R₂₃ may each be the same as in the description of R₂,
two or more neighboring groups of R₁₁ to R₁₄ or R₂₁ to R₂₃ may optionally be bonded to each other to form a C₅-C₆₀ carbocyclic group unsubstituted or substituted with at least one R₁₀ₐ or a C₂-C₆₀ heterocyclic group unsubstituted or substituted with at least one R₁₀ₐ,
Z₁₁ may be *'"-N[(L₆₁)_{b61}-(R₆₁)]-*'"' *'"-O-*'"' *'"-S-*'"' *'"-Se-*'"', or *'"-C(R₆₁ₐ)(R_{61b})-*'"',
Z₁₂ may be *'"-N[(L₆₂)_{b62}-(R₆₂)]-*'"', *'"-C(R₆₂ₐ)(R_{62b})-*'"', *'"-C(R₆₂)=*'"', or *'"=(R₆₂)-*'"',
Z₁₃ may be *"'-N[(L₆₃)_{b63}-(R₆₃)]-*'"', *'"-C(R₆₃ₐ)(R_{63b})-'"', *'"-C(R₆₃)=*'"', or *'"=C(R₆₃)-*'"',
L₆₁ to L₆₃ may each independently be a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
b61 to b63 may each independently be an integer from 1 to 3,
R₆₁, R₆₁ₐ, R_{61b}, R₆₂, R₆₂ₐ, R_{62b}, R₆₃, R₆₃ₐ, and R_{63b} may each be the same as in the description of R₁, and R₁₀ₐ is the same as described herein,
*' indicates a binding site to A₁ in Formula 1,
* indicates a binding site to M₁ in Formula 1,
*" indicates a binding site to T₂ in Formula 1, and
*'" and *'"' each indicate a binding site to a neighboring atom.

In one or more embodiments, a group represented by 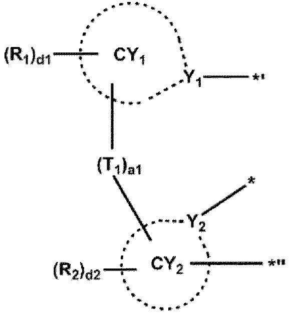 in Formula 1 may be a group represented by one selected from among Formulae 2-11A to 2-11E and 2-12A to 2-12D: 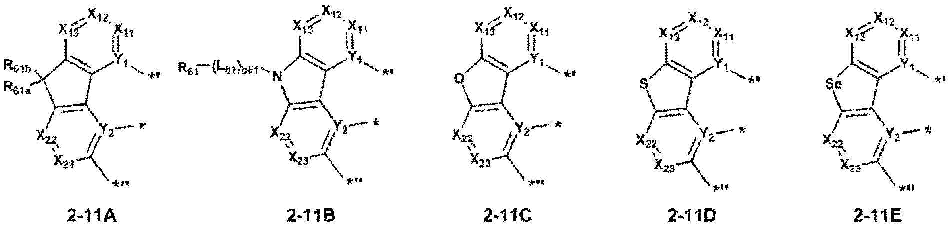 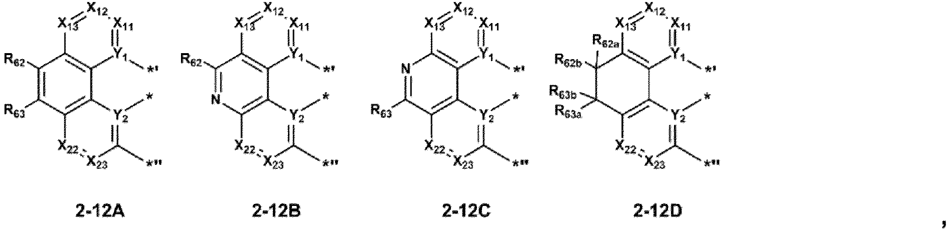
wherein, in Formulae 2-11A to 2-11E and 2-12A to 2-12D,
Y₁ and Y₂ may each be C or N,
X₁₁ may be C(R₁₁) or N, X₁₂ may be C(R₁₂) or N, and X₁₃ may be C(R₁₃) or N,
X₂₂ may be C(R₂₂) or N, and X₂₃ may be C(R₂₃) or N,
R₁₁ to R₁₃ may each be the same as in the description of R₁,
R₂₂ to R₂₃ may each be the same as in the description of R₂,
two or more neighboring groups of R₁₁ to R₁₃ or R₂₂ to R₂₃ may optionally be bonded to each other to form a C₅-C₆₀ carbocyclic group unsubstituted or substituted with at least one R₁₀ₐ or a C₂-C₆₀ heterocyclic group unsubstituted or substituted with at least one R₁₀ₐ,
L₆₁ may be a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
b61 may each independently be an integer from 1 to 3,
R₆₁, R₆₁ₐ, R_{61b}, R₆₂, R₆₂ₐ, R_{62b}, R₆₃, R₆₃ₐ, and R_{63b} may each be the same as in the description of R₁, and R₁₀ₐ is the same as described herein,
*' indicates a binding site to A₁ in Formula 1,
* indicates a binding site to M₁ in Formula 1,
*" indicates a binding site to T₂ in Formula 1, and
*'" and *'"' each indicate a binding site to a neighboring atom.

In one or more embodiments, the organometallic compound represented by Formula 1 may be represented by Formula 1-1: 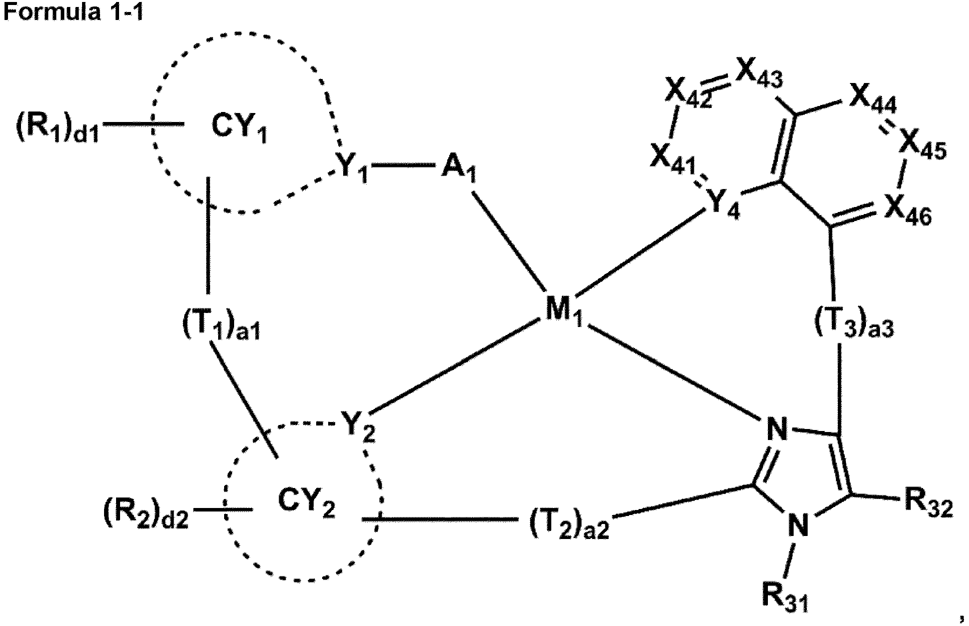
wherein, in Formula 1-1,
M₁, A₁, Y₁, Y₂, Y₄, CY₁, CY₂, R₁, R₂, R₃₁, R₃₂, T₁ to T₃, and a1 to a3 may each be the same as described herein,
X₄₁ may be C(R₄₁) or N, X₄₂ may be C(R₄₂) or N, X₄₃ may be C(R₄₃) or N, X₄₄ may be C(R₄₄) or N, X₄₅ may be C(R₄₅) or N, and X₄₆ may be C(R₄₆) or N,
R₄₁ to R₄₆ may each be the same as in the description of R₄, and
two or more groups of R₄₁ to R₄₆ may optionally be bound to each other to form a C₅-C₆₀ carbocyclic group that is unsubstituted or substituted with at least one R₁₀ₐ or a C₂-C₆₀ heterocyclic group that is unsubstituted or substituted with at least one R₁₀ₐ.

In one or more embodiments, an organometallic compound represented by Formula 1 may be represented by one of Formulae 1-11 to 1-13: 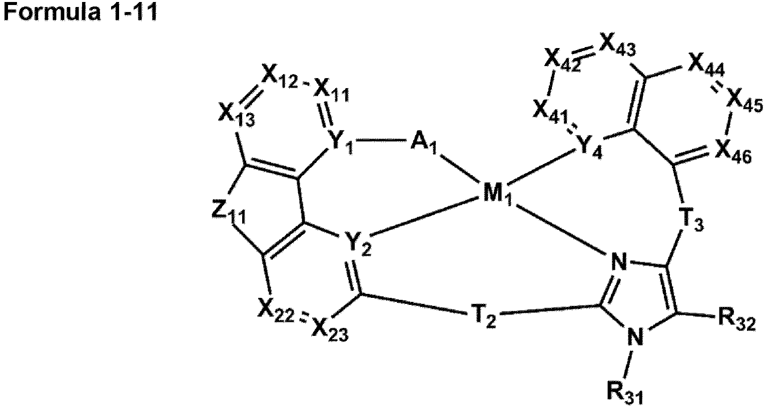 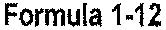 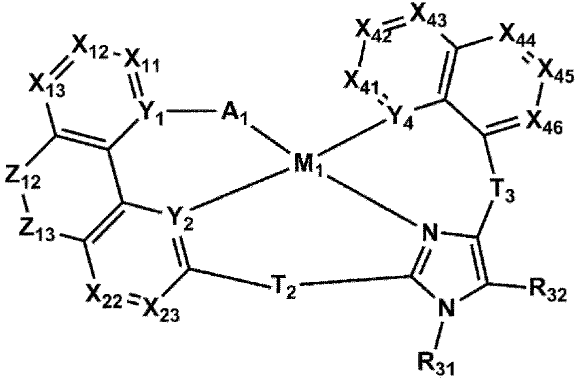 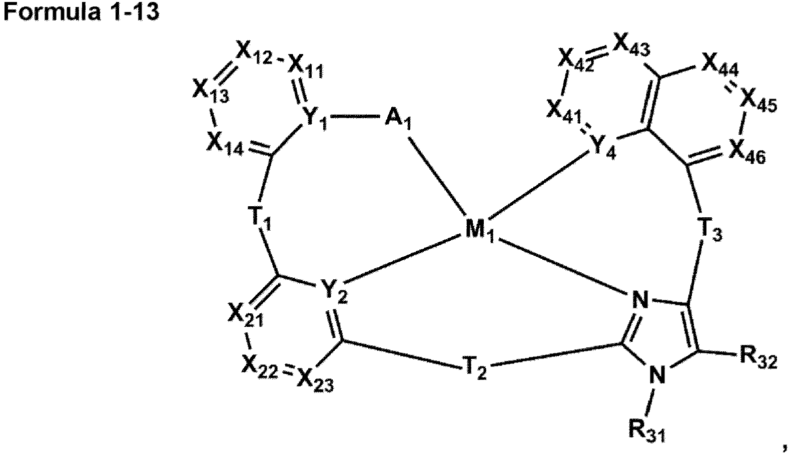
wherein, in Formulae 1-11 to 1-13,
M₁, A₁, Y₁, Y₂, Y₄, R₃₁, R₃₂, and T₁ to T₃ may each be the same as described herein,
X₁₁ may be C(R₁₁) or N, X₁₂ may be C(R₁₂) or N, X₁₃ may be C(R₁₃) or N, and X₁₄ may be C(R₁₄) or N,
X₂₁ may be C(R₂₁) or N, X₂₂ may be C(R₂₂) or N, and X₂₃ may be C(R₂₃) or N,
X₄₁ may be C(R₄₁) or N, X₄₂ may be C(R₄₂) or N, X₄₃ may be C(R₄₃) or N, X₄₄ may be C(R₄₄) or N, X₄₅ may be C(R₄₅) or N, and X₄₆ may be C(R₄₆) or N,
R₁₁ to R₁₄ may each be the same as in the description of R₁,
R₂₁ to R₂₃ may each be the same as in the description of R₂,
R₄₁ to R₄₆ may each be the same as in the description of R₄, and
two or more groups of R₁₁ to R₁₄, R₂₁ to R₂₃, or R₄₁ to R₄₆ may optionally be bonded to each other to form a C₅-C₆₀ carbocyclic group that is unsubstituted or substituted with at least one R₁₀ₐ or a C₂-C₆₀ heterocyclic group that is unsubstituted or substituted with at least one R₁₀ₐ,
Z₁₁ may be *'"-N[(L₆₁)_{b61}-(R₆₁)]-*'"', *'"-O-*'"', *'"-S-*'"', *'"-Se-*'"', or *'"-C(R₆₁ₐ)(R_{61b})-*'"',
Z₁₂ may be *'"-N[(L₆₂)_{b62}-(R₆₂)]-*'"', *'"-C(R₆₂ₐ)(R_{62b})-*'"', *'"-C(R₆₂)=*'"', or *'"=C(R₆₂)-*'"',
Z₁₃ may be *'"-N[(L₆₃)_{b63}-(R₆₃)]-*'"'. *'"-C(R₆₃ₐ)(R_{63b})-*'"', *'"-C(R₆₃)=*'"', or *'"=C(R6₃)-*'"',
L₆₁ to L₆₃ may each independently be a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
b61 to b63 may each independently be an integer from 1 to 3, and
R₆₁, R₆₁ₐ, R_{61b}, R₆₂, R₆₂ₐ, R_{62b}, R₆₃, R₆₃ₐ, and R_{63b} may each be the same as in the description of R₁, and R₁₀ₐ is the same as described herein.

In one or more embodiments, a ratio of presence of triplet metal-to-ligand charge transfer state (³MLCT) value of the organometallic compound represented by Formula 1 may be equal to or greater than 10%. For example, the ³MLCT value may be 10 % or more, 11 % or more, or 12 % or more.

In one or more embodiments, the organometallic compound represented by Formula 1 may be one selected from among Compounds D01 to D36, but embodiments of the present disclosure are not limited thereto:

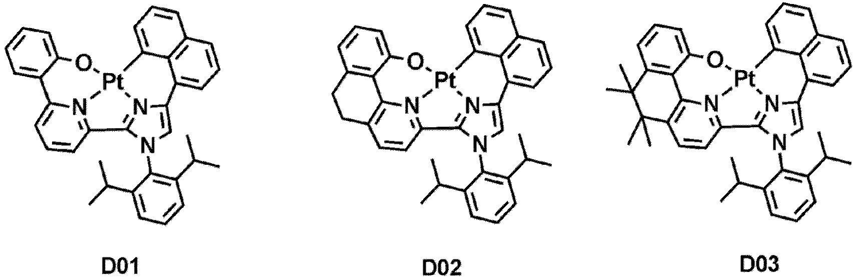

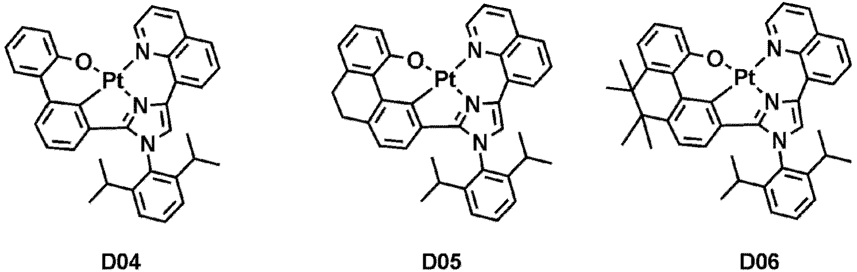

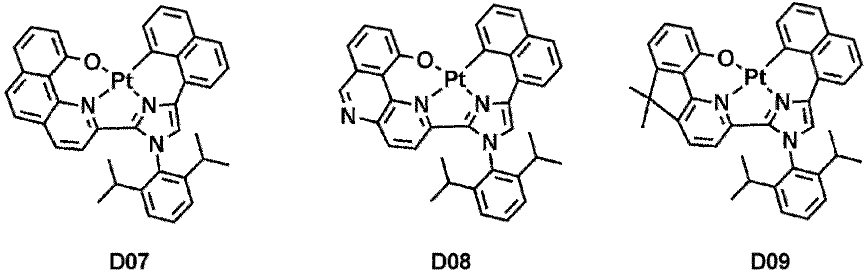

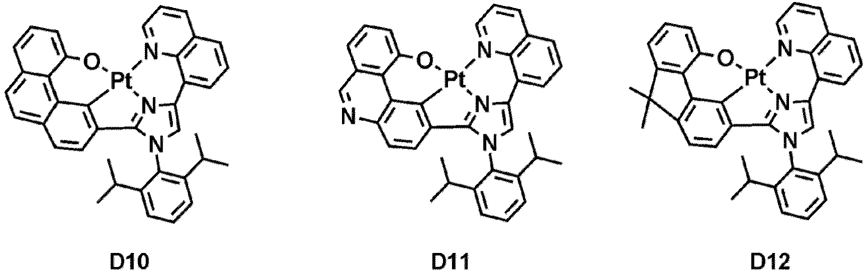

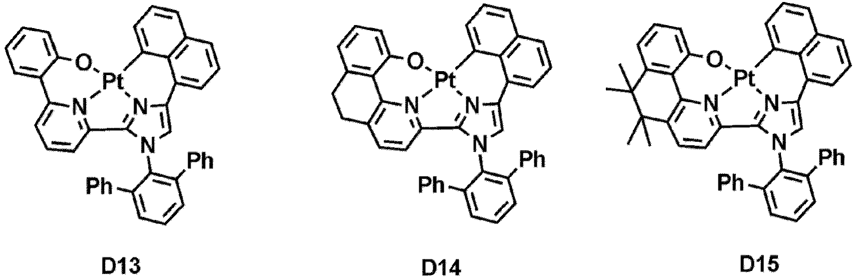

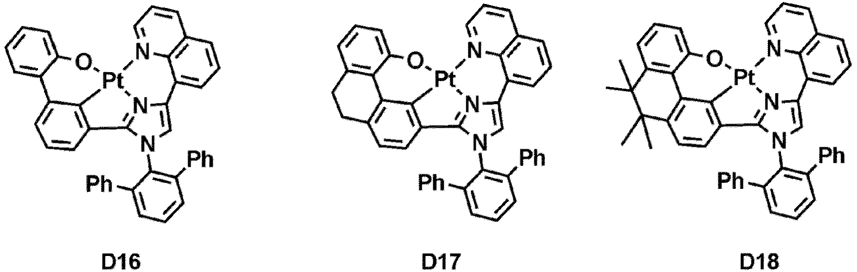

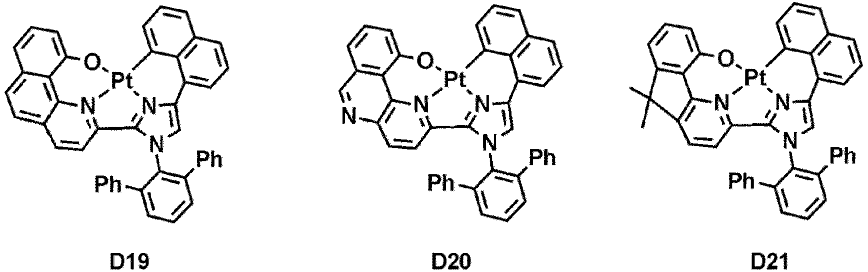

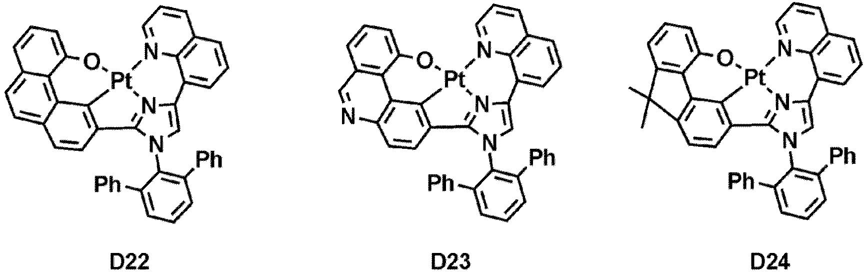

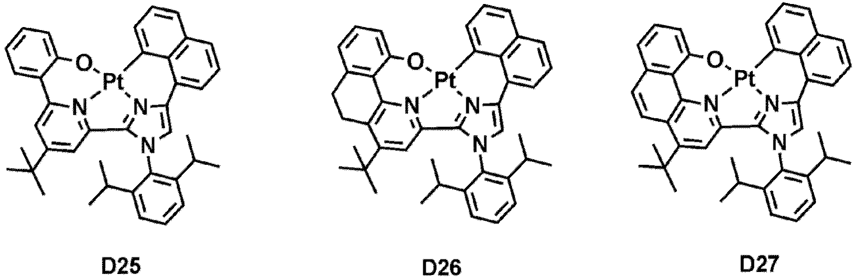

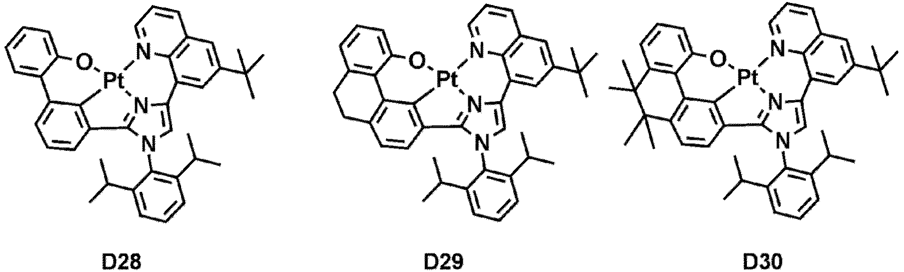

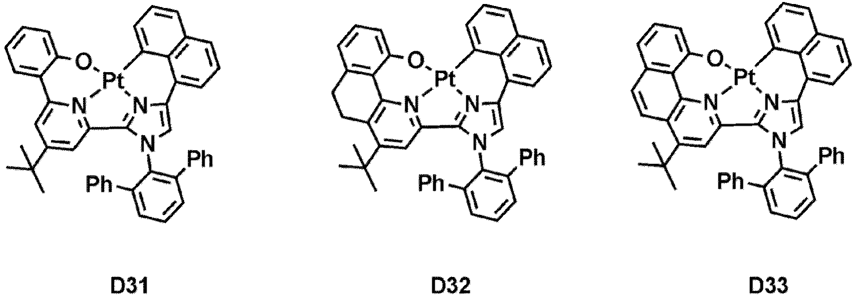

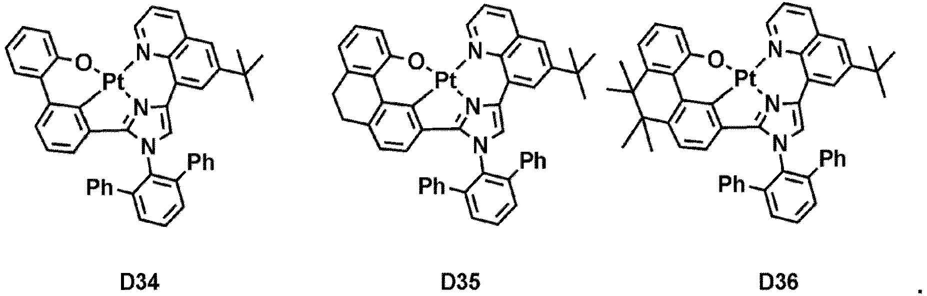

The organometallic compound represented by Formula 1 has a structure of a tetradentate organometallic compound including a moiety including both (e.g., simultaneously) an aromatic ring and an alkyl ring, for example, a condensed ring in which a cyclic group is additionally condensed to a tetrahydroquinoline-based group. As the organometallic compound includes the condensed cyclic moiety, structural stability of the compound may be increased. Therefore, a light-emitting device including the organometallic compound may have improved lifespan.

Also, because the organometallic compound includes the condensed cyclic moiety, horizontal orientation is improved, and thus, a light-emitting device including the organometallic compound may have low driving voltage and improved luminescence efficiency.

Therefore, an electronic device, for example, a light-emitting device, including the organometallic compound represented by Formula 1 may have low driving voltage, high emission efficiency, and long lifespan.

The highest occupied molecular orbital/ lowest unoccupied molecular orbital (HOMO/LUMO) energy level, triplet energy (T₁) level, maximum emission wavelength (λₘₐₓ), and a ratio of presence of triplet metal-to-ligand charge transfer state (³MLCT) of Compounds D01, D02, D03, D09, D11, D13, D14, D15, D21, D23, D25, and D26 and Comparative Example Compounds R01 to R05 according to one or more embodiments were evaluated utilizing the DFT method of the Gaussian program, which is structure-optimized at the B3LYP/6-31G(d,p) level, and the evaluation result and a band gap value, which a HOMO/LUMO energy difference, are shown in Table 1.

**Table 1**

| Compound | HOMO (eV) | LUMO (eV) | Band gap (eV) | λₘₐₓ (nm) | Luminescence T₁ (eV) | ³MLCT (%) |
|---|---|---|---|---|---|---|
| D01 | -4.89 | -2.12 | 2.77 | 642 | 1.93 | 13 |
| D02 | -4.84 | -2.00 | 2.84 | 629 | 1.97 | 13 |
| D03 | -4.83 | -1.96 | 2.87 | 626 | 1.98 | 14 |
| D09 | -4.88 | -2.03 | 2.85 | 626 | 1.98 | 15 |
| D11 | -4.68 | -2.53 | 2.15 | 667 | 1.86 | 35 |
| D13 | -4.83 | -2.09 | 2.74 | 646 | 1.92 | 13 |
| D14 | -4.79 | -1.98 | 2.81 | 629 | 1.97 | 13 |
| D15 | -4.77 | -1.93 | 2.84 | 626 | 1.98 | 14 |
| D21 | -4.83 | -2.00 | 2.83 | 626 | 1.98 | 17 |
| D23 | -4.64 | -2.47 | 2.17 | 663 | 1.87 | 36 |
| D25 | -4.83 | -2.06 | 2.77 | 639 | 1.94 | 13 |
| D26 | -4.78 | -1.95 | 2.83 | 626 | 1.98 | 12 |
| R01 | -5.01 | -1.88 | 3.13 | 534 | 2.32 | 5.84 |
| R02 | -4.87 | -1.76 | 3.11 | 517 | 2.40 | 1.06 |
| R03 | -4.86 | -2.29 | 2.57 | 663 | 1.87 | 9.23 |
| R04 | -4.77 | -1.49 | 3.28 | 517 | 2.40 | 12 |
| R05 | -4.91 | -1.72 | 3.19 | 620 | 2.00 | 10 |
| R06 | -4.87 | -1.44 | 3.43 | 557 | 2.26 | 15 |

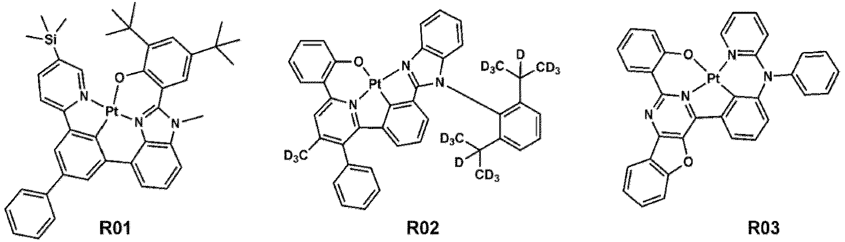

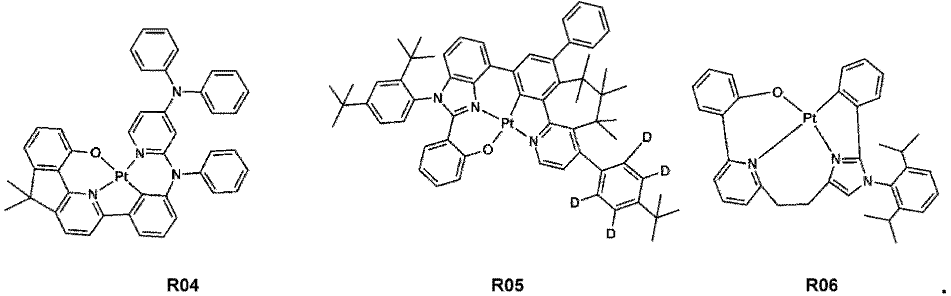

Through Table 1, it is confirmed that Compounds D01, D02, D03, D09, D11, D13, D14, D15, D21, D23, D25, and D26 have a higher ³MLCT value than that of Compounds R01 to R05 of Comparative Examples, and that as the maximum emission wavelengths of R01, R02, R04, and R06 of Comparative Example Compounds do not satisfy the range of about 590 nm to about 670 nm, Compounds R01, R02, R04, and R06 are different from Compounds D01, D02, D03, D09, D11, D13, D14, D15, D21, D23, D25, and D26.

Synthesis methods of the organometallic compound represented by Formula 1 may be recognizable by one of ordinary skill in the art by referring to Synthesis Examples and/or Examples provided.

At least one organometallic compound represented by Formula 1 may be utilized in a light-emitting device (for example, an organic light-emitting device). Accordingly, in one or more embodiments, a light-emitting device is provided to include: a first electrode; a second electrode facing the first electrode; and an interlayer between the first electrode and the second electrode and including an emission layer, wherein the interlayer may include the organometallic compound represented by Formula 1.

In some embodiments,
the first electrode of the light-emitting device may be an anode,
the second electrode of the light-emitting device may be a cathode,
the interlayer may include at least one organometallic compound represented by Formula 1,
the interlayer may further include a hole transport region between the first electrode and the emission layer and an electron transport region between the emission layer and the second electrode,
the hole transport region may include a hole injection layer, a hole transport layer, an emission auxiliary layer, an electron blocking layer, or any combination thereof, and
the electron transport region may include a hole blocking layer, an electron transport layer, an electron injection layer, or any combination thereof.

In one or more embodiments, the organometallic compound may be included between a pair of electrodes of the light-emitting device. Accordingly, the organometallic compound may be included in the interlayer of the light-emitting device, for example, in the emission layer of the interlayer.

In one or more embodiments, the emission layer may further include a host, and the amount of the organometallic compound may be from about 0.01 parts by weight to about 49.99 parts by weight based on 100 parts by weight of the emission layer.

In one or more embodiments, the emission layer of the light-emitting device may include a dopant and a host, and the dopant may include the organometallic compound. For example, the organometallic compound may act as a dopant. For example, in some embodiments, the emission layer may be to emit green light.

In one or more embodiments, the emission layer may be to emit blue light or blue-green light.

In one or more embodiments, the emission layer may be to emit light having a maximum emission wavelength range of about 590 nm to about 670 nm.

The wording "(interlayer and/or capping layer) includes an organometallic compound" as utilized herein may be understood as "(interlayer and/or capping layer) may include one kind or type of organometallic compound represented by Formula 1 or two different kinds or types of organometallic compounds, each represented by Formula 1."

For example, in one or more embodiments, the interlayer and/or capping layer may include Compound 1 only as the organometallic compound. In this regard, Compound 1 may be present in the emission layer of the light-emitting device. In one or more embodiments, the interlayer may include, as the organometallic compound, Compound 1 and Compound 2. In this regard, Compound 1 and Compound 2 may be present in substantially the same layer (for example, all of Compound 1 and Compound 2 may be present in the emission layer), or may be present in different layers (for example, Compound 1 may be present in the emission layer, and Compound 2 may be present in the electron transport region).

The term "interlayer" as utilized herein may refer to a single layer and/or all of a plurality of layers located between the first electrode and the second electrode of the light-emitting device.
one or more aspects of embodiments of the present disclosure provide an electronic apparatus including the light-emitting device. The electronic apparatus may further include a thin-film transistor. For example, in one or more embodiments, the electronic apparatus may further include a thin-film transistor including a source electrode and a drain electrode, wherein the first electrode of the light-emitting device may be electrically connected to the source electrode or the drain electrode of the thin-film transistor. In some embodiments, the electronic apparatus may further include a color filter, a color conversion layer, a touch screen layer, a polarizing layer, or any combination thereof. For more details on the electronic apparatus, related descriptions provided herein may be referred to.

One or more aspects of embodiments of the present disclosure provide an electronic device including the light-emitting device.

For example, in one or more embodiments, the electronic device may be a flat panel display, a curved display, a computer monitor, a medical monitor, a TV, a billboard, indoor or outdoor illuminations and/or signal light, a head-up display, a fully or partially transparent display, a flexible display, a rollable display, a foldable display, a stretchable display, a laser printer, a phone, a cell phone, a tablet, a phablet, a personal digital assistant (PDA), a wearable device, laptop computers, digital cameras, camcorders, viewfinders, micro displays, 3D displays, virtual or augmented reality displays, vehicles, a video wall including multiple displays tiled together, a theater or stadium screen, a phototherapy device, and/or a signage.

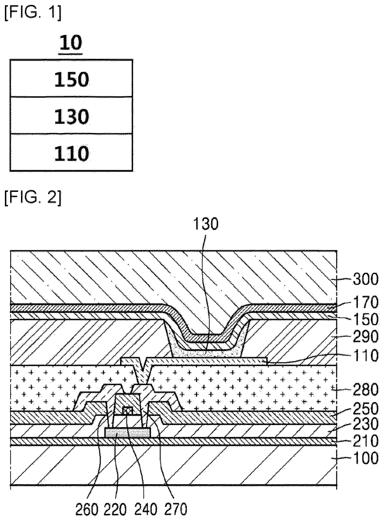

### [Description of FIG. 1]

FIG. 1 is a schematic cross-sectional view of a light-emitting device 10 according to one or more embodiments of the present disclosure. The light-emitting device 10 may include a first electrode 110, an interlayer 130, and a second electrode 150.

Hereinafter, the structure of the light-emitting device 10 according to one or more embodiments and a method of manufacturing the light-emitting device 10 will be described with reference to FIG. 1.

### [First electrode 110]

In FIG. 1, in some embodiments, a substrate may be additionally provided and located under the first electrode 110 or on the second electrode 150. As the substrate, a glass substrate or a plastic substrate may be utilized. In one or more embodiments, the substrate may be a flexible substrate, and may include plastics with excellent or suitable heat resistance and durability, such as polyimide, polyethylene terephthalate (PET), polycarbonate, polyethylene napthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. In one or more embodiments, when the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layered structure including (e.g., consisting of) a single layer or a multi-layered structure including a plurality of layers. For example, in one or more embodiments, the first electrode 110 may have a three-layered structure of ITO/Ag/ITO.

### [Interlayer 130]

The interlayer 130 may be on the first electrode 110. The interlayer 130 may include an emission layer.

In one or more embodiments, the interlayer 130 may further include a hole transport region located between the first electrode 110 and the emission layer, and an electron transport region located between the emission layer and the second electrode 150.

In one or more embodiments, the interlayer 130 may further include, in addition to one or more suitable organic materials, a metal-containing compound such as an organometallic compound, an inorganic material such as quantum dots, and/or the like.

In one or more embodiments, the interlayer 130 may include, i) two or more emitting units sequentially stacked between the first electrode 110 and the second electrode 150, and ii) a charge generation layer located between the two or more emitting units. When the interlayer 130 includes emitting units and a charge generation layer as described above, the light-emitting device 10 may be a tandem light-emitting device.

### [Hole transport region in interlayer 130]

The hole transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The hole transport region may include a hole injection layer, a hole transport layer, an emission auxiliary layer, an electron blocking layer, or any combination thereof.

For example, in some embodiments, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, the layers of each structure being stacked sequentially from the first electrode 110 in the stated order.

The hole transport region may include a compound represented by Formula 201, a compound represented by Formula 202, or any combination thereof: 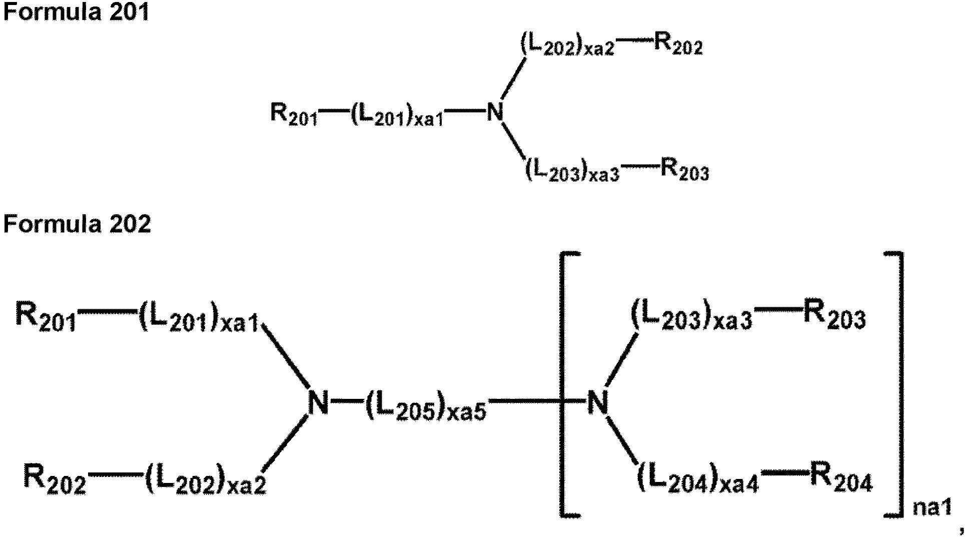
wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ, or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₆-C₆₀ polycyclic group (for example, a carbazole group and/or the like) unsubstituted or substituted with at least one R₁₀ₐ (for example, Compound HT16),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₆-C₆₀ polycyclic group unsubstituted or substituted with at least one R₁₀ₐ, and
na1 may be an integer from 1 to 4.

For example, each of Formulae 201 and 202 may include at least one selected from groups represented by Formulae CY201 to CY217:

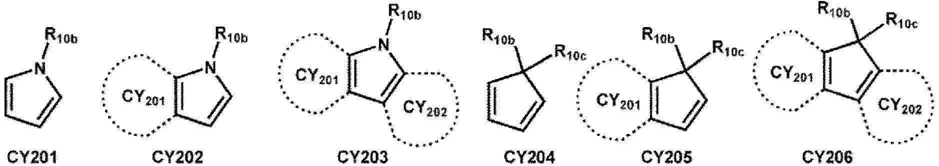

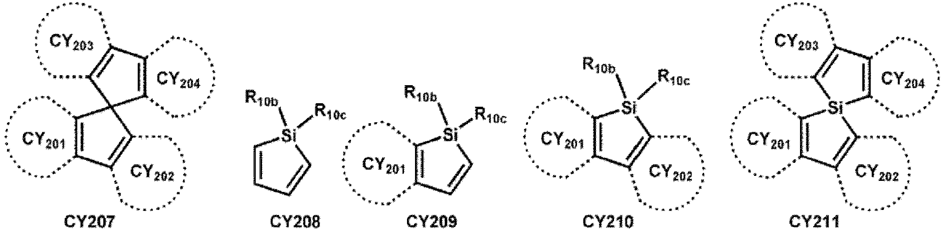

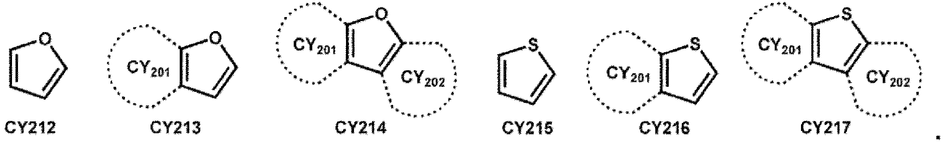

In Formulae CY201 to CY217, R_{10b} and R_{10c} may each be the same as described with respect to R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ as described above.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one selected from groups represented by Formulae CY201 to CY203.

In one or more embodiments, Formula 201 may include at least one selected from the groups represented by Formulae CY201 to CY203 and at least one selected from the groups represented by Formulae CY204 to CY217.

In one or more embodiments, in Formula 201, xa1 may be 1, R₂₀₁ may be a group represented by one selected from among Formulae CY201 to CY203, xa2 may be 0, and R₂₀₂ may be a group represented by one selected from among Formulae CY204 to CY207.

In one or more embodiments, each of Formulae 201 and 202 may not include (e.g., may exclude) a group represented by one selected from among Formulae CY201 to CY203.

In one or more embodiments, each of Formulae 201 and 202 may not include (e.g., may exclude) a group represented by one selected from among Formulae CY201 to CY203, and may include at least one selected from the groups represented by Formulae CY204 to CY217.

In one or more embodiments, each of Formulae 201 and 202 may not include (e.g., may exclude) a group represented by one selected from among Formulae CY201 to CY217.

In one or more embodiments, the hole transport region may include one of Compounds HT1 to HT46, 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), 4,4'-bis[N-(1-naphthyl)-N-phenylamino]biphenyl (NPB (or NPD)), β-NPB, N,N'-bis(3-methylphenyl)-N,N'-diphenyl-[1,1'-biphenyl]-4,4'-diamine (TPD), Spiro-TPD, Spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

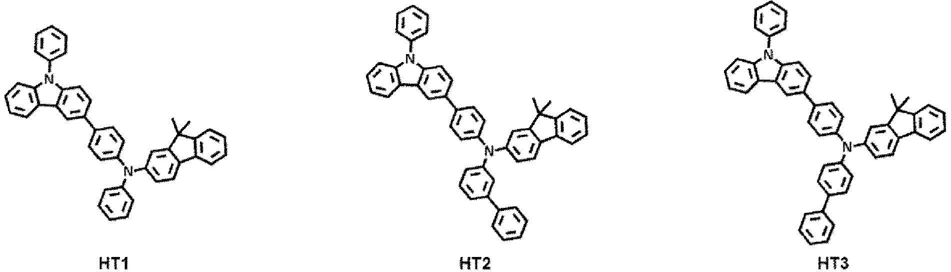

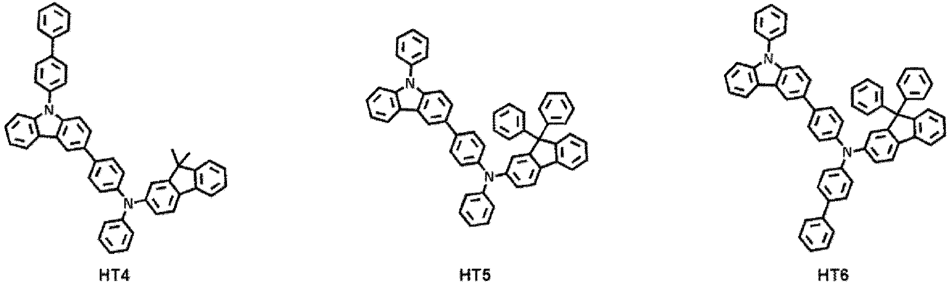

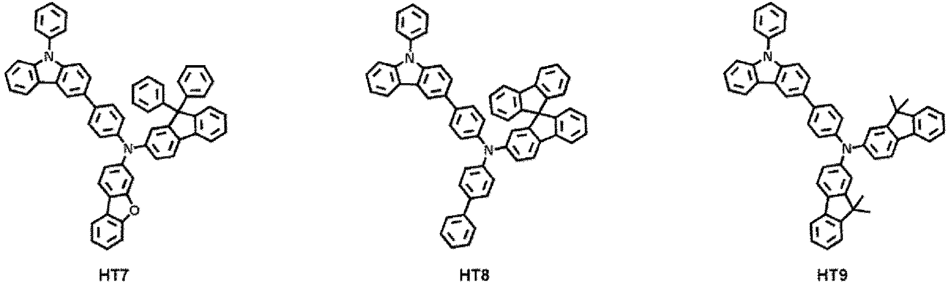

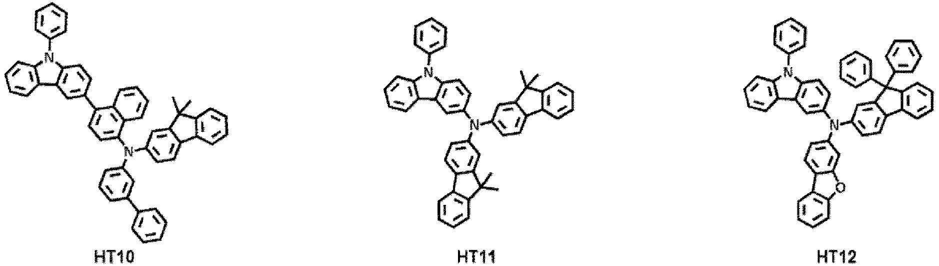

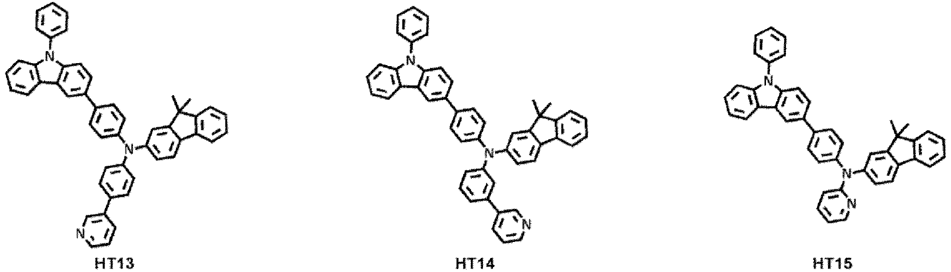

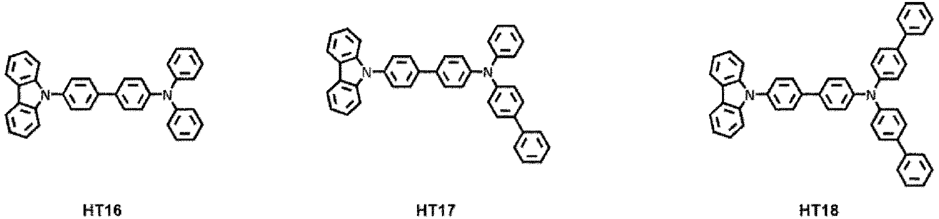

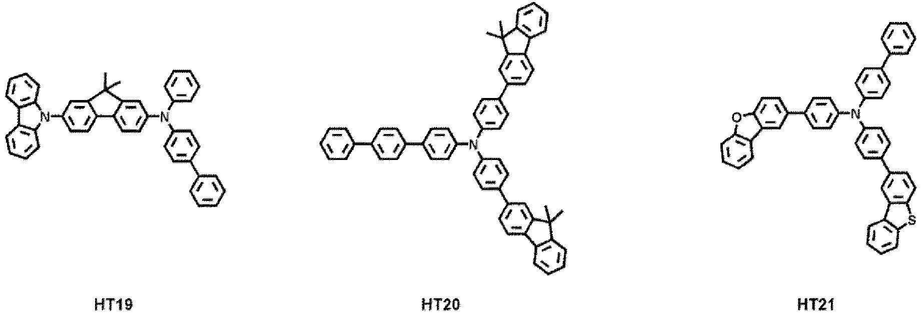

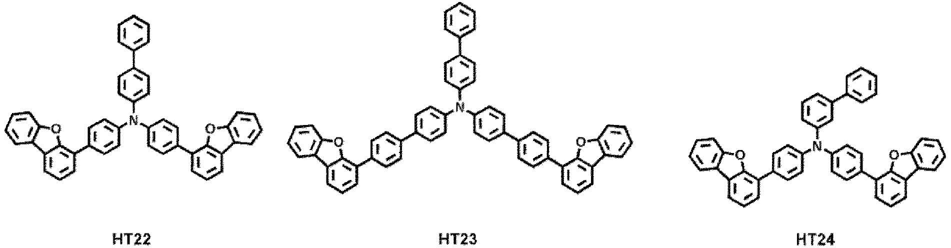

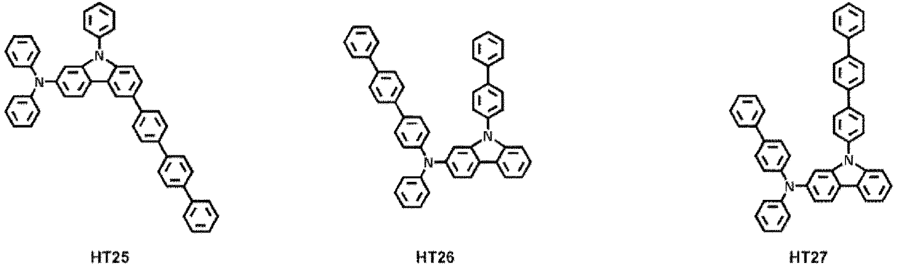

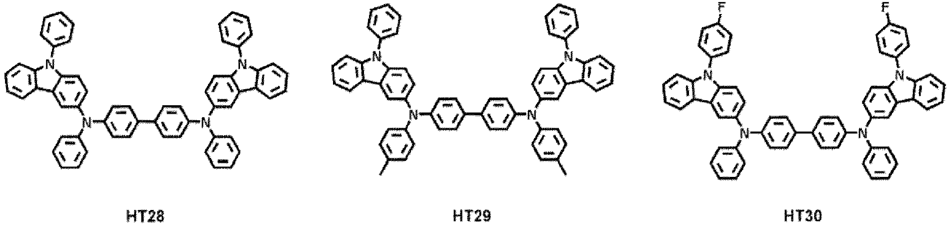

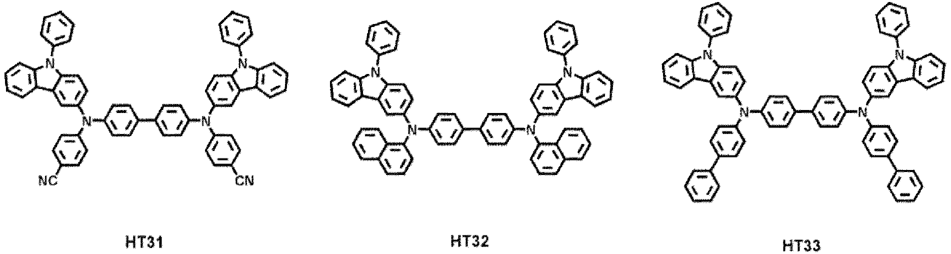

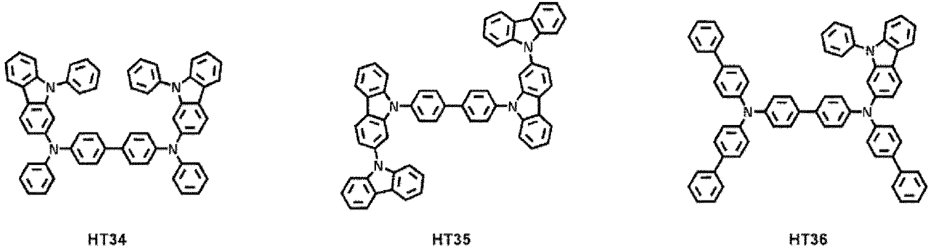

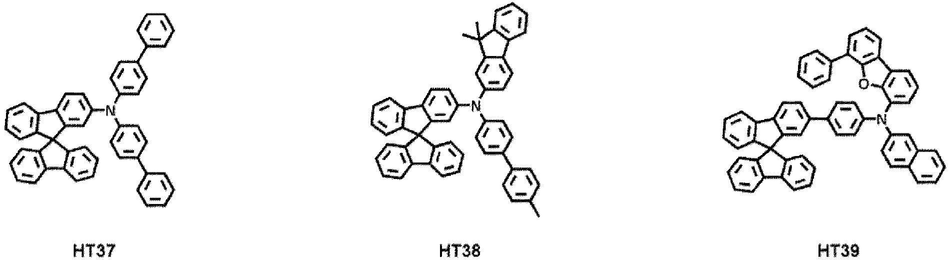

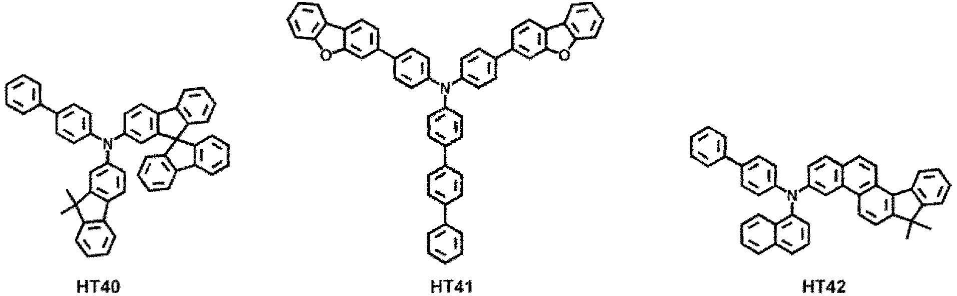

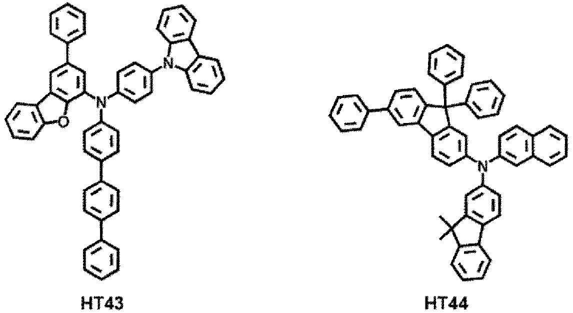

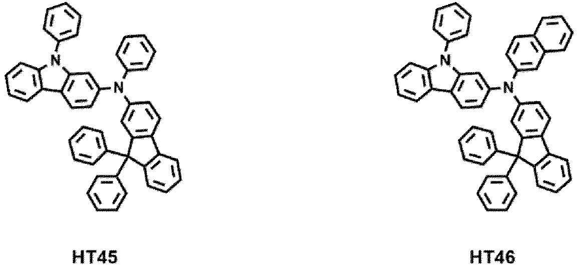

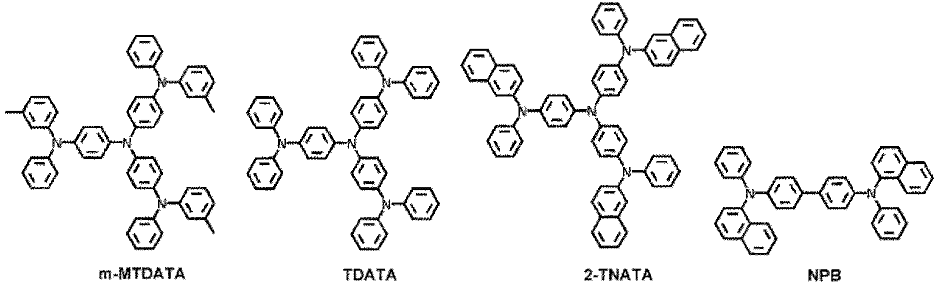

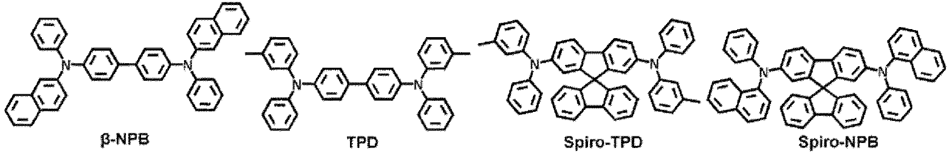

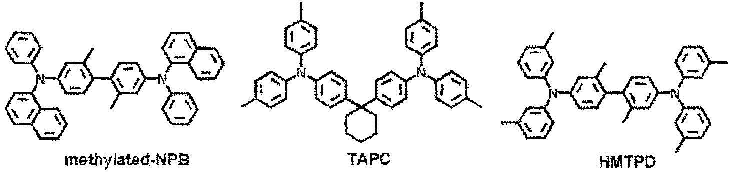

A thickness of the hole transport region may be in a range of about 5 nm (50 Å) to about 1.000 nm (10.000 Å), for example, about 10 nm (100 Å) to about 400 nm (4.000 Å). When the hole transport region includes a hole injection layer, a hole transport layer, or any combination thereof, a thickness of the hole injection layer may be in a range of about 10 nm (100 Å) to about 900 nm (9.000 Å), for example, about 10 nm (100) to about 100 nm (1.000 Å), and a thickness of the hole transport layer may be in a range of about 5 nm (50 Å) to about 200 nm (2.000 Å), for example, about 10 nm (100 Å) to about 150 nm (1.500 Å). When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block or reduce the leakage of electrons from an emission layer to a hole transport region. Materials that may be included in the hole transport region may be included in the emission auxiliary layer and the electron blocking layer.

### [p-dopant]

In one or more embodiments, the hole transport region may further include, in addition to these materials, a charge-generation material for the improvement of conductive properties. The charge-generation material may be uniformly or non-uniformly dispersed in the hole transport region (for example, in the form of a single layer including (e.g., consisting of) a charge-generation material).

The charge-generation material may be, for example, a p-dopant.

For example, the lowest unoccupied molecular orbital (LUMO) energy level of the p-dopant may be -3.5 eV or less.

In one or more embodiments, the p-dopant may include a quinone derivative, a cyano group-containing compound, a compound including element EL1 and element EL2, or any combination thereof.

Non-limiting examples of the quinone derivative may be tetracyanoquinodimethane (TCNQ), 2,3,5,6-tetrafluoro-7,7',8,8-tetracyanoquinodimethane (F4-TCNQ), etc.

Non-limiting examples of the cyano group-containing compound may be dipyrazino[2,3-f: 2',3'-h] quinoxaline-2,3,6,7,10,11-hexacarbonitrile (HAT-CN) and a compound represented by Formula 221:

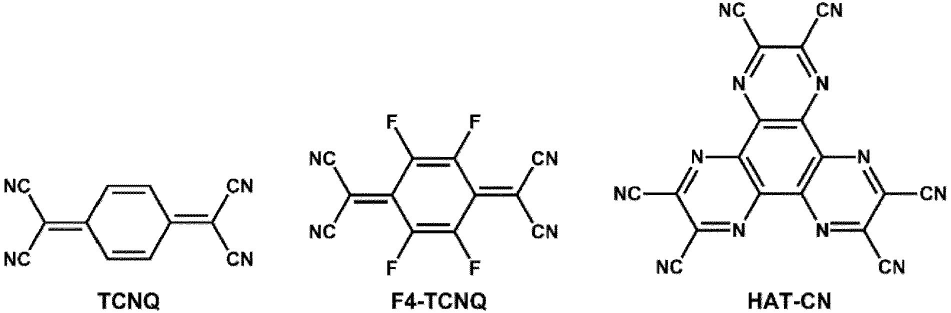

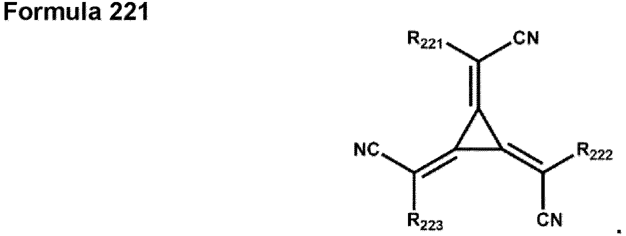

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one selected from among R₂₂₁ to R₂₂₃ may each independently be a C₃-C₆₀ carbocyclic group or a C₁-C₆₀ heterocyclic group, each substituted with a cyano group; -F; -Cl; -Br; -I; a C₁-C₂₀ alkyl group substituted with a cyano group, -F, -Cl, -Br, - I, or any combination thereof; or any combination thereof.

In the compound including element EL1 and element EL2, element EL1 may be metal, metalloid, or any combination thereof, and element EL2 may be non-metal, metalloid, or any combination thereof.

Non-limiting examples of the metal may be an alkali metal (for example, lithium (Li), sodium (Na), potassium (K), rubidium (Rb), cesium (Cs), etc.); alkaline earth metal (for example, beryllium (Be), magnesium (Mg), calcium (Ca), strontium (Sr), barium (Ba), etc.); transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); post-transition metal (for example, zinc (Zn), indium (In), tin (Sn), etc.); and lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Non-limiting examples of the metalloid may be silicon (Si), antimony (Sb), and tellurium (Te).

Non-limiting examples of the non-metal may be oxygen (O) and halogen (for example, F, Cl, Br, I, etc.).

Non-limiting examples of the compound including element EL1 and element EL2 may be metal oxide, metal halide (for example, metal fluoride, metal chloride, metal bromide, or metal iodide), metalloid halide (for example, metalloid fluoride, metalloid chloride, metalloid bromide, or metalloid iodide), metal telluride, or any combination thereof.

Non-limiting examples of the metal oxide may be tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoOs, Mo₂O₅, etc.), and rhenium oxide (for example, ReOs, etc.).

Non-limiting examples of the metal halide may be alkali metal halide, alkaline earth metal halide, transition metal halide, post-transition metal halide, and lanthanide metal halide.

Non-limiting examples of the alkali metal halogen may include LiF, NaF, KF, RbF, CsF, LiCl, NaCl, KCl, RbCl, CsCl, LiBr, NaBr, KBr, RbBr, CsBr, Lil, Nal, KI, Rbl, and Csl.

Non-limiting examples of the alkaline earth metal halide may be BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and BaI₂.

Non-limiting examples of the transition metal halide may be titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBr₃, VI₃, etc.), niobium halide (for example, NbF₃, NbCl₃, NbBr₃, NbI₃, etc.), tantalum halide (for example, TaF₃, TaCl₃, TaBr₃, TaI₃, etc.), chromium halide (for example, CrFs, CrCl₃, CrBr₃, CrI₃, etc.), molybdenum halide (for example, MoF₃, MoCl₃, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCl, CuBr, Cul, etc.), silver halide (for example, AgF, AgCl, AgBr, Agl, etc.), and gold halide (for example, AuF, AuCl, AuBr, Aul, etc.).

Non-limiting examples of the post-transition metal halide may be zinc halide (for example, ZnF₂, ZnCl₂, ZnBr₂, ZnI₂, etc.), indium halide (for example, InI₃, etc.), and tin halide (for example, SnI₂, etc.).

Non-limiting examples of the lanthanide metal halide may be YbF, YbF₂, YbF₃, SmF₃, YbCl, YbCl₂, YbCl₃ SmCl₃, YbBr, YbBr₂, YbBr₃, SmBr₃, Ybl, YbI₂, YbI₃, and SmI₃.

Non-limiting examples of the metalloid halide may be antimony halide (for example, SbCl₅, etc.).

Non-limiting examples of the metal telluride may be alkali metal telluride (for example, Li₂Te, Na₂Te, K₂Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), and lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### [Emission layer in interlayer 130]

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and/or a blue emission layer, in which the two or more layers contact each other or are separated from each other to emit white light. In one or more embodiments, the emission layer may include two or more materials of a red light-emitting material, a green light-emitting material, and/or a blue light-emitting material, in which the two or more materials are mixed with each other in a single layer to emit white light.

The emission layer may include a host and a dopant. The dopant may include a phosphorescent dopant, a fluorescent dopant, or any combination thereof.

The amount of the dopant in the emission layer may be from about 0.01 part by weight to about 15 parts by weight based on 100 parts by weight of the host.

In one or more embodiments, the emission layer may include a quantum dot.

In some embodiments, the emission layer may include a delayed fluorescence material. The delayed fluorescence material may act as a host or a dopant in the emission layer.

A thickness of the emission layer may be in a range of about 10 nm (100 Å) to about 100 nm (1.000 Å), for example, about 20 nm (200 Å) to about 60 nm (600 Å). When the thickness of the emission layer is within these ranges, excellent or suitable light-emission characteristics may be obtained without a substantial increase in driving voltage.

### Host

In one or more embodiments, the host may include a compound represented by Formula 301:

**Formula 301** **[Ar₃₀₁]_{xb11}-[(L₃₀₁)_{xb1}-R₃₀₁]_{xb21}**

wherein, in Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ,-Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ may each be the same as described herein with respect to Q₁.

For example, when xb11 in Formula 301 is 2 or more, two or more Ar₃₀₁(s) may be linked to each other via a single bond.

In one or more embodiments, the host may include a compound represented by Formula 301-1, a compound represented by Formula 301-2, or any combination thereof:

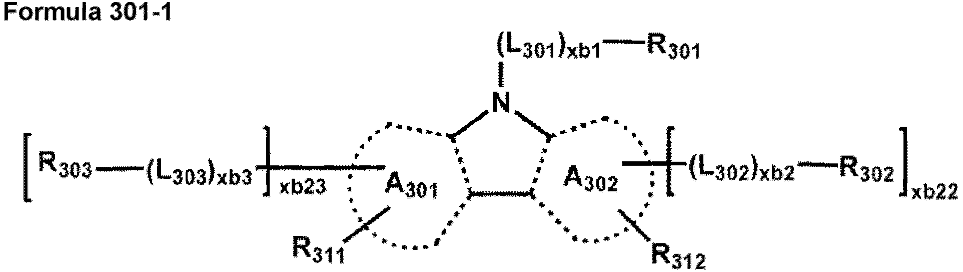

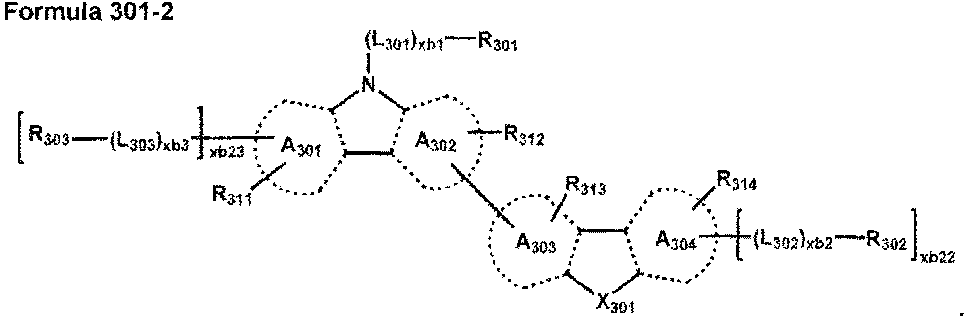

In Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be the same as described herein,
L₃₀₂ to L₃₀₄ may each independently be the same as described herein with respect to with L₃₀₁,
xb2 to xb4 may each independently be the same as described herein with respect to xb1, and
R₃₀₂ to R₃₀₅ and R₃₁₁ to R₃₁₄ may each be the same as described herein with respect to R₃₀₁.

In one or more embodiments, the host may include an alkali earth metal complex, a post-transition metal complex, or any combination thereof. For example, in some embodiments, the host may include a Be complex (for example, Compound H55), an Mg complex, a Zn complex, or any combination thereof.

In one or more embodiments, the host may include one selected from among Compounds H1 to H124, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or any combination thereof:

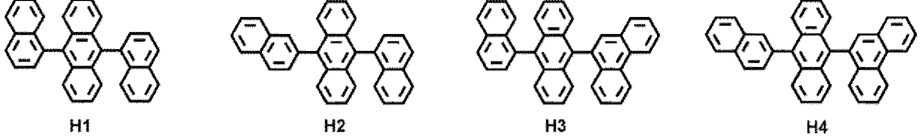

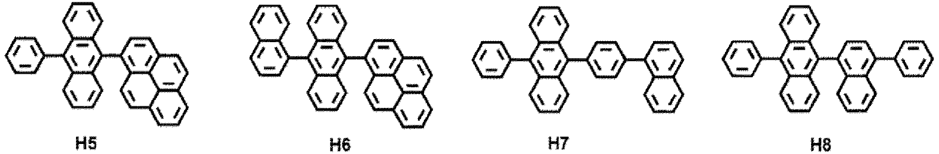

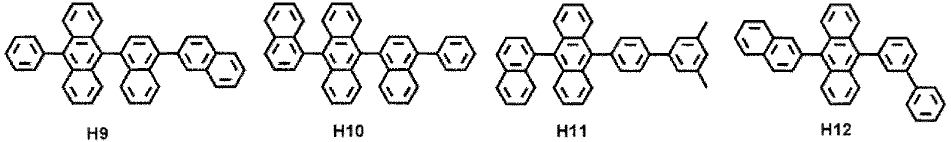

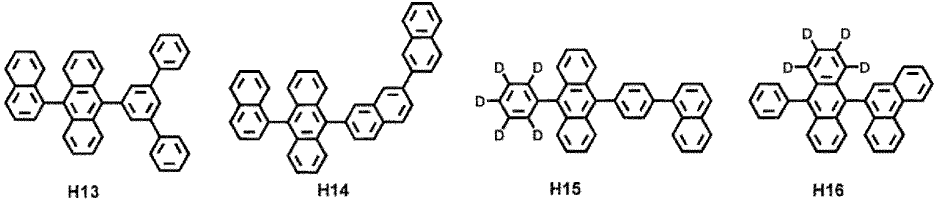

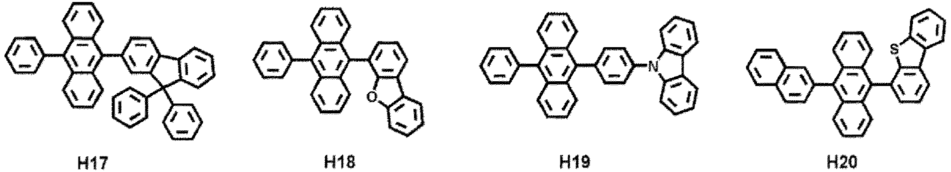

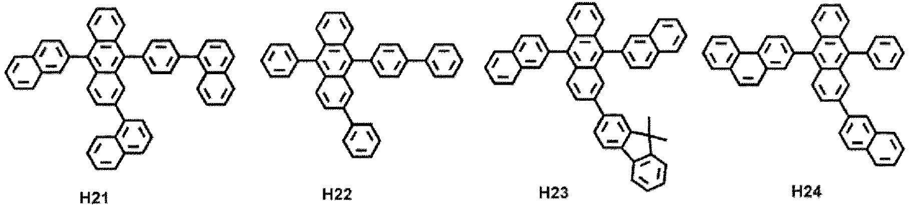

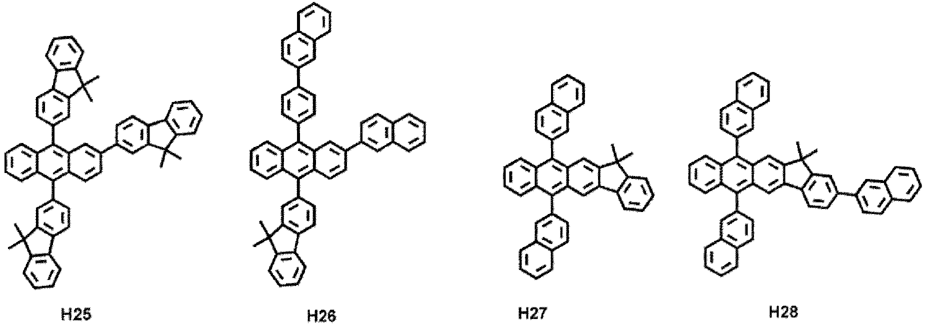

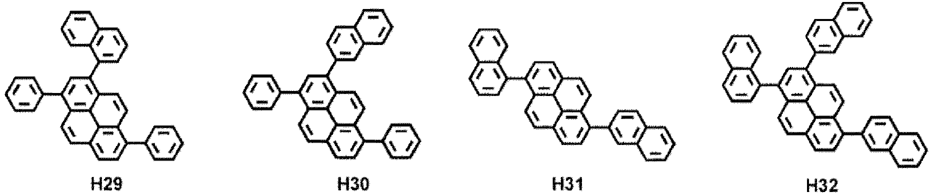

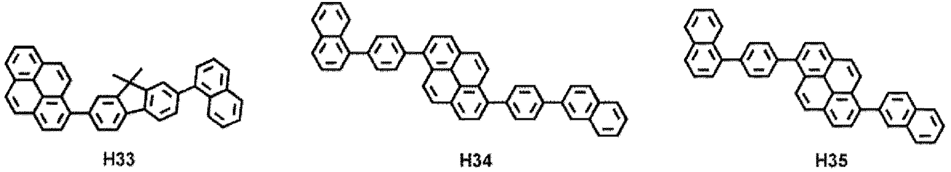

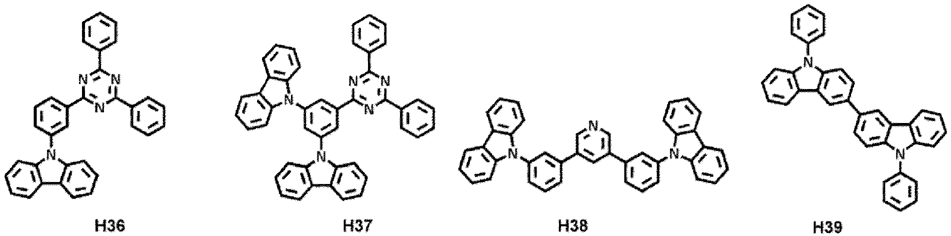

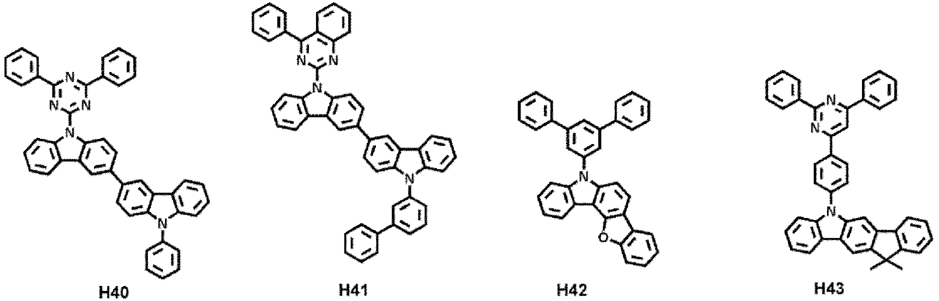

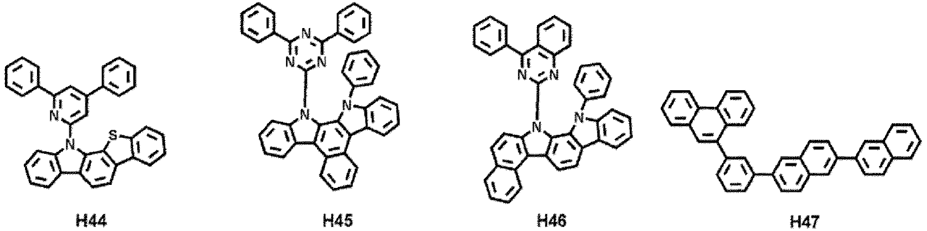

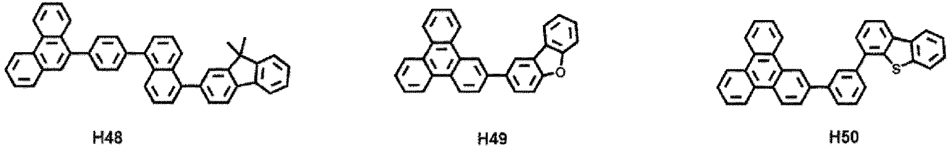

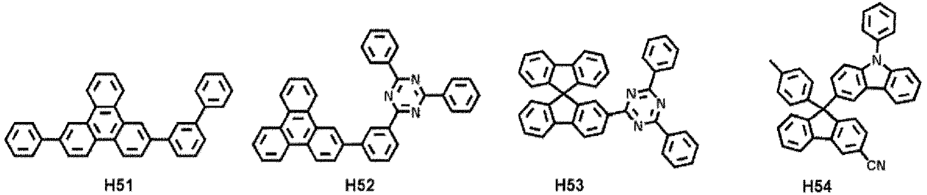

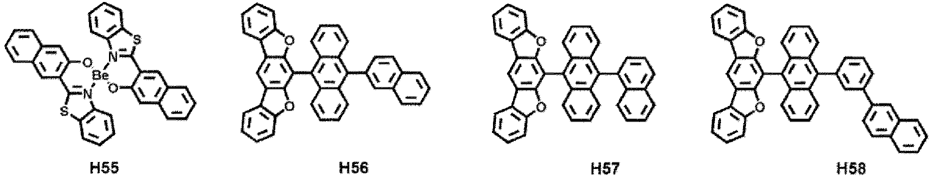

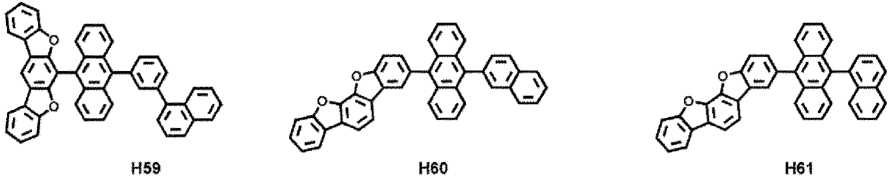

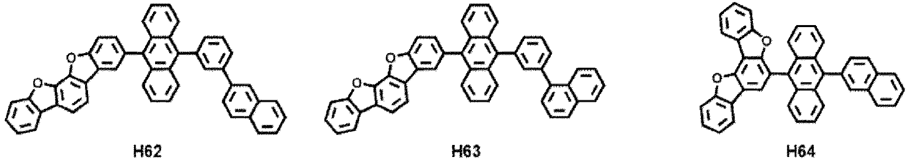

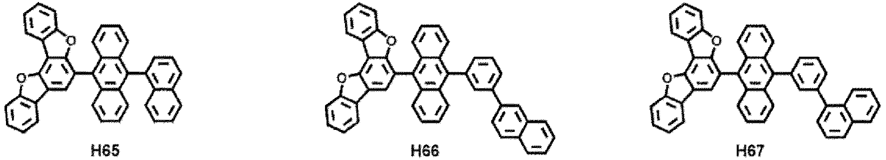

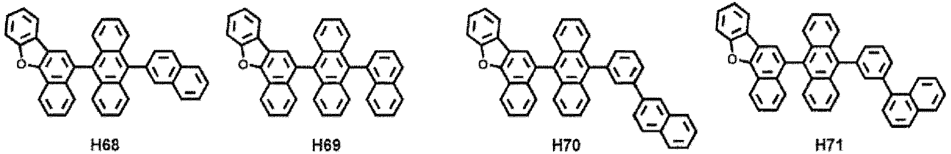

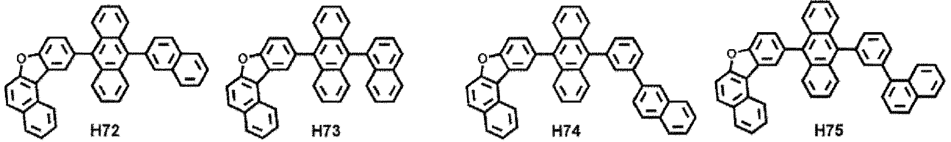

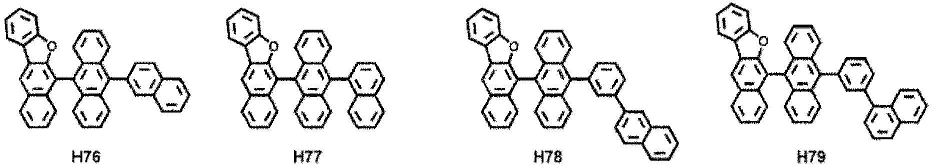

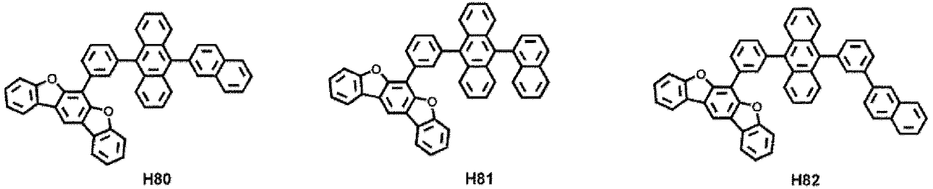

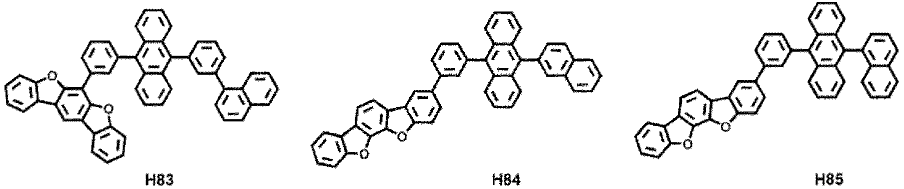

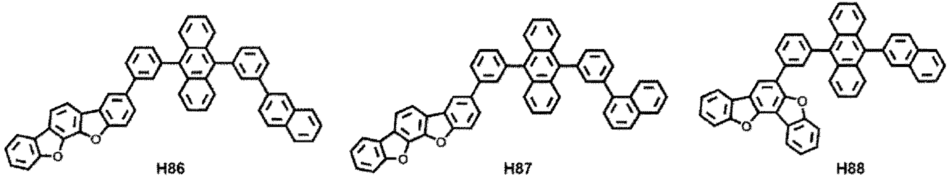

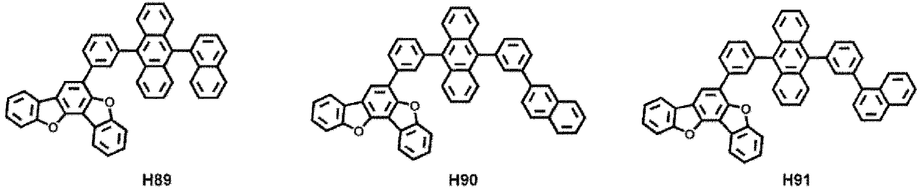

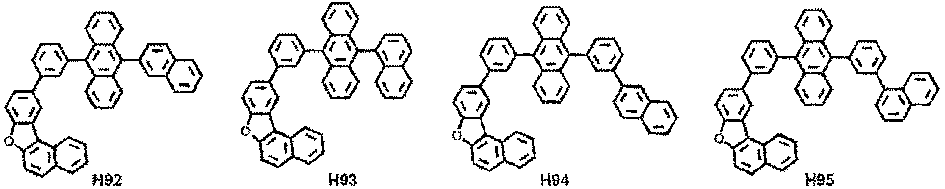

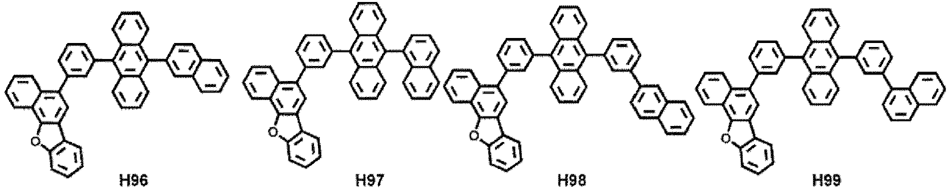

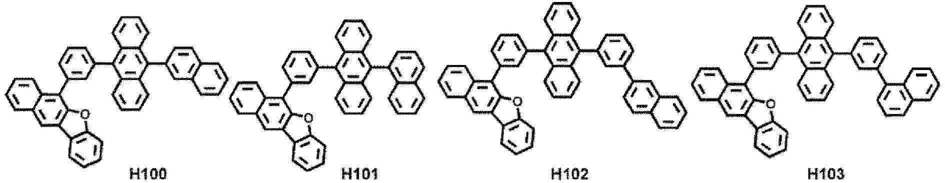

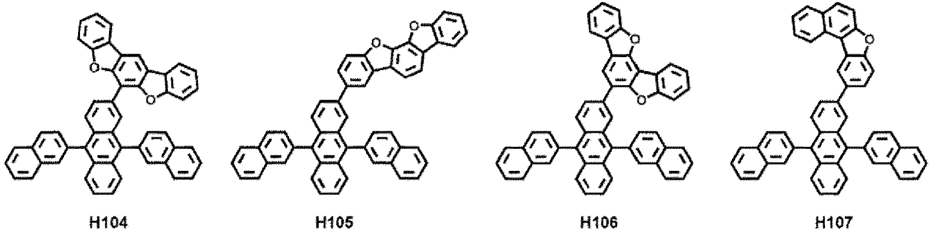

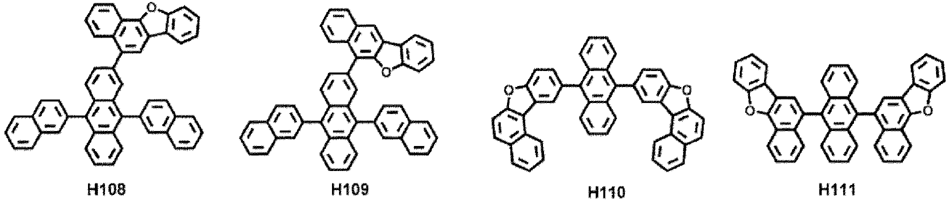

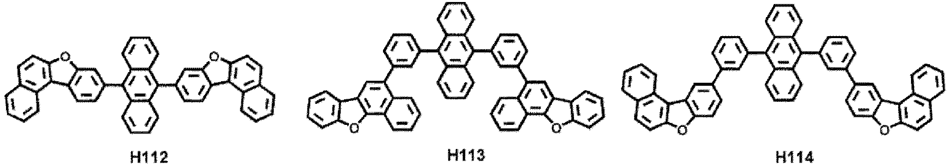

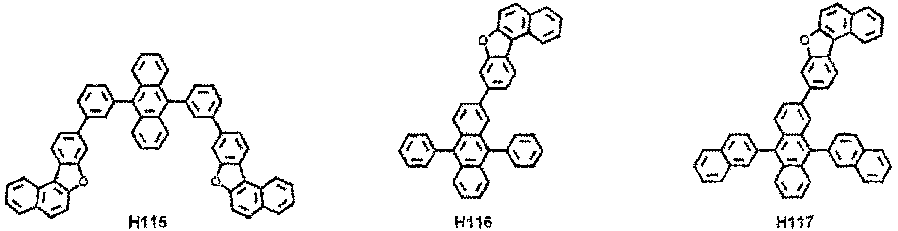

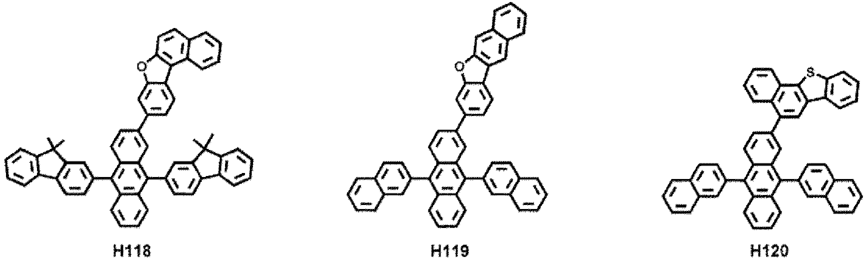

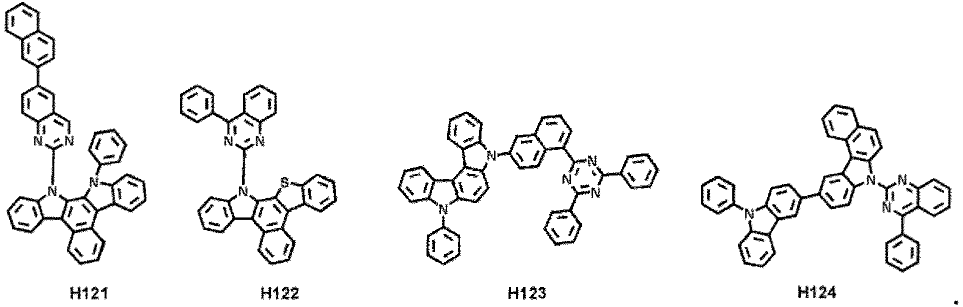

### [Phosphorescent dopant]

In one or more embodiments, the phosphorescent dopant may include at least one transition metal as a central metal.

In some embodiments, the phosphorescent dopant may include a monodentate ligand, a bidentate ligand, a tridentate ligand, a tetradentate ligand, a pentadentate ligand, a hexadentate ligand, or any combination thereof.

In some embodiments, the phosphorescent dopant may be electrically neutral.

For example, in some embodiments, the phosphorescent dopant may include an organometallic compound represented by Formula 401:

**Formula 401** **M(L₄₀₁)_{xc1}(L₄₀₂)_{xc2}**

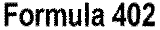

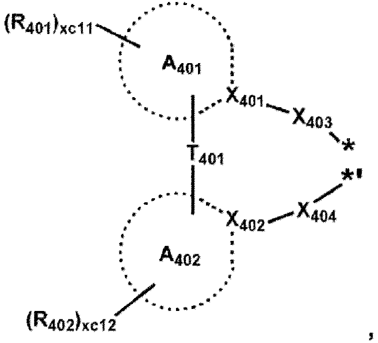

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein when xc1 is two or more, two or more L₄₀₁(s) may be identical to or different from each other,
L₄₀₂ may be an organic ligand, and xc2 may be 0, 1, 2, 3, or 4, and when xc2 is 2 or more, two or more L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordination bond), O, S, N(Q₄₁₃), B(Q₄₁₃), P(Q₄₁₃), C(Q₄₁₃)(Q₄₁₄), or Si(Q413)(Q414),
Q₄₁₁ to Q₄₁₄ may each be the same as described herein with respect to Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q4₀₁), or -P(=O)(Q₄₀₁)(Q₄₀₂),
Q₄₀₁ to Q₄₀₃ may each be the same as described herein with respect to Q₁,
xc11 and xc12 may each independently be an integer from 0 to 10, and
* and *' in Formula 402 each indicate a binding site to M in Formula 401.

For example, in Formula 402, i) X₄₀₁ may be nitrogen, and X₄₀₂ may be carbon, or ii) each of X₄₀₁ and X₄₀₂ may be nitrogen.

In one or more embodiments, when xc1 in Formula 401 is 2 or more, two ring A₄₀₁(s) among two or more L₄₀₁ may optionally be bonded to each other via T₄₀₂, which is a linking group, and/or two ring A₄₀₂(s) among two or more L₄₀₁ may optionally be bonded to each other via T₄₀₃, which is a linking group (see Compounds PD1 to PD4 and PD7). T₄₀₂ and T₄₀₃ may each be the same as described herein with respect to T₄₀₁.

L₄₀₂ in Formula 401 may be an organic ligand. For example, L₄₀₂ may include a halogen group, a diketone group (for example, an acetylacetonate group), a carboxylic acid group (for example, a picolinate group), -C(=O), an isonitrile group, -CN group, a phosphorus group (for example, a phosphine group, a phosphite group, etc.), or any combination thereof.

In one or more embodiments, the phosphorescent dopant may include, for example, one selected from among compounds PD1 to PD39, or any combination thereof:

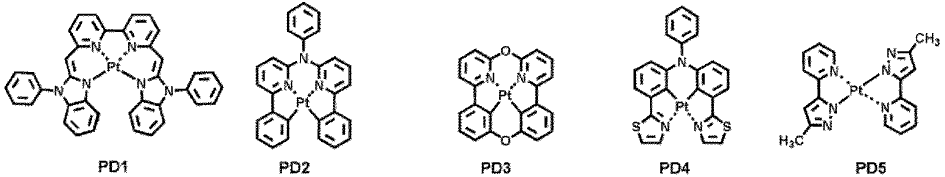

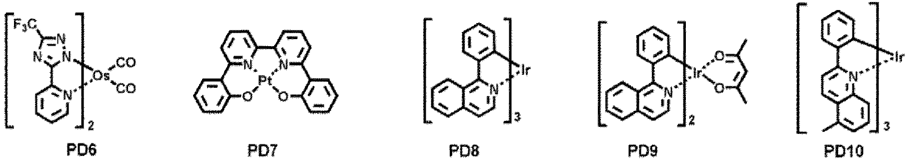

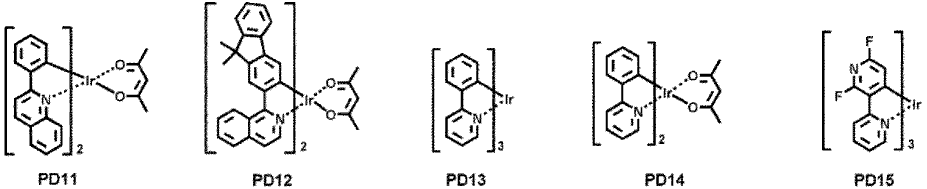

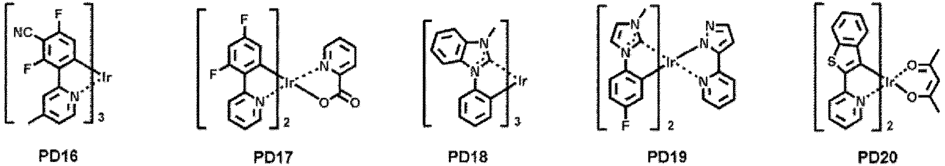

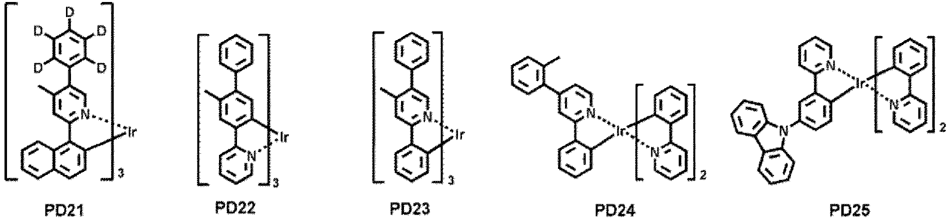

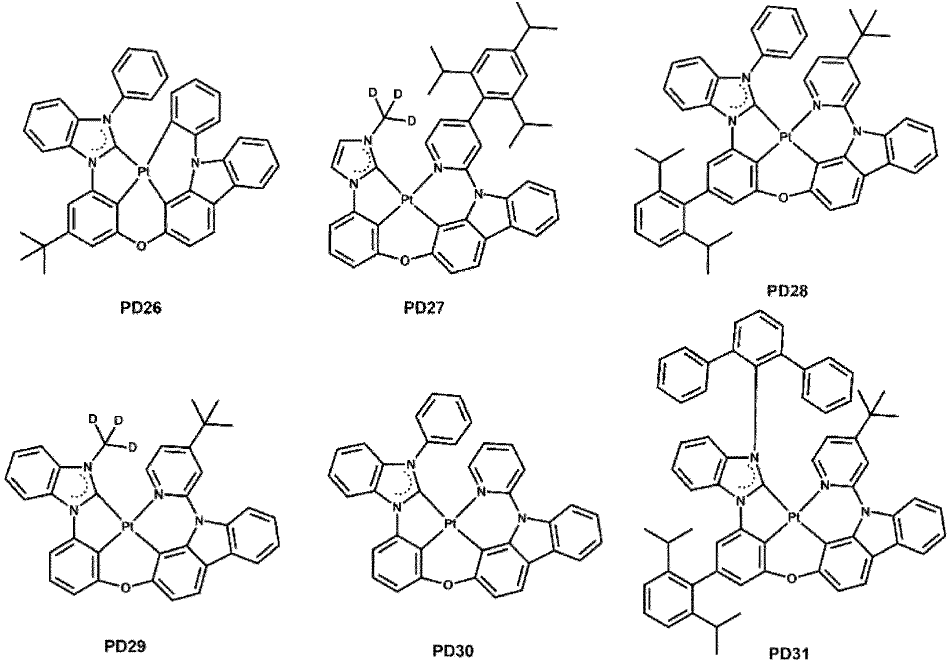

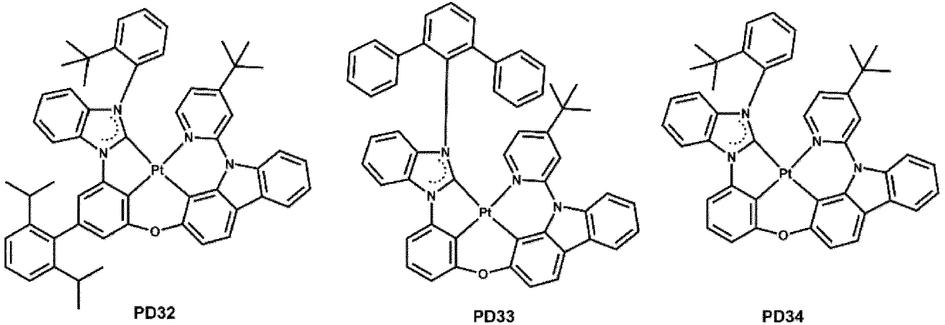

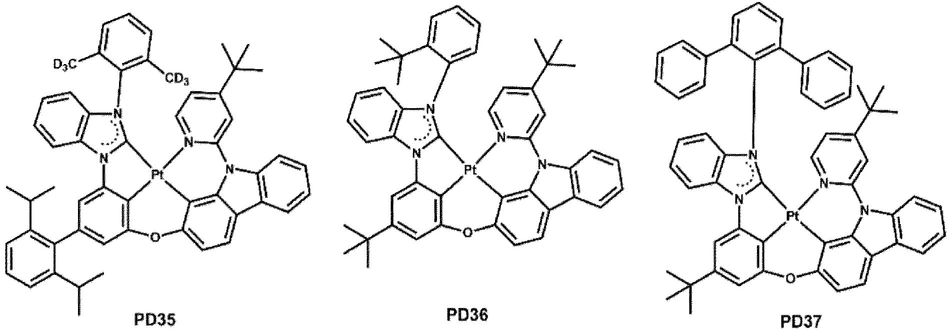

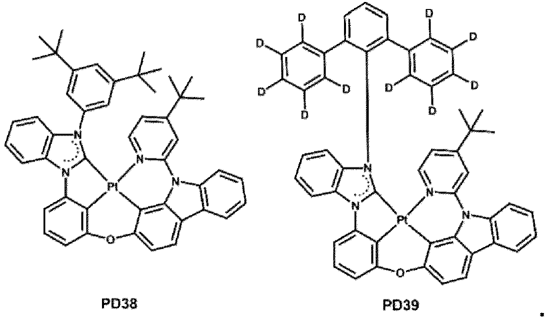

### [Fluorescent dopant]

In one or more embodiments, the fluorescent dopant may include an amine group-containing compound, a styryl group-containing compound, or any combination thereof.

For example, in some embodiments, the fluorescent dopant may include a compound represented by Formula 501: 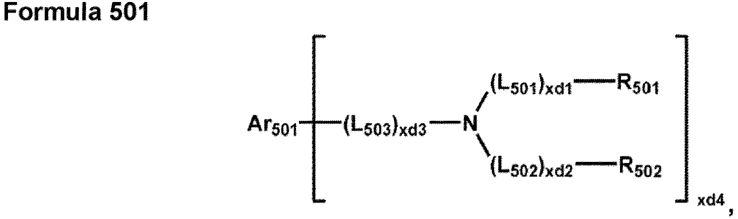
wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, in some embodiments, Ar₅₀₁ in Formula 501 may be a condensed cyclic group (for example, an anthracene group, a chrysene group, or a pyrene group) in which three or more monocyclic groups are condensed together.

In one or more embodiments, xd4 in Formula 501 may be 2.

For example, in some embodiments, the fluorescent dopant may include: one selected from among Compounds FD1 to FD36; 4,4'-bis(2,2-diphenylvinyl)-1,1'-biphenyl (DPVBi); 4,4'-bis[4-(di-p-tolylamino)styryl]biphenyl (DPAVBi); or any combination thereof:

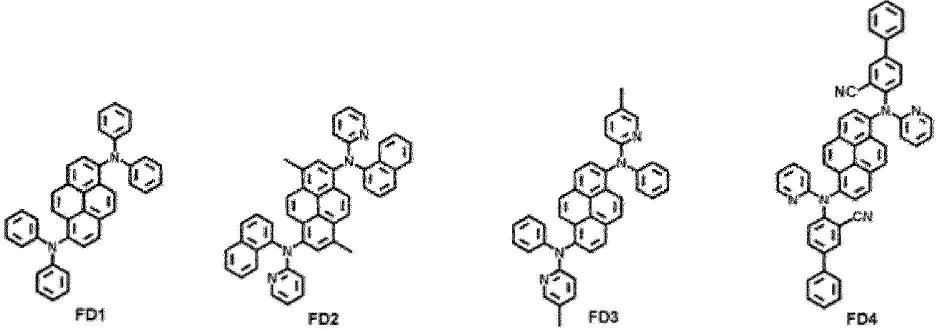

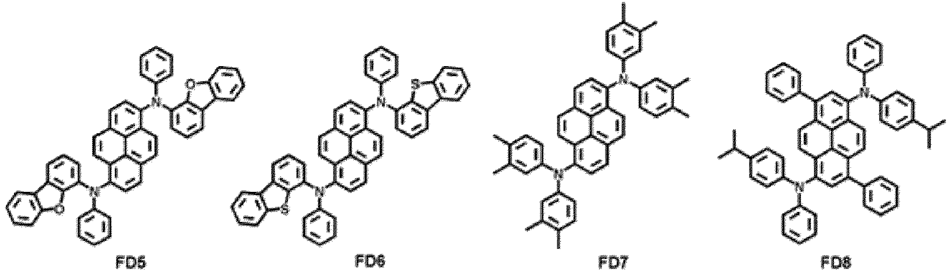

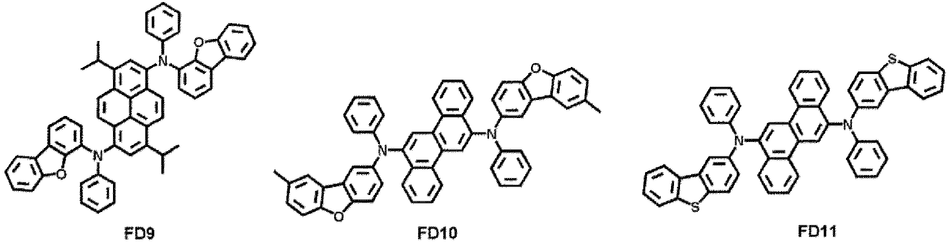

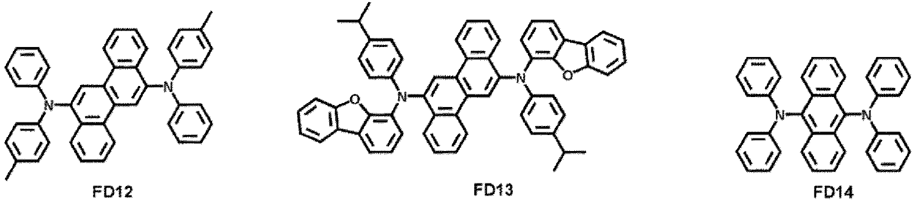

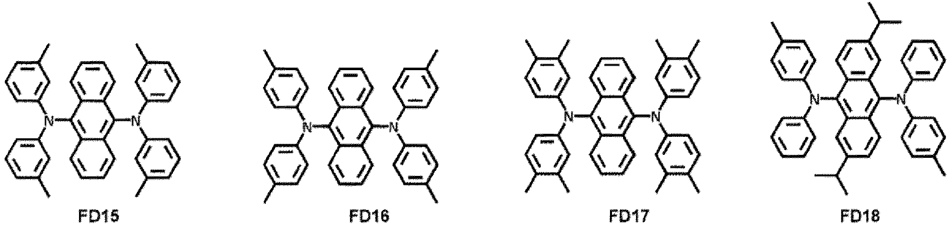

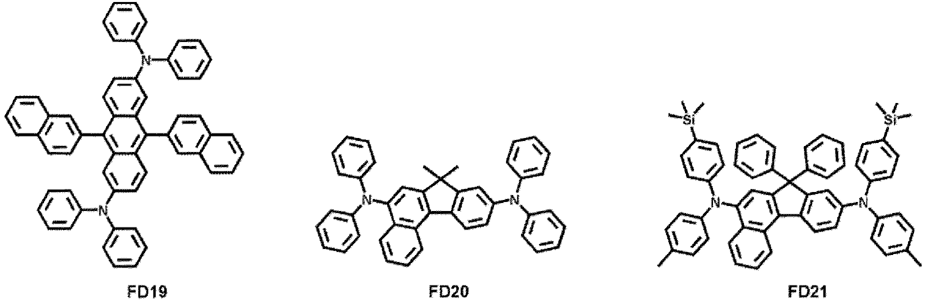

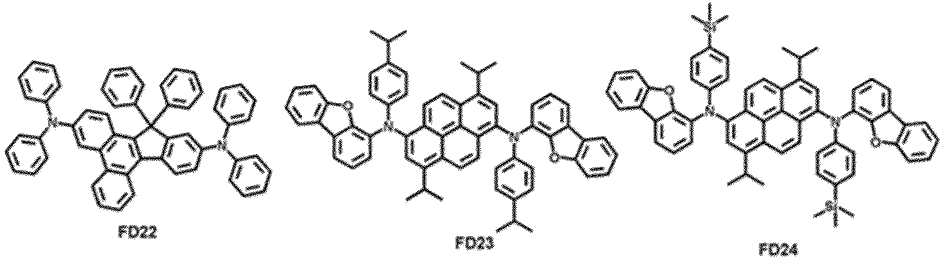

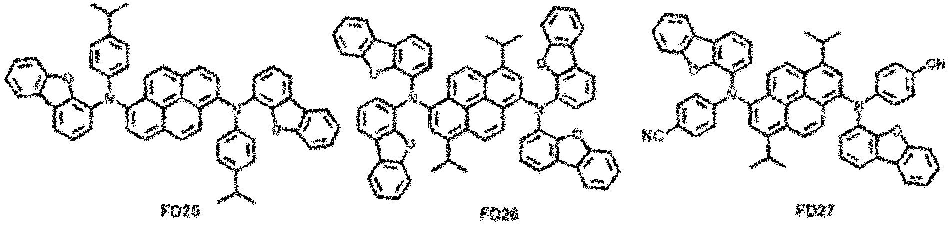

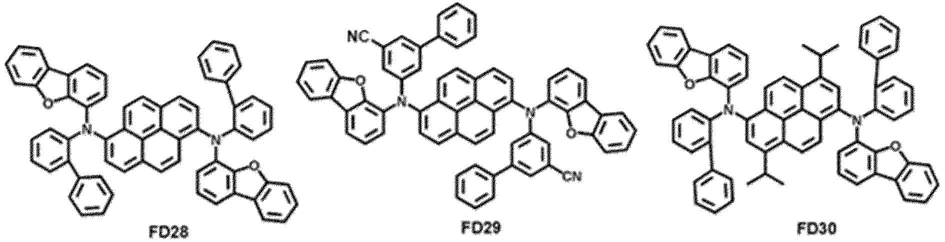

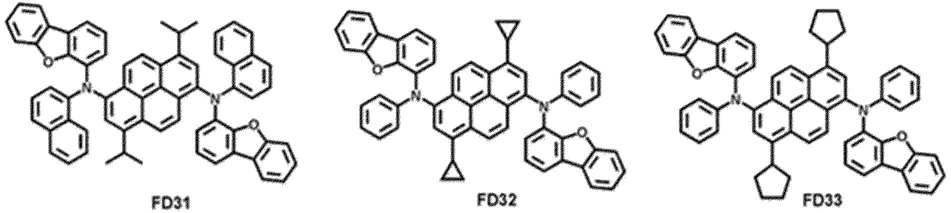

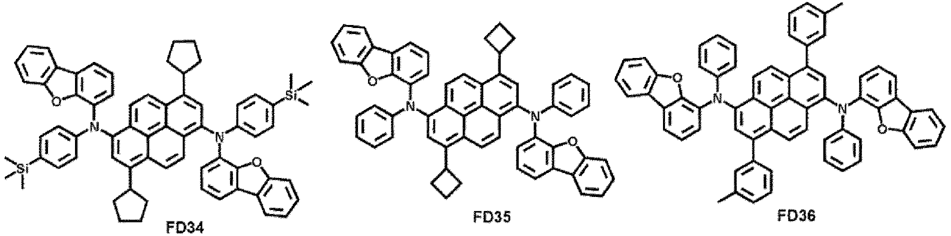

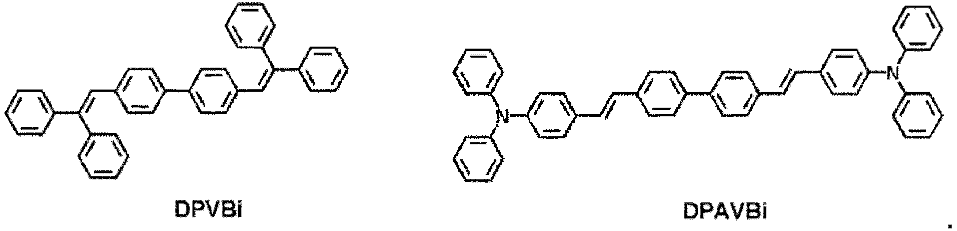

### [Delayed fluorescence material]

In one or more embodiments, the emission layer may include a delayed fluorescence material.

In the present disclosure, the delayed fluorescence material may be selected from compounds capable of emitting delayed fluorescent light based on a delayed fluorescence emission mechanism.

The delayed fluorescence material included in the emission layer may act as a host or a dopant depending on the type or kind of other materials included in the emission layer.

In one or more embodiments, the difference between the triplet energy level (eV) of the delayed fluorescence material and the singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material satisfies the above-described range, up-conversion from the triplet state to the singlet state of the delayed fluorescence materials may effectively occur, and thus, the luminescence efficiency of the light-emitting device 10 may be improved.

For example, in some embodiments, the delayed fluorescence material may include i) a material including at least one electron donor (for example, a π electron-rich C₃-C₆₀ cyclic group, such as a carbazole group) and at least one electron acceptor (for example, a sulfoxide group, a cyano group, or a π electron-deficient nitrogen-containing C₁-C₆₀ cyclic group), and ii) a material including a C₈-C₆₀ polycyclic group in which two or more cyclic groups are condensed while sharing boron (B).

Non-limiting examples of the delayed fluorescence material may include at least one selected from among compounds DF1 to DF9:

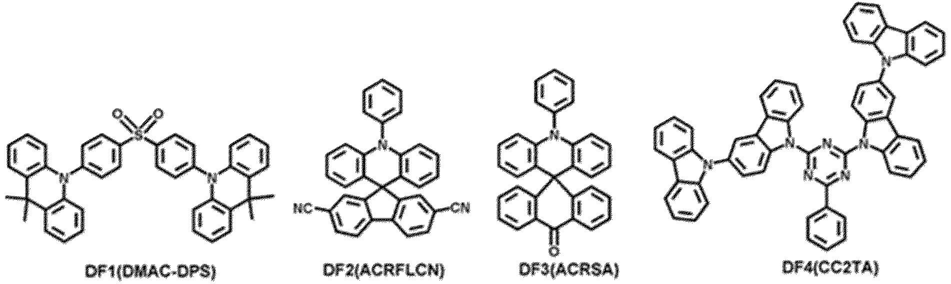

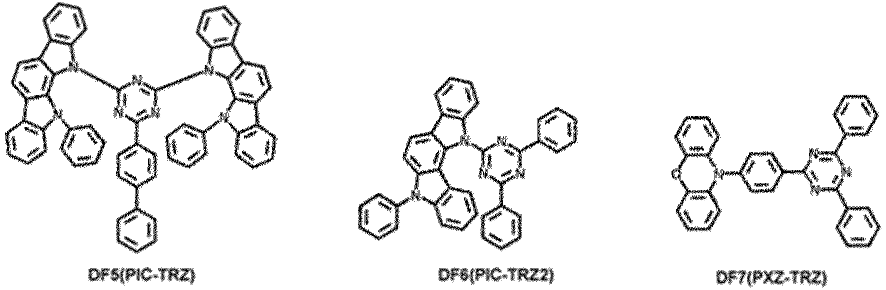

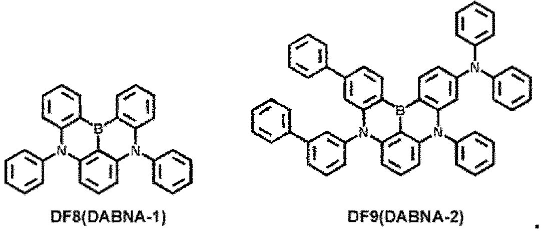

### [Quantum dot]

In one or more embodiments, the emission layer may include a quantum dot.

The term "quantum dot" as utilized herein may refer to a crystal of a semiconductor compound, and may include any material capable of emitting light of one or more suitable emission wavelengths according to the size of the crystal.

A diameter of the quantum dot may be, for example, in a range of about 1 nm to about 10 nm.

The quantum dot may be synthesized by a wet chemical process, a metal organic chemical vapor deposition process, a molecular beam epitaxy process, or any process similar thereto.

The wet chemical process is a method including mixing a precursor material with an organic solvent and then growing a quantum dot particle crystal. When the crystal grows, the organic solvent naturally acts as a dispersant coordinated on the surface of the quantum dot crystal and controls the growth of the crystal so that the growth of quantum dot particles can be controlled or selected through a process which costs lower and is easier than vapor deposition methods, such as metal organic chemical vapor deposition (MOCVD) or molecular beam epitaxy (MBE),

The quantum dot may include Group II-VI semiconductor compounds, Group III-V semiconductor compounds, Group III-VI semiconductor compounds, Group I-III-VI semiconductor compounds, Group IV-VI semiconductor compounds, a Group IV element or compound, or any combination thereof.

Non-limiting examples of the Group II-VI semiconductor compound may be a binary compound, such as CdS, CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; or any combination thereof.

Non-limiting examples of the Group III-V semiconductor compound may include: a binary compound, such as GaN, GaP, GaAs, GaSb, AlN, AlP, AlAs, AlSb, InN, InP, InAs, or InSb; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, or InPSb; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, or InAlPSb; or any combination thereof. In some embodiments, the Group III-V semiconductor compound may further include a Group II element. Non-limiting examples of the Group III-V semiconductor compound further including a Group II element may be InZnP, InGaZnP, InAlZnP, etc.

Non-limiting examples of the Group III-VI semiconductor compound may be: a binary compound, such as GaS, GaSe, Ga₂Se₃, GaTe, InS, InSe, In₂S₃, In₂Se₃, or InTe; a ternary compound, such as InGaS₃, or InGaSe₃; and any combination thereof.

Non-limiting examples of the Group I-III-VI semiconductor compound may be: a ternary compound, such as AgInS, AgInS₂, CuInS, CuInS₂, CuGaO₂, AgGaO₂, or AgAlO₂; or any combination thereof.

Non-limiting examples of the Group IV-VI semiconductor compound may be: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, or SnPbTe; a quaternary compound, such as SnPbSSe, SnPbSeTe, or SnPbSTe; or any combination thereof.

The Group IV element or compound may include: a single element compound, such as Si or Ge; a binary compound, such as SiC or SiGe; or any combination thereof.

Each element included in a multi-element compound such as the binary compound, the ternary compound, and the quaternary compound may be present at a substantially uniform concentration or non-substantially uniform concentration in a particle.

In some embodiments, the quantum dot may have a single structure in which the concentration of each element in the quantum dot is substantially uniform, or a core-shell dual structure. For example, the material included in the core and the material included in the shell may be different from each other.

The shell of the quantum dot may act as a protective layer that prevents chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases toward the center of the core.

Non-limiting examples of the shell of the quantum dot may be an oxide of metal, metalloid, or non-metal, a semiconductor compound, and any combination thereof. Non-limiting examples of the oxide of metal, metalloid, or non-metal may be a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound, such as MgAl₂O₄, CoFe₂O₄, NiFe₂O₄, or CoMn₂O₄; and any combination thereof. Non-limiting examples of the semiconductor compound may be, as described herein, a Group II-VI semiconductor compound; a Group III-V semiconductor compound; a Group III-VI semiconductor compound; a Group I-III-VI semiconductor compound; a Group IV-VI semiconductor compound; and any combination thereof. For example, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

A full width at half maximum (FWHM) of the emission wavelength spectrum of the quantum dot may be about 45 nm or less, for example, about 40 nm or less, for example, about 30 nm or less, and within these ranges, color purity or color reproducibility may be increased. In some embodiments, because the light emitted through the quantum dot is emitted in all directions, the wide viewing angle may be improved.

In some embodiments, the quantum dot may be in the form of a substantially spherical particle, a pyramidal particle, a multi-arm particle, a cubic nanoparticle, a nanotube particle, a nanowire particle, a nanofiber particle, or a nanoplate particle.

Because the energy band gap may be adjusted by controlling the size of the quantum dot, light having one or more suitable wavelength bands may be obtained from the quantum dot emission layer. Accordingly, by utilizing quantum dots of different sizes, a light-emitting device that emits light of one or more suitable wavelengths may be implemented. In one or more embodiments, the size of the quantum dot may be selected to emit red, green and/or blue light. In some embodiments, the size of the quantum dot may be configured to emit white light by combination of light of one or more suitable colors.

### [Electron transport region in interlayer 130]

The electron transport region may have: i) a single-layered structure including (e.g., consisting of) a single layer consisting of a single material, ii) a single-layered structure including (e.g., consisting of) a single layer including (e.g., consisting of) a plurality of different materials, or iii) a multi-layered structure including a plurality of layers including different materials.

The electron transporting region may include a buffer layer, a hole blocking layer, an electron control layer, an electron transport layer, an electron injection layer, or any combination thereof.

For example, the electron transport region may include an electron transport layer/electron injection layer structure, a hole blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer in the stated order.

In one or more embodiments, the electron transport region (for example, the buffer layer, the hole blocking layer, the electron control layer, or the electron transport layer in the electron transport region) may include a metal-free compound including at least one π electron-deficient nitrogen-containing C₁-C₆₀ cyclic group.

For example, in some embodiments, the electron transport region may include a compound represented by Formula 601:

**Formula 601** **[Ar₆₀₁]ₓₑ₁₁-[(L₆₀₁)ₓₑ₁-R₆₀₁]ₓₑ₂₁**

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described herein with respect to Q₁,
xe21 may be 1, 2, 3, 4, or 5,
at least one selected from among Ar₆₀₁, L₆₀₁, and R₆₀₁ may each independently be a π electron-deficient nitrogen-containing C₁-C₆₀ cyclic group unsubstituted or substituted with at least one R₁₀ₐ.

For example, when xe11 in Formula 601 is 2 or more, two or more Ar₆₀₁(s) may be linked to each other via a single bond.

In some embodiments, Ar₆₀₁ in Formula 601 may be a substituted or unsubstituted anthracene group.

In some embodiments, the electron transport region may include a compound represented by Formula 601-1: 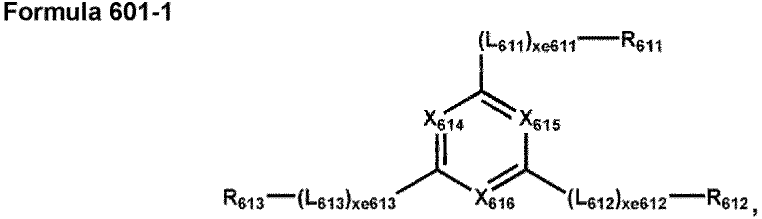
wherein, in Formula 601-1,
X₆₁₄ may be N or C(R₆₁₄), X₆₁₅ may be N or C(R₆₁₅), X₆₁₆ may be N or C(R₆₁₆), and at least one selected from among X₆₁₄ to X₆₁₆ may be N,
L₆₁₁ to L₆₁₃ may each be the same as described herein with respect to L₆₀₁,
xe611 to xe613 may each be the same as described herein with respect to xe1,
R₆₁₁ to R₆₁₃ may each be the same as described herein with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

In one or more embodiments, the electron transport region may include one selected from among Compounds ET1 to ET45, 2,9-dimethyl-4,7-diphenyl-1,10-phenanthroline (BCP), 4,7-diphenyl-1,10-phenanthroline (Bphen), Alq₃, bis(2-methyl-8-quinolinolato-N1,O8)-(1,1'-biphenyl-4-olato)aluminum (BAlq), 3-(4-biphenyl)-4-phenyl-5-tert-butylphenyl-1,2,4-triazole (TAZ), 4-(naphthalen-1-yl)-3,5-diphenyl-4H-1,2,4-triazole (NTAZ), or any combination thereof:

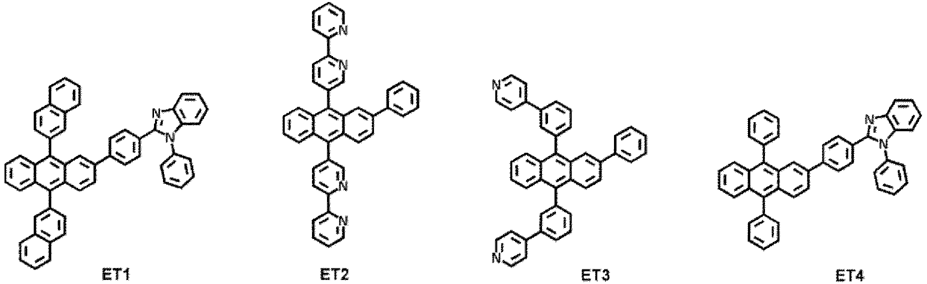

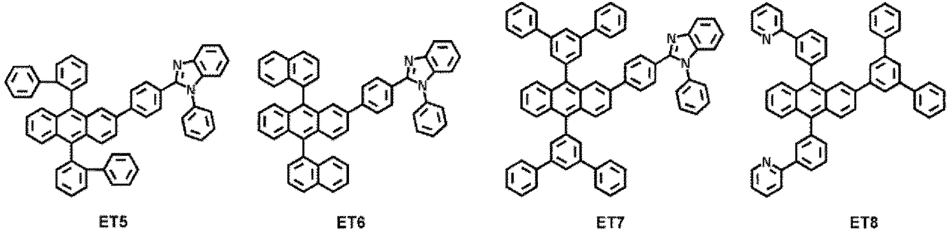

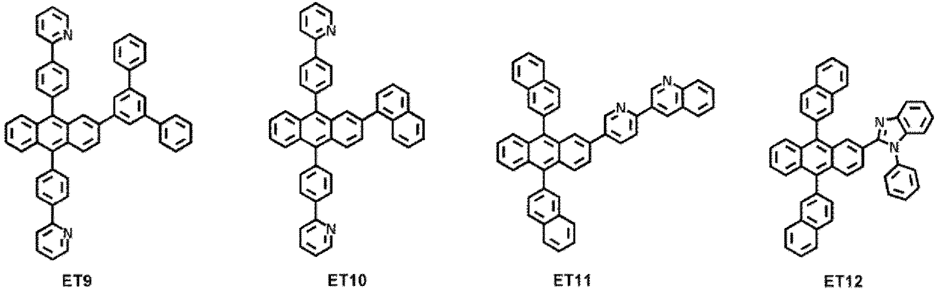

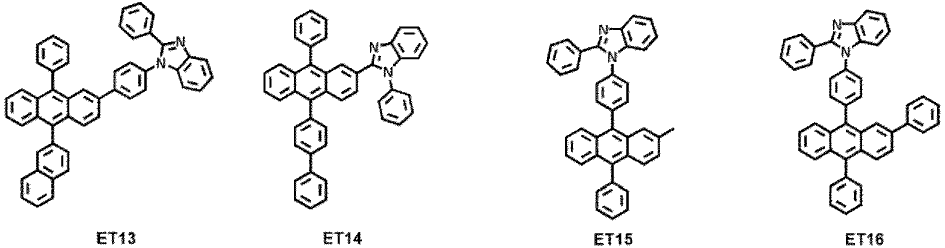

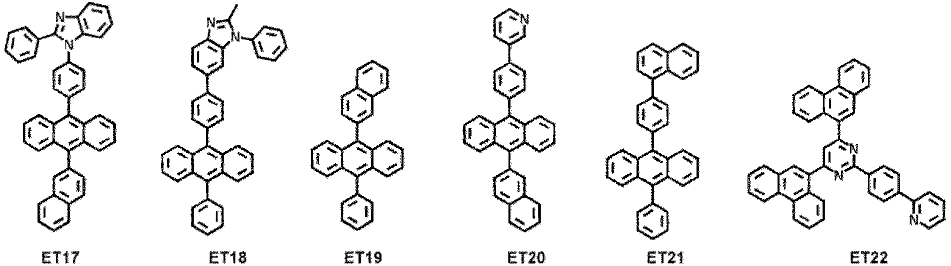

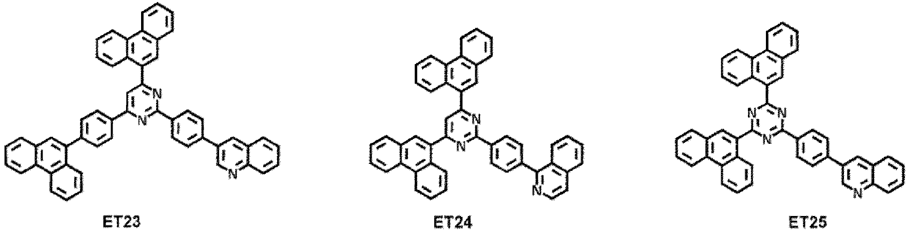

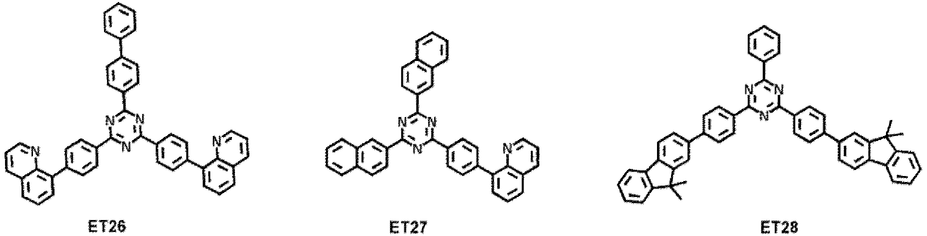

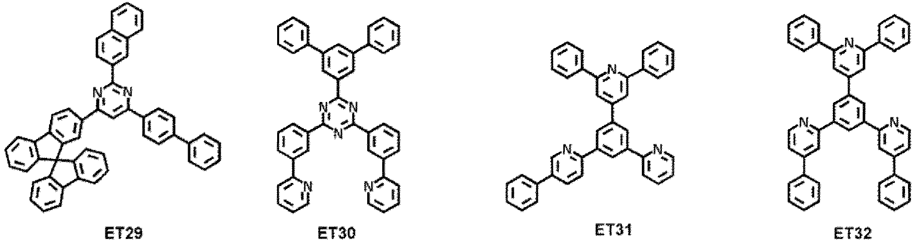

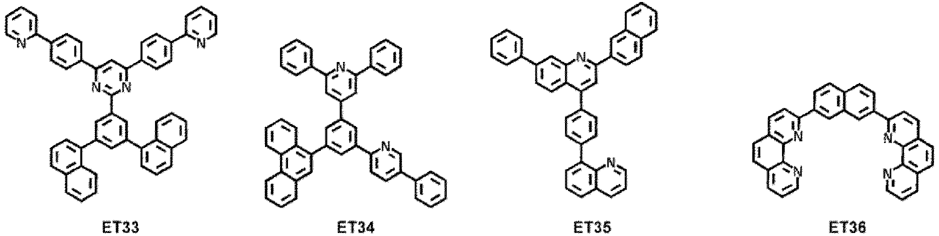

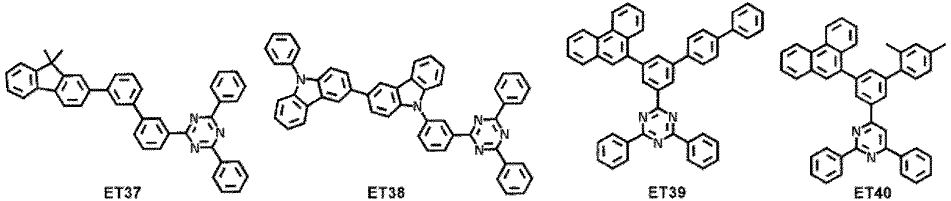

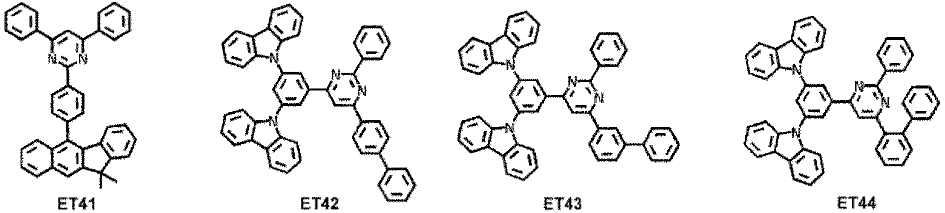

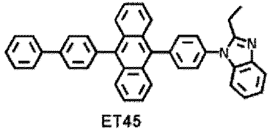

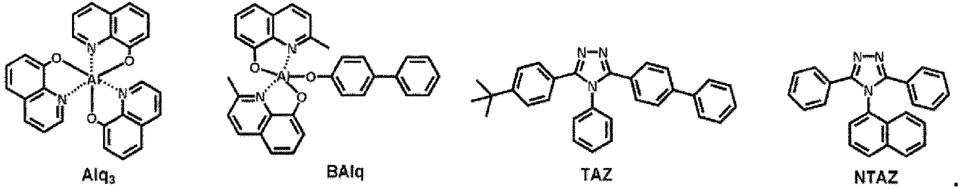

A thickness of the electron transport region may be from about 10 nm (100 Å) to about 500 nm (5.000 Å), for example, about 16 nm (160 Å) to about 400 nm (4.000 Å). When the electron transport region includes a buffer layer, a hole blocking layer, an electron control layer, an electron transport layer, or any combination thereof, the thickness of the buffer layer, the hole blocking layer, or the electron control layer may each independently be from about 2 nm (20 Å) to about 100 nm (1.000 Å), for example, about 3 nm (30 Å) to about 30 nm (300 Å), and the thickness of the electron transport layer may be from about 10 nm (100 Å) to about 100 nm (1.000 Å), for example, about 15 nm (150 Å) to about 50 nm (500 Å). When the thickness of the buffer layer, the hole blocking layer, the electron control layer, the electron transport layer, and/or the electron transport region are within these ranges, satisfactory electron transporting characteristics may be obtained without a substantial increase in driving voltage.

In one or more embodiments, the electron transport region (for example, the electron transport layer in the electron transport region) may further include, in addition to the materials described above, a metal-containing material.

The metal-containing material may include an alkali metal complex, an alkaline earth metal complex, or any combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, in some embodiments, the metal-containing material may include a Li complex. The Li complex may include, for example, Compound ET-D1 (LiQ) or ET-D2:

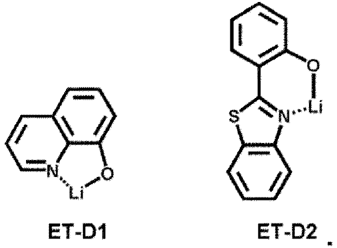

In one or more embodiments, the electron transport region may include an electron injection layer that facilitates the injection of electrons from the second electrode 150. The electron injection layer may directly contact the second electrode 150.

The electron injection layer may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides, halides (for example, fluorides, chlorides, bromides, or iodides), or tellurides of the alkali metal, the alkaline earth metal, and the rare earth metal, or any combination thereof.

The alkali metal-containing compound may include: alkali metal oxides, such as Li₂O, Cs₂O, or K₂O; alkali metal halides, such as LiF, NaF, CsF, KF, Lil, Nal, Csl, or KI; or any combination thereof. The alkaline earth metal-containing compound may include an alkaline earth metal compound, such as BaO, SrO, CaO, BaₓSr₁₋ₓO (wherein x is a real number satisfying the condition of 0<x<1), BaₓCa₁₋ₓO (wherein x is a real number satisfying the condition of 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In one or more embodiments, the rare earth metal-containing compound may include lanthanide metal telluride. Non-limiting examples of the lanthanide metal telluride may be LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include i) one of ions of the alkali metal, the alkaline earth metal, and the rare earth metal, respectively and ii) a ligand bonded to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further include an organic material (for example, a compound represented by Formula 601).

In one or more embodiments, the electron injection layer may include (e.g., consist of): i) an alkali metal-containing compound (for example, an alkali metal halide); or ii) a) an alkali metal-containing compound (for example, an alkali metal halide), and b) an alkali metal, an alkaline earth metal, a rare earth metal, or any combination thereof. For example, in some embodiments, the electron injection layer may be a KI:Yb co-deposited layer, an RbI:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be uniformly or non-uniformly dispersed in a matrix including the organic material.

A thickness of the electron injection layer may be in a range of about 0,1 nm (1 Å) to about 10 nm (100 Å), and, for example, about 0,3 nm (3 Å) to about 9 nm (90 Å). When the thickness of the electron injection layer is within the ranges described above, satisfactory electron injection characteristics may be obtained without a substantial increase in driving voltage.

### [Second electrode 150]

The second electrode 150 may be on the interlayer 130 having a structure as described above. The second electrode 150 may be a cathode, which is an electron injection electrode, and as the material for the second electrode 150, a metal, an alloy, an electrically conductive compound, or any combination thereof, each having a low-work function, may be utilized.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure or a multi-layered structure including a plurality of layers.

### [Capping layer]

A first capping layer may be located outside the first electrode 110, and/or a second capping layer may be located outside the second electrode 150. In some embodiments, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

In some embodiments, light generated in an emission layer of the interlayer 130 of the light-emitting device 10 may be extracted toward the outside through the first electrode 110 which is a semi-transmissive electrode or a transmissive electrode, and the first capping layer. In some embodiments, light generated in an emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external emission efficiency according to the principle of constructive interference. Consequently, the light extraction efficiency of the light-emitting device 10 is increased, so that the luminescence efficiency of the light-emitting device 10 may be improved.

Each of the first capping layer and the second capping layer may include a material having a refractive index of 1.6 or more (at 589 nm).

The first capping layer and the second capping layer may each independently be an organic capping layer including an organic material, an inorganic capping layer including an inorganic material, or an organic-inorganic composite capping layer including an organic material and an inorganic material.

At least one selected from among the first capping layer and the second capping layer may each independently include carbocyclic compounds, heterocyclic compounds, amine group-containing compounds, porphine derivatives, phthalocyanine derivatives, naphthalocyanine derivatives, alkali metal complexes, alkaline earth metal complexes, or any combination thereof. In some embodiments, the carbocyclic compound, the heterocyclic compound, and the amine group-containing compound may be substituted with a substituent including O, N, S, Se, Si, F, Cl, Br, I, or any combination thereof. In one or more embodiments, at least one selected from among the first capping layer and the second capping layer may each independently include an amine group-containing compound.

For example, in some embodiments, at least one selected from among the first capping layer and the second capping layer may each independently include a compound represented by Formula 201, a compound represented by Formula 202, or any combination thereof.

In one or more embodiments, at least one selected from among the first capping layer and the second capping layer may each independently include one or more selected from Compounds HT28 to HT33, one or more selected from Compounds CP1 to CP6, β-NPB, or any combination thereof:

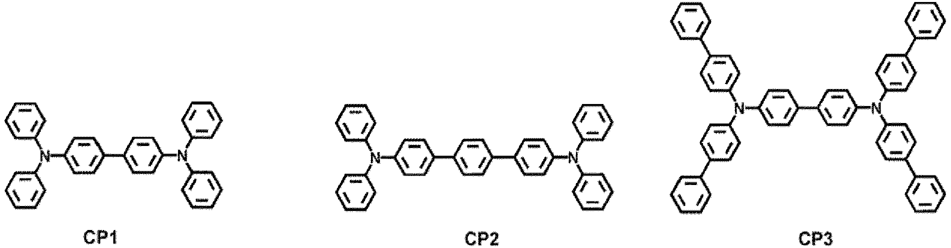

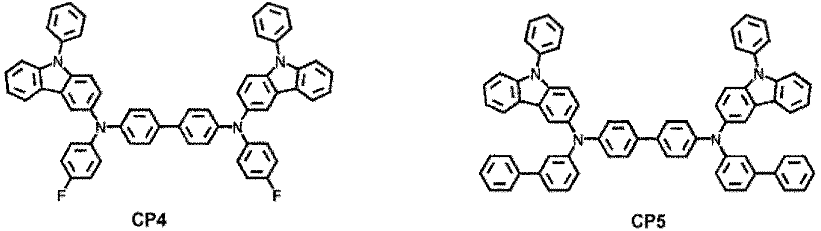

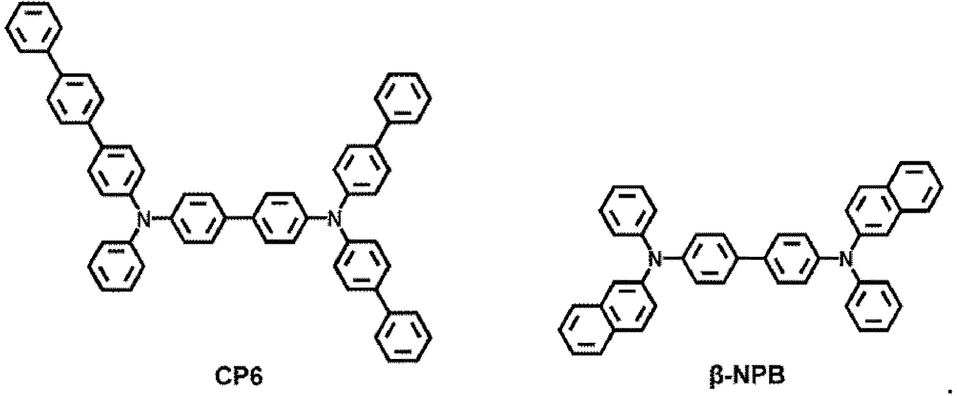

### [Film]

The organometallic compound represented by Formula 1 may be included in one or more suitable films. According to one or more embodiments of the present disclosure, a film including an organometallic compound represented by Formula 1 may be provided. The film may be, for example, an optical member (or a light control element) (for example, a color filter, a color conversion member, a capping layer, a light extraction efficiency enhancement layer, a selective light absorbing layer, a polarizing layer, a quantum dot-containing layer, or like), a light blocking member (for example, a light reflective layer, a light absorbing layer, or the like), or a protective member (for example, an insulating layer, a dielectric layer, and/or the like).

### [Electronic apparatus]

The light-emitting device may be included in one or more suitable electronic apparatuses. For example, the electronic apparatus including the light-emitting device may be a light-emitting apparatus, an authentication apparatus, and/or the like.

In one or more embodiments, the electronic apparatus (for example, a light-emitting apparatus) may further include, in addition to the light-emitting device, i) a color filter, ii) a color conversion layer, or iii) a color filter and a color conversion layer. The color filter and/or the color conversion layer may be located in at least one direction in which light emitted from the light-emitting device travels. For example, in one or more embodiments, the light emitted from the light-emitting device may be blue light or white light. For details on the light-emitting device, related description provided above may be referred to. In one or more embodiments, the color conversion layer may include a quantum dot. The quantum dot may be, for example, a quantum dot as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be located among the subpixel areas to define each of the subpixel areas.

The color filter may further include a plurality of color filter areas and light-shielding patterns located among the color filter areas, and the color conversion layer may further include a plurality of color conversion areas and light-shielding patterns located among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths from one another. For example, in some embodiments, the first color light may be red light, the second color light may be green light, and the third color light may be blue light. For example, in one or more embodiments, the plurality of color filter areas (or the plurality of color conversion areas) may include quantum dots. In some embodiments, the first area may include a red quantum dot emitting red light, the second area may include a green quantum dot emitting green light, and the third area may not include (e.g., may exclude) a quantum dot. For details on the quantum dot, related descriptions provided herein may be referred to. The first area, the second area, and/or the third area may each include a scatterer.

For example, in one or more embodiments, the light-emitting device may be to emit first light, the first area may be to absorb the first light to emit first-first color light, the second area may be to absorb the first light to emit second-first color light, and the third area may be to absorb the first light to emit third-first color light. In this regard, the first-first color light, the second-first color light, and the third-first color light may have different maximum emission wavelengths. In some embodiments, the first light may be blue light, the first-first color light may be red light, the second-first color light may be green light, and the third-first color light may be blue light.

In one or more embodiments, the electronic apparatus may further include a thin-film transistor, in addition to the light-emitting device as described above. The thin-film transistor may include a source electrode, a drain electrode, and an activation layer, wherein any one selected from the source electrode and the drain electrode may be electrically connected to any one selected from the first electrode and the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be located between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic apparatus may be flexible.

Various functional layers may be additionally located on the sealing portion, in addition to the color filter and/or the color conversion layer, according to the utilization of the electronic apparatus. The functional layers may include a touch screen layer, a polarizing layer, and/or the like. The touch screen layer may be a pressure-sensitive touch screen layer, a capacitive touch screen layer, or an infrared touch screen layer.

The authentication apparatus may further include, in addition to the light-emitting device as described above, a biometric information collector. The authentication apparatus may be, for example, a biometric authentication apparatus that authenticates an individual by utilizing biometric information of a living body (for example, fingertips, pupils, etc.).

The electronic apparatus may be applied to one or more suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

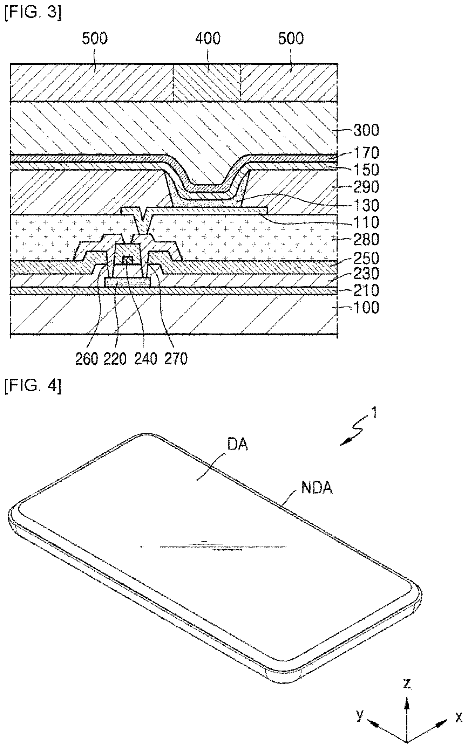

### [Description of FIGs. 2 and 3]

FIG. 2 is a cross-sectional view showing a light-emitting apparatus according to one or more embodiments of the present disclosure.

The light-emitting apparatus of FIG. 2 may include a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be located on the substrate 100. The buffer layer 210 may prevent or reduce penetration of impurities through the substrate 100 and may provide a flat surface on the substrate 100.

A TFT may be located on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region, and a channel region.

A gate insulating film 230 for insulating the activation layer 220 from the gate electrode 240 may be located on the activation layer 220, and the gate electrode 240 may be located on the gate insulating film 230.

An interlayer insulating film 250 may be located on the gate electrode 240. The interlayer insulating film 250 may be located between the gate electrode 240 and the source electrode 260 and between the gate electrode 240 and the drain electrode 270, to insulate from one another.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be located in contact with the exposed portions of the source region and the drain region of the activation layer 220, respectively.

The TFT may be electrically connected to a light-emitting device to drive the light-emitting device, and may be covered and protected by a passivation layer 280. The passivation layer 280 may include an inorganic insulating film, an organic insulating film, or any combination thereof. The light-emitting device may be provided on the passivation layer 280. The light-emitting device may include a first electrode 110, an interlayer 130, and a second electrode 150.

The first electrode 110 may be located on the passivation layer 280. The passivation layer 280 may be located to expose a portion of the drain electrode 270, not fully covering the drain electrode 270, and the first electrode 110 may be located to be connected to the exposed portion of the drain electrode 270.

A pixel defining layer 290 including an insulating material may be located on the first electrode 110. The pixel defining layer 290 may expose a certain region of the first electrode 110, and the interlayer 130 may be formed in the exposed region of the first electrode 110. The pixel defining layer 290 may be a polyimide or polyacrylic organic film. In some embodiments, at least some layers of the interlayer 130 may extend beyond the upper portion of the pixel defining layer 290 to be located in the form of a common layer.

The second electrode 150 may be located on the interlayer 130, and a capping layer 170 may be additionally formed on the second electrode 150. The capping layer 170 may be formed to cover the second electrode 150.

The encapsulation portion 300 may be located on the capping layer 170. The encapsulation portion 300 may be located on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or any combination thereof; or any combination of the inorganic films and the organic films.

FIG. 3 shows a cross-sectional view showing a light-emitting apparatus according to one or more embodiments of the present disclosure.

The light-emitting apparatus of FIG. 3 is substantially the same as the light-emitting apparatus of FIG. 2, except that a light-shielding pattern 500 and a functional region 400 are additionally located on the encapsulation portion 300. The functional region 400 may be i) a color filter area, ii) a color conversion area, or iii) a combination of the color filter area and the color conversion area. In some embodiments, the light-emitting device included in the light-emitting apparatus of FIG. 3 may be a tandem light-emitting device.

### [Description of FIG. 4]

FIG. 4 is a schematic perspective view of an electronic device 1 including a light-emitting device according to one or more embodiments. The electronic device 1 may be, as an apparatus that displays a moving image or still image, a portable electronic device, such as a mobile phone, a smart phone, a tablet personal computer (PC), a mobile communication terminal, an electronic notebook, an electronic book, a portable multimedia player (PMP), a navigation, or a ultra mobile PC (UMPC) as well as one or more suitable products, such as a television, a laptop, a monitor, a billboard, or an Internet of things (IOT). In some embodiments, the electronic device 1 may be such a product above or a part thereof. In some embodiments, the electronic device 1 may be a wearable device, such as a smart watch, a watch phone, a glasses-type or kind display, or a head mounted display (HMD), or a part of the wearable device. However, embodiments of the present disclosure are not limited thereto. For example, the electronic device 1 may include a dashboard of a vehicle, a center fascia of a vehicle, a center information display arranged on a dashboard of a vehicle, a room mirror display replacing a side mirror of a vehicle, an entertainment display for the rear seat of a vehicle, or a display arranged on the back of the front seat, or a head up display (HUD) installed in the front of a vehicle or projected on a front window glass, or a computer-generated hologram augmented-reality head up display (CGH AR HUD). FIG. 4 illustrates an embodiment in which the electronic device 1 is a smartphone for convenience of explanation.

The electronic device 1 may include a display area DA and a non-display area NDA outside the display area DA. A display device of the electronic device 1 may implement an image through an array of a plurality of pixels that are two-dimensionally arranged in the display area DA.

The non-display area NDA is an area that does not display an image, and may entirely surround the display area DA. On the non-display area NDA, a driver for providing electrical signals or power to display devices arranged on the display area DA may be arranged. On the non-display area NDA, a pad, which is an area to which an electronic element or a printing circuit board may be electrically connected, may be arranged.

In the electronic device 1, a length in the x-axis direction and a length in the y-axis direction may be different from each other. For example, as shown in FIG. 4 , the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

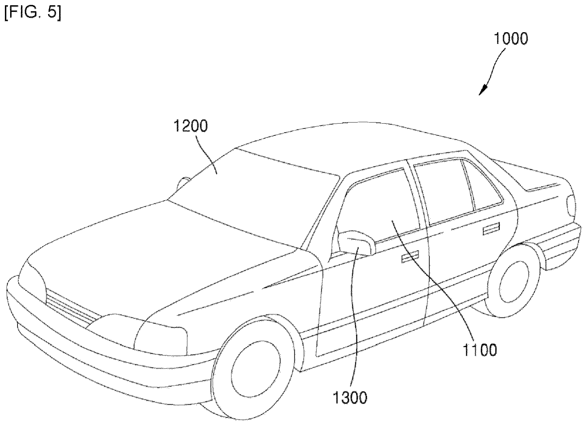

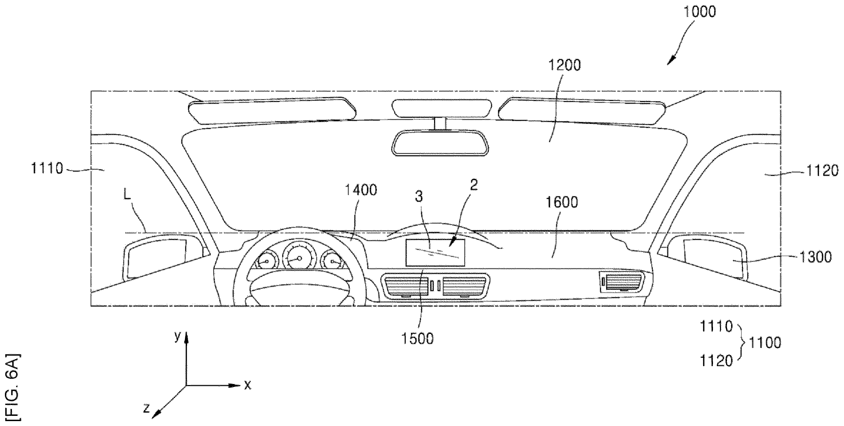

### [Description of FIGs. 5 and 6A to 6C]

FIG. 5 is a schematic view illustrating an exterior of a vehicle 1000 as an electronic device including a light-emitting device according to one or more embodiments of the present disclosure. FIGs. 6A to 6C are each a schematic view illustrating an interior of a vehicle 1000 according to one or more embodiments of the present disclosure.

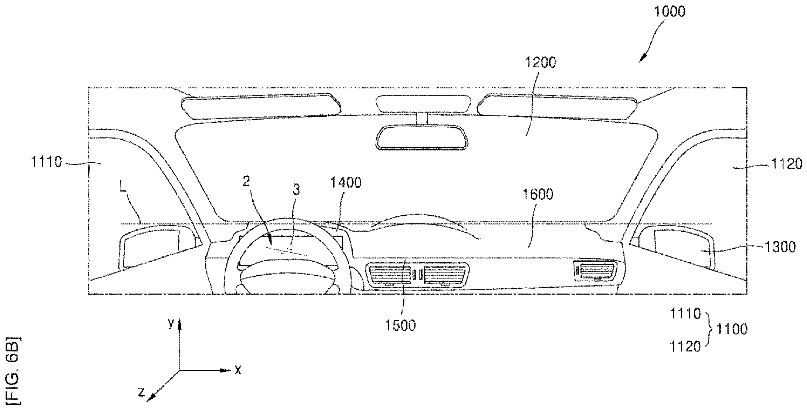

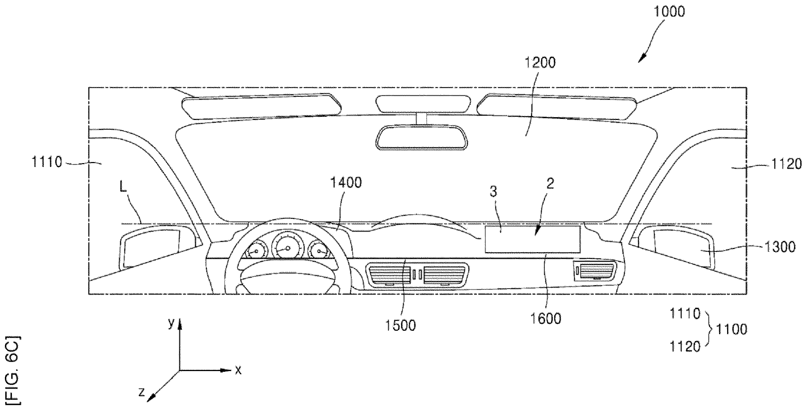

Referring to FIGs. 5, 6A, 6B, and 6C, the vehicle 1000 may refer to one or more suitable apparatuses for moving an object to be transported, such as a human, an object, or an animal, from a departure point to a destination. The vehicle 1000 may include a vehicle traveling on a road or a track, a vessel moving over a sea or a river, an airplane flying in the sky utilizing the action of air, and/or the like.

In one or more embodiments, the vehicle 1000 may travel on a road or a track. The vehicle 1000 may move in a set or predetermined direction according to the rotation of at least one wheel. For example, the vehicle 1000 may include a three-wheeled or four-wheeled vehicle, a construction machine, a two-wheeled vehicle, a prime mover device, a bicycle, or a train running on a track.

The vehicle 1000 may include a body having an interior and an exterior, and a chassis in which mechanical apparatuses necessary for driving are installed as other parts except for the body. The exterior of the vehicle body may include a front panel, a bonnet, a roof panel, a rear panel, a trunk, a filler provided at a boundary between doors, and/or the like. The chassis of the vehicle 1000 may include a power generating device, a power transmitting device, a driving device, a steering device, a braking device, a suspension device, a transmission device, a fuel device, front and rear wheels, left and right wheels, and/or the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a filler arranged between the side window glass 1100 and the front window glass 1200.

The side window glass 1100 may be installed on the side of the vehicle 1000. In one or more embodiments, the side window glass 1100 may be installed on a door of the vehicle 1000. A plurality of side window glasses 1100 may be provided and may face each other. In one or more embodiments, the side window glass 1100 may include a first side window glass 1110 and a second side window glass 1120. In one or more embodiments, the first side window glass 1110 may be arranged adjacent to the cluster 1400. The second side window glass 1120 may be arranged adjacent to the passenger seat dashboard 1600.

In one or more embodiments, the side window glasses 1100 may be spaced apart from each other in the x-direction or the -x-direction. For example, the first side window glass 1110 and the second side window glass 1120 may be spaced apart from each other in the x direction or the -x direction. In other words, an imaginary straight line L connecting the side window glasses 1100 may extend in the x-direction or the -x-direction. For example, an imaginary straight line L connecting the first side window glass 1110 and the second side window glass 1120 to each other may extend in the x direction or the -x direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In one embodiment, a plurality of side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may include a tachometer, a speedometer, a coolant thermometer, a fuel gauge, a turn signal indicator, a high beam indicator, a warning light, a seat belt warning light, an odometer, a driving record system, an automatic transmission selection lever indicator, a door open warning light, an engine oil warning light, and/or a low fuel warning light.

The center fascia 1500 may include a control panel on which a plurality of buttons for adjusting an audio device, an air conditioning device, and/or a heater of a seat are disposed. The center fascia 1500 may be arranged on one side of the cluster 1400.

A passenger seat dashboard 1600 may be spaced apart from the cluster 1400 with the center fascia 1500 arranged therebetween. In one or more embodiments, the cluster 1400 may be arranged to correspond to a driver seat, and the passenger seat dashboard 1600 may be disposed to correspond to a passenger seat. In one or more embodiments, the cluster 1400 may be adjacent to the first side window glass 1110, and the passenger seat dashboard 1600 may be adjacent to the second side window glass 1120.

In one or more embodiments, the display device 2 may include a display panel 3, and the display panel 3 may display an image. The display device 2 may be arranged inside the vehicle 1000. In some embodiments, the display device 2 may be arranged between the side window glasses 1100 facing each other. The display device 2 may be arranged on at least one selected from among the cluster 1400, the center fascia 1500, and the passenger seat dashboard 1600.

The display device 2 may include an organic light-emitting display device, an inorganic electroluminescent (EL) display device, a quantum dot display device, and/or the like. Hereinafter, as the display device 2 according to one or more embodiments, an organic light-emitting display device display including the light-emitting device according to the present disclosure will be described as an example, but one or more suitable types (kinds) of display devices as described above may be utilized in embodiments of the present disclosure.

Referring to FIG. 6A, the display device 2 may be arranged on the center fascia 1500. In one embodiment, the display device 2 may display navigation information. In another embodiment, the display device 2 may display audio, video, or information regarding vehicle settings.

Referring to FIG. 6B, the display device 2 may be arranged on the cluster 1400. When the display device 2 is arranged on the cluster 1400, the cluster 1400 may display driving information and/or the like through the display device 2. For example, in some embodiments, the cluster 1400 may be implemented digitally. The digital cluster 1400 may display vehicle information and driving information as images. For example, a needle and a gauge of a tachometer and/or one or more suitable warning light icons may be displayed by a digital signal.

Referring to FIG. 6C, the display device 2 may be arranged on the dashboard 1600 of the passenger seat. The display device 2 may be embedded in the passenger seat dashboard 1600 or arranged on the passenger seat dashboard 1600. In some embodiments, the display device 2 arranged on the dashboard 1600 for the passenger seat may display an image related to information displayed on the cluster 1400 and/or information displayed on the center fascia 1500. In one or more embodiments, the display device 2 arranged on the passenger seat dashboard 1600 may display information different from information displayed on the cluster 1400 and/or information displayed on the center fascia 1500.

### [Manufacturing method]

Respective layers included in the hole transport region, the emission layer, and respective layers included in the electron transport region may be formed in a certain region by utilizing one or more suitable methods selected from vacuum deposition, spin coating, casting, Langmuir-Blodgett (LB) deposition, ink-jet printing, laser-printing, and laser-induced thermal imaging.

When layers constituting the hole transport region, the emission layer, and layers constituting the electron transport region are formed by vacuum deposition, the deposition may be performed at a deposition temperature of about 100 °C to about 500 °C, a vacuum degree of about 1,33322 * 10⁻⁶ Pa (10⁻⁸ torr) to about 133,322 mPa (10⁻³ torr), and a deposition speed of about 0,001 nm/s (0.01 Å/sec) to about 10nm/s (100 Å/sec), depending on a material to be included in a layer to be formed and the structure of a layer to be formed.

### [Definition of terms]

The term "C₃-C₆₀ carbocyclic group" as utilized herein may refer to a cyclic group consisting of carbon only as a ring-forming atom and having three to sixty carbon atoms, and the term "C₁-C₆₀ heterocyclic group" as utilized herein may refer to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the C₁-C₆₀ heterocyclic group has 3 to 61 ring-forming atoms.

The "cyclic group" as utilized herein may include the C₃-C₆₀ carbocyclic group, and the C₁-C₆₀ heterocyclic group.

The term "π electron-rich C₃-C₆₀ cyclic group" as utilized herein may refer to a cyclic group that has three to sixty carbon atoms and does not include *-N=*' as a ring-forming moiety, and the term "π electron-deficient nitrogen-containing C₁-C₆₀ cyclic group" as utilized herein may refer to a heterocyclic group that has one to sixty carbon atoms and includes *-N=*' as a ring-forming moiety.

For example,
the C₃-C₆₀ carbocyclic group may be i) a group T1 or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) a group T2, ii) a condensed cyclic group in which two or more groups T2 are condensed with each other, or iii) a condensed cyclic group in which at least one group T2 and at least one group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) a group T1, ii) a condensed cyclic group in which two or more groups T1 are condensed with each other, iii) a group T3, iv) a condensed cyclic group in which two or more groups T3 are condensed with each other, or v) a condensed cyclic group in which at least one group T3 and at least one group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ cyclic group may be i) a group T4, ii) a condensed cyclic group in which two or more groups T4 are condensed with each other, iii) a condensed cyclic group in which at least one group T4 and at least one group T1 are condensed with each other, iv) a condensed cyclic group in which at least one group T4 and at least one group T3 are condensed with each other, or v) a condensed cyclic group in which at least one group T4, at least one group T1, and at least one group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
the group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the group T3 may be a furan group, a thiophene group, a 1H-pyrrole group, a silole group, or a borole group, and
the group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ cyclic group" as utilized herein may refer to a group condensed to any cyclic group, a monovalent group, or a polyvalent group (for example, a divalent group, a trivalent group, a tetravalent group, etc.) according to the structure of a formula for which the corresponding term is utilized. For example, the "benzene group" may be a benzo group, a phenyl group, a phenylene group, and/or the like, which may be easily understood by one of ordinary skill in the art according to the structure of a formula including the "benzene group."

In one or more embodiments, non-limiting examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group, and non-limiting examples of the divalent C₃-C₆₀ carbocyclic group and the monovalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a divalent non-aromatic condensed heteropolycyclic group.

The term "C₁-C₆₀ alkyl group" as utilized herein may refer to a linear or branched aliphatic hydrocarbon monovalent group that has one to sixty carbon atoms, and non-limiting examples thereof may be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as utilized herein refers to a divalent group having the same structure as the C₁-C₆₀ alkyl group.

The term "C₂-C₆₀ alkenyl group" as utilized herein may refer to a monovalent hydrocarbon group having at least one carbon-carbon double bond in the middle or at the terminus of the C₂-C₆₀ alkyl group, and non-limiting examples thereof may be an ethenyl group, a propenyl group, and a butenyl group. The term "C₂-C₆₀ alkenylene group" as utilized herein may refer to a divalent group having the same structure as the C₂-C₆₀ alkenyl group.

The term "C₂-C₆₀ alkynyl group" as utilized herein may refer to a monovalent hydrocarbon group having at least one carbon-carbon triple bond in the middle or at the terminus of the C₂-C₆₀ alkyl group, and non-limiting examples thereof may include an ethynyl group, a propynyl group, and/or the like. The term "C₂-C₆₀ alkynylene group" as utilized herein may refer to a divalent group having the same structure as the C₂-C₆₀ alkynyl group.

The term "C₁-C₆₀ alkoxy group" as utilized herein may refer to a monovalent group represented by -OA₁₀₁ (wherein A₁₀₁ may be a C₁-C₆₀ alkyl group), and non-limiting examples thereof may include a methoxy group, an ethoxy group, and an isopropyloxy group.

The term "C₃-C₁₀ cycloalkyl group" as utilized herein may refer to a monovalent saturated hydrocarbon cyclic group having 3 to 10 carbon atoms, and non-limiting examples thereof may be a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group" as utilized herein may refer to a divalent group having the same structure as the C₃-C₁₀ cycloalkyl group.

The term "C₁-C₁₀ heterocycloalkyl group" as utilized herein may refer to a monovalent cyclic group of 1 to 10 carbon atoms, further including, in addition to carbon atoms, at least one heteroatom, as ring-forming atoms, and non-limiting examples thereof may be a 1,2,3,4-oxatriazolidinyl group, a tetrahydrofuranyl group, and a tetrahydrothiophenyl group. The term "C₁-C₁₀ heterocycloalkylene group" as utilized herein may refer to a divalent group having the same structure as the C₁-C₁₀ heterocycloalkyl group.

The term C₃-C₁₀ cycloalkenyl group utilized herein may refer to a monovalent cyclic group that has three to ten carbon atoms and at least one carbon-carbon double bond in the ring thereof and no aromaticity, and non-limiting examples thereof may be a cyclopentenyl group, a cyclohexenyl group, and a cycloheptenyl group. The term "C₃-C₁₀ cycloalkenylene group" as utilized herein refers to a divalent group having the same structure as the C₃-C₁₀ cycloalkenyl group.

The term "C₁-C₁₀ heterocycloalkenyl group" as utilized herein may refer to a monovalent cyclic group of 1 to 10 carbon atoms, further including, in addition to carbon atoms, at least one heteroatom, as ring-forming atoms, and having at least one carbon-carbon double bond in the cyclic structure thereof. Non-limiting examples of the C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as utilized herein may refer to a divalent group having the same structure as the C₁-C₁₀ heterocycloalkenyl group.

The term "C₆-C₆₀ aryl group" as utilized herein may refer to a monovalent group having a carbocyclic aromatic system of 6 to 60 carbon atoms, and the term "C₆-C₆₀ arylene group" as utilized herein may refer to a divalent group having a carbocyclic aromatic system of 6 to 60 carbon atoms. Non-limiting examples of the C₆-C₆₀ aryl group may be a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the rings may be condensed with each other.

The term "C₁-C₆₀ heteroaryl group" as utilized herein may refer to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as utilized herein may refer to a divalent group having a heterocyclic aromatic system of 1 to 60 carbon atoms, further including, in addition to carbon atoms, at least one heteroatom, as ring-forming atoms. Non-limiting examples of the C₁-C₆₀ heteroaryl group may be a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed with each other.

The term "monovalent non-aromatic condensed polycyclic group" as utilized herein may refer to a monovalent group (for example, having 8 to 60 carbon atoms) having two or more rings condensed to each other, only carbon atoms as ring-forming atoms, and no aromaticity in its entire molecular structure as a whole. Non-limiting examples of the monovalent non-aromatic condensed polycyclic group may be an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as utilized herein may refer to a divalent group having the same structure as the monovalent non-aromatic condensed polycyclic group described above.

The term "monovalent non-aromatic condensed heteropolycyclic group" as utilized herein may refer to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure as a whole. Non-limiting examples of the monovalent non-aromatic condensed heteropolycyclic group may include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as utilized herein may refer to a divalent group having the same structure as the monovalent non-aromatic condensed heteropolycyclic group described above.

The term "C₆-C₆₀ aryloxy group" as utilized herein may refer to -OA₁₀₂ (wherein A₁₀₂ may be a C₆-C₆₀ aryl group), and the term "C₆-C₆₀ arylthio group" as utilized herein may refer to -SA₁₀₃ (wherein A₁₀₃ may be a C₆-C₆₀ aryl group).

The term "C₇-C₆₀ arylalkyl group" utilized herein may refer to -A₁₀₄A₁₀₅ (where A₁₀₄ may be a C₁-C₅₄ alkylene group, and A₁₀₅ may be a C₆-C₅₉ aryl group), and the term C₂-C₆₀ heteroarylalkyl group" utilized herein may refer to -A₁₀₆A₁₀₇ (where A₁₀₆ may be a C₁-C₅₉ alkylene group, and A₁₀₇ may be a C₁-C₅₉ heteroaryl group).

The term "R₁₀ₐ" as utilized herein may refer to:
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃ and Q₃₁ to Q₃₃ utilized herein may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ arylalkyl group; or a C₂-C₆₀ heteroarylalkyl group.

The term "heteroatom" as utilized herein may refer to any atom other than a carbon atom. Non-limiting examples of the heteroatom may be O, S, N, P, Si, B, Ge, Se, and any combinations thereof.

The term "third-row transition metal" utilized herein may include hafnium (Hf), tantalum (Ta), tungsten (W), rhenium (Re), osmium (Os), iridium (Ir), platinum (Pt), gold (Au), and/or the like.

"Ph" as utilized herein may refer to a phenyl group, "Me" as utilized herein may refer to a methyl group, "Et" as utilized herein may refer to an ethyl group, "tert-Bu" or "Bu^{t}" as utilized herein may refer to a tert-butyl group, and "OMe" as utilized herein may refer to a methoxy group.

The term "biphenyl group" as utilized herein may refer to "a phenyl group substituted with a phenyl group." In other words, the "biphenyl group" is a substituted phenyl group having a C₆-C₆₀ aryl group as a substituent.

The term "terphenyl group" as utilized herein may refer to "a phenyl group substituted with a biphenyl group". In other words, the "terphenyl group" is a substituted phenyl group having, as a substituent, a C₆-C₆₀ aryl group substituted with a C₆-C₆₀ aryl group.

In the present disclosure, the x-axis, y-axis, and z-axis are not limited to three axes in an orthogonal coordinate system, and may be interpreted in a broad sense including these axes. For example, the x-axis, y-axis, and z-axis may refer to those orthogonal to each other, or may refer to those in different directions that are not orthogonal to each other.

* and *' as utilized herein, unless defined otherwise, each refer to a binding site to a neighboring atom in a corresponding formula or moiety.

Hereinafter, compounds according to one or more embodiments of the present disclosure and light-emitting devices according to one or more embodiments of the present disclosure will be described in more detail with reference to the following synthesis examples and examples. The wording "B was utilized instead of A" utilized in describing Synthesis Examples may refer to that an identical molar equivalent of B was utilized in place of A.

### [Examples]

### Synthesis Example 1: Synthesis of Compound D11

### 1. Synthesis of Intermediate Compound 11-3

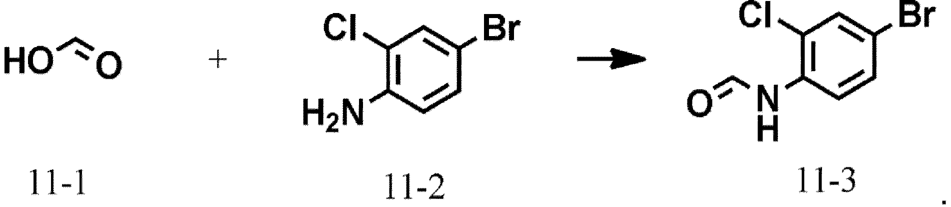

Polyethylene glycol (PEG-400, 2 g) was added to a mixture of Compound 11-1 (3 mmol) and Compound 11-2 (1 mmol), and then was mixed at room temperature. Meanwhile, the reaction was monitored through thin layer chromatography (TLC). After the reaction was completed, the mixture was diluted in 10 mL of distilled water, and was subjected to an extraction process three times with 10 mL of ethyl acetate (EtOAc). An organic material was dried with inorganic Na₂SO₄ and was concentrated. The obtained solid was purified by utilizing column chromatography to obtain Intermediate Compound 11-3 (yield of 79 %).

### 2. Synthesis of Intermediate Compound 11-5

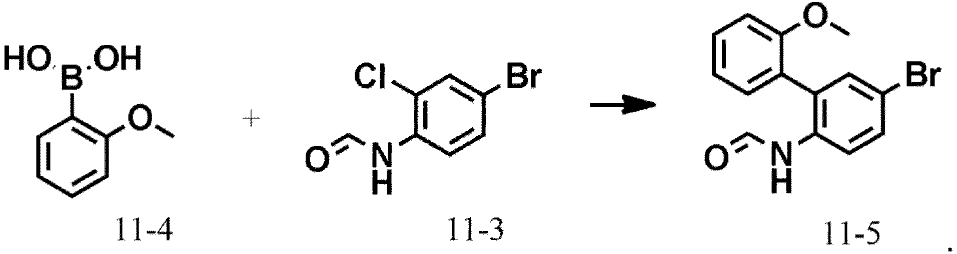

Intermediate Compound 11-3 (1.0 mmol), Pd(OAc)₂ (0.02 mmol), 2-dicyclohexylphosphino-2',6'-dimethoxy-1,1'-biphenyl (S-Phos, 0.04 mmol), Compound 11-4 (1.5 mmol), and inorganic K₃PO₄ (2.0 mmol) were put into a 14 mL reaction tube, and the reaction tube was slightly shaken to mix the solid mixture therein well. The sealed tube was subjected to three times of vacuum processing and filling with Ar gas. Toluene (1.5 mL) was added utilizing a syringe, and the mixture was heated at 90 °C in an oil bath. To promote the reaction, the tube may be shaken or subjected to sonification. After the reaction was completed, the reaction product was filtered through Celite, and the Celite bed was washed three times with EtOAc (5 mL). The filtered liquid was diluted with EtOAc (10 mL) and washed four times with NaOH (aq. 1N, 10 mL) solution to remove excess Compound 11-4. The reaction product was dried with inorganic Na₂SO₄, concentrated, and purified and separated by column chromatography to obtain Intermediate Compound 11-5 (yield of 95 %).

### 3. Synthesis of Intermediate Compound 11-6

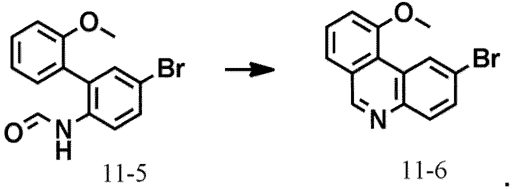

Intermediate Compound 11-5 (10 mmol) and POCl₃ (40 mmol) were refluxed for 2 hours, and a solvent was eliminated in a vacuum environment. NaOH (aq, 2M) solution was added so that the obtained material became basic with a pH of 10 or more, and was subjected to an extraction process three times with CH₂Cl₂ (20 mL). The extracted organic layer was washed two times with brine (20 mL), dried with inorganic MgSO₄, and purified and separated by silica gel flash chromatography utilizing ethyl acetate/petroleum ether as an eluent to obtain Intermediate Compound 11-6.

### 4. Synthesis of Intermediate Compound 11-8

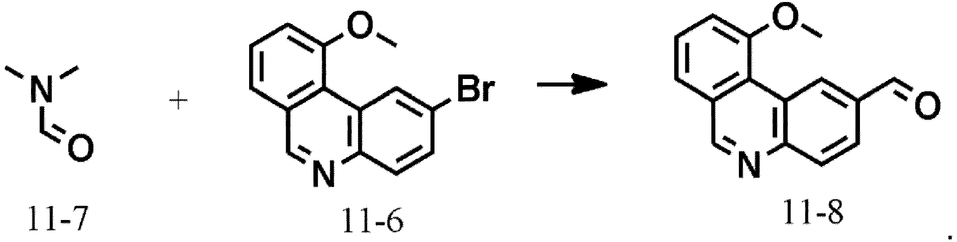

Tetrahydrofuran (THF) (12 mL) and n-BuLi (2.5 M in Hexane) solution (0.49 mL, 1.22 mmol) were added to a 100 mL two-neck flask, and then mixed at -78 °C under nitrogen gas. A mixed solution containing Intermediate Compound 11-6 (1 mmol) and THF solvent was slowly added to the flask by utilizing a syringe. After the mixture was stirred at -78 °C for about 30 minutes, Compound 11-7 (1.39 mmol) was added to the mixture by utilizing a syringe, and then the mixture was stirred at -78 °C for about 3 hours. The mixture was treated with distilled water (5 mL), subjected to an extraction process three times with EtOAc (15 mL), and washed two times with brine (20 mL) to collect an organic layer. Subsequently, the collected organic layer was dried with Na₂SO₄, and concentrated with Rotavapor. The obtained solid was purified by flash column chromatography through silica gel to obtain Intermediate Compound 11-8 (yield of 31%).

### 5. Synthesis of Intermediate Compound 11-10

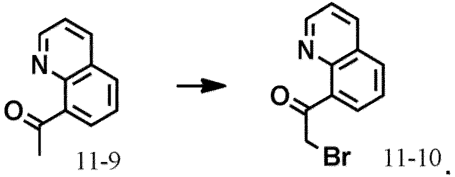

Intermediate Compound 11-9 (5 mmol), HBr (5.5 mmol, 40 % aq.), and 2-methylpyridinium nitrate (5.5 mmol) were put in a reaction flask equipped with a condenser and O₂ balloon and stirred at 60 °C for 8 hours. The reaction process was monitored with TLC and gas chromatography. After the reaction was completed, 10 mL of NaHSOs (aq.) saturated solution was added thereto, and the mixture was subjected to an extraction process three times with ethyl acetate (20 mL). The extracted organic layer was washed with distilled water, dried with Na₂SO₄, and then concentrated. The obtained material was purified and separated by column chromatography utilizing silica gel utilizing CH₂Cl₂ and hexane as a development solvent to thereby obtain Intermediate Compound 11-10 (yield of 78 %).

### 6. Synthesis of Intermediate Compound 11-12

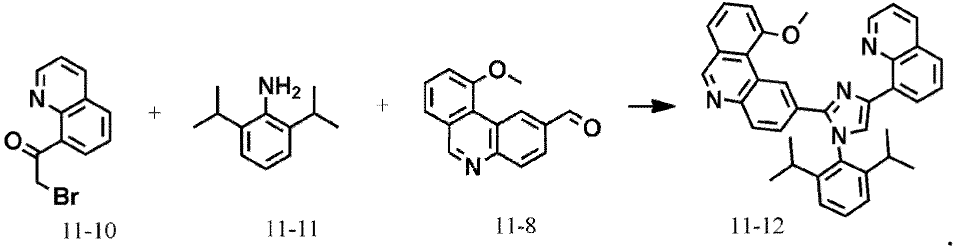

Intermediate Compound 11-10 (2 mmol), Compound 11-11 (2 mmol), Intermediate Compound 11-8 (2 mmol), and ammonium acetate (3 mmol) were mixed and then stirred at 130 °C for 2 hours. Then, the mixture was cooled to room temperature, was subjected to an extraction process through dilution with acetone-H₂O (Volume ratio 1:1), and recrystallized from n-hexane-EtOAc (Volume ratio 1:1) to obtain Intermediate Compound 11-12 (yield of 92 %).

### 7. Synthesis of Intermediate Compound 11-13

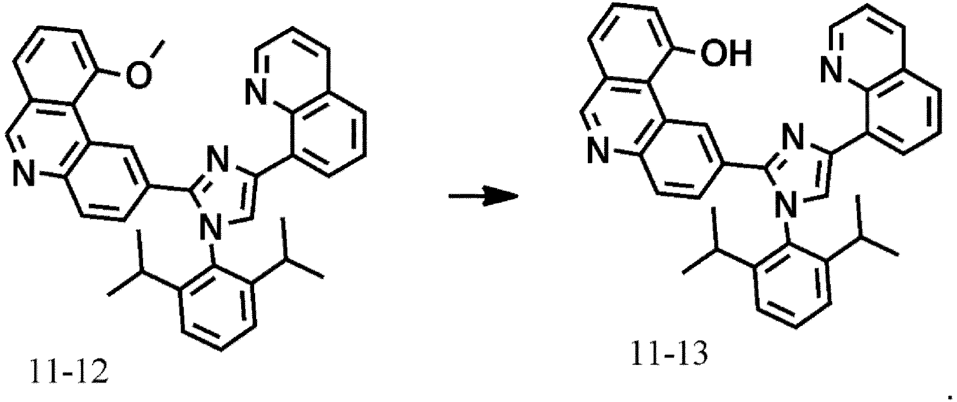

Intermediate Compound 11-13 (5.7 mmol) and pyridine hydrochloride (34 mmol) were heated at 200 °C for 6 hours. After adding water thereto, the mixture was subjected to an extraction process utilizing ethyl acetate, dried with Na₂SO₄, and then purified and separated by column chromatography utilizing silica gel utilizing CH₂Cl₂ and hexane as a development solvent to thereby obtain Intermediate Compound 11-13 (yield of 58 %).

### 8. Synthesis of Compound D11

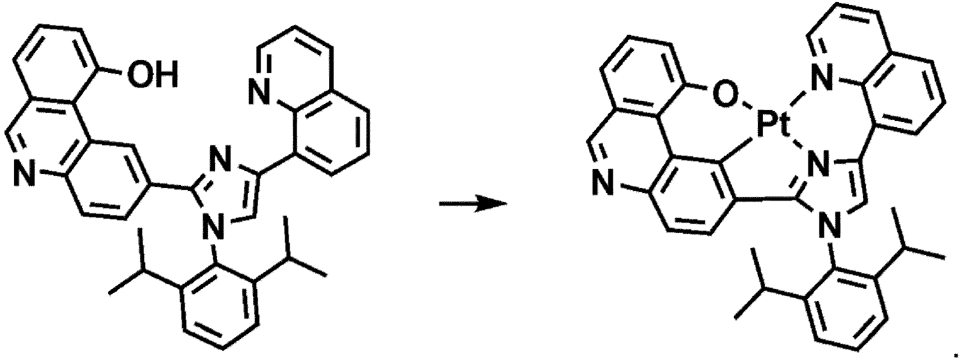

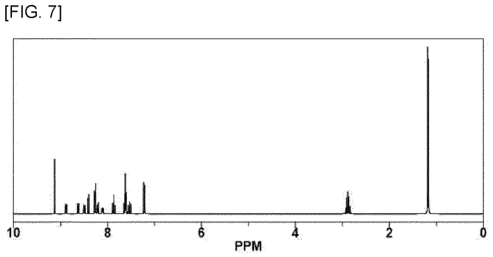

Acetic acid (30 mL), Intermediate Compound 11-13 (2.50 mmol), and Pt salt (2.8 mmol) were added to a 250 mL round-bottom flask, degassed with nitrogen for 30 minutes, and then heated at 130 °C in an oil bath until Intermediate Compound 11-13 was completely reacted (for about 4 days). After a cooling process was performed thereon, the mixture was mixed with heptane, and the mixed solution was stirred and filtered. The obtained solid was purified by silica gel column chromatography utilizing a mixed solvent including dichloromethane (DCM) and ethyl acetate (2 % of ethyl acetate in DCM) to thereby obtain Compound D11 (yield of 42 %). The obtained compound was confirmed to be Compound D11 through NMR and liquid chromatography-mass spectroscopy (LC-MS) and ¹H NMR of Compound D11 is shown in FIG. 7. (LS-MS: (Found) Exact Mass: 725.21,(Calc) Molecular Weight: 725.76)

Methods of synthesizing compounds other than the compounds synthesized in Synthesis Example 1 may be easily understood to those skilled in the art by referring to the synthesis pathways and raw materials described above.

### Example 1

As an anode, a 15 Ω/cm² (120 nm (1.200 Å)) ITO glass substrate available from Corning Inc. was cut to a size of 50 mm × 50 mm × 0.7 mm, sonicated utilizing isopropyl alcohol and pure water for 5 minutes each, and then cleaned by irradiation of ultraviolet rays and exposure of ozone thereto for 30 minutes. Then, the resultant glass substrate was loaded onto a vacuum deposition apparatus.

2-TNATA was vacuum-deposited on the ITO anode formed on the glass substrate to form a hole injection layer having a thickness of 60nm (600 Å), and then, 4,4'-bis[N-(1-naphthyl)-N-phenylamino]biphenyl (NPB) was vacuum-deposited on the hole injection layer to form a hole transport layer having a thickness of 30 nm (300 Å).

Compound H41 as a host and Compound D01 as a dopant (weight ratio of 90:10) were co-deposited on the hole transport layer to form an emission layer having a thickness of 45 nm (450 Å).

Diphenyl(4-(triphenylsilyl)phenyl)-phosphine oxide (TSPO1) was vacuum-deposited on the emission layer to form a hole blocking layer having a thickness of 5 nm (50 Å). Then, Compound ET37 was deposited on the hole blocking layer to form an electron transport layer having a thickness of 30 nm (300 Å), Yb was deposited on the electron transport layer to form an electron injection layer having a thickness of 1 nm (10 Å), AgMg was deposited on the electron injection layer to form a cathode having a thickness of 12 nm (120 Å), and HT28 was deposited on the cathode to form a capping layer having a thickness of 60 nm (600 Å).

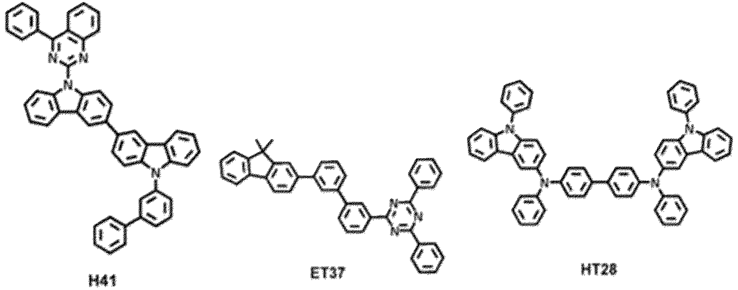

### Examples 2 to 10 and Comparative Examples 1 to 6

Organic light-emitting devices were manufactured in substantially the same manner as in Example 1, except that compounds shown in Table 2 were each utilized instead of Compound D01 as a dopant in forming an emission layer:

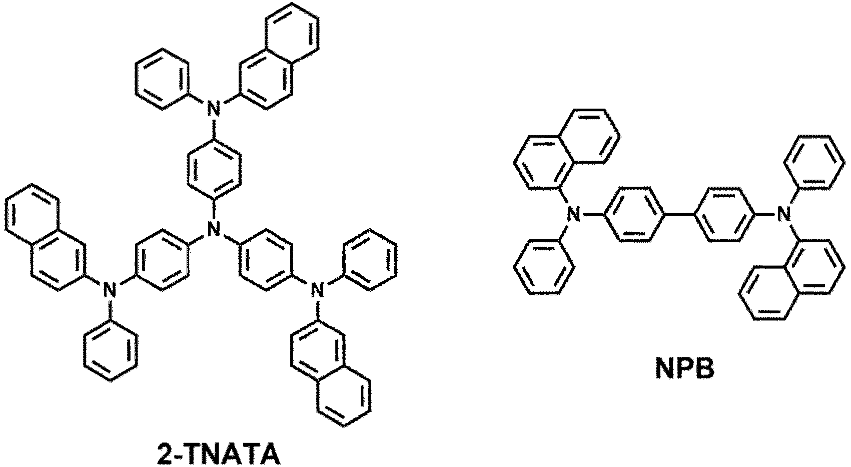

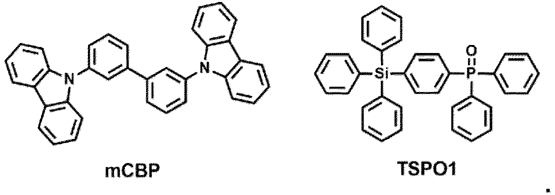

### Evaluation Example 1

To evaluate characteristics of the light-emitting devices manufactured according to Examples 1 to 12 and Comparative Examples 1 to 6, the driving voltage at a current density of 50 mA/cm², luminance, and luminescence efficiency thereof were measured. The driving voltage of the light-emitting devices was measured utilizing a source meter (Keithley Instrument Inc., 2400 series). In addition, an emission spectrum of the light-emitting device was measured utilizing a Quantaurus-QY Absolute PL quantum yield spectrometer of Hamamatsu company (on which a xenon light source, a monochromator, a photonic multichannel analyzer, and an integrating sphere are mounted and which uses a PLQY measurement software (Hamamatsu Photonics, Ltd., Shizuoka, Japan)) to thereby measure the maximum emission wavelength (λₘₐₓ), and then the color purity (CIEx and CIEy coordinates) at 400 cd/m² was measured. Table 2 shows the evaluation results of the characteristics of the light-emitting devices.

**Table 2**

| | Dopant | Maximum luminescence efficiency (cd/A) | Driving voltage (V) | λₘₐₓ (nm) | CIE x | CIE y |
|---|---|---|---|---|---|---|
| Example 1 | D01 | 28.59 | 3.13 | 595 | 0.62 | 0.38 |
| Example 2 | D02 | 28.59 | 3.13 | 633 | 0.63 | 0.31 |
| Example 3 | D03 | 31.41 | 3.1 | 632 | 0.63 | 0.31 |
| Example 4 | D09 | 33.96 | 3.05 | 621 | 0.68 | 0.32 |
| Example 5 | D11 | 46.43 | 2.9 | 627 | 0.63 | 0.31 |
| Example 6 | D13 | 28.59 | 3.13 | 600 | 0.63 | 0.37 |
| Example 7 | D14 | 28.59 | 3.13 | 638 | 0.70 | 0.30 |
| Example 8 | D15 | 31.41 | 3.1 | 638 | 0.70 | 0.30 |
| Example 9 | D21 | 38.07 | 3.0 | 626 | 0.63 | 0.31 |
| Example 10 | D23 | 46.49 | 2.9 | 626 | 0.68 | 0.32 |
| Example 11 | D25 | 28.59 | 3.13 | 638 | 0.70 | 0.30 |
| Example 12 | D26 | 25.62 | 3.2 | 626 | 0.68 | 0.32 |
| Comparative Example 1 | R01 | 12.77 | 3.47 | 541 | 0.37 | 0.61 |
| Comparative Example 2 | R02 | 12.18 | 3.5 | 517 | 0.23 | 0.63 |
| Comparative Example 3 | R03 | 18.04 | 3.36 | 642 | 0.70 | 0.30 |
| Comparative Example 4 | R04 | 25.62 | 3.2 | 537 | 0.37 | 0.62 |
| Comparative Example 5 | R05 | 19.92 | 3.3 | 517 | 0.23 | 0.63 |
| Comparative Example 6 | R06 | 33.7 | 3.05 | 557 | 0.45 | 0.54 |

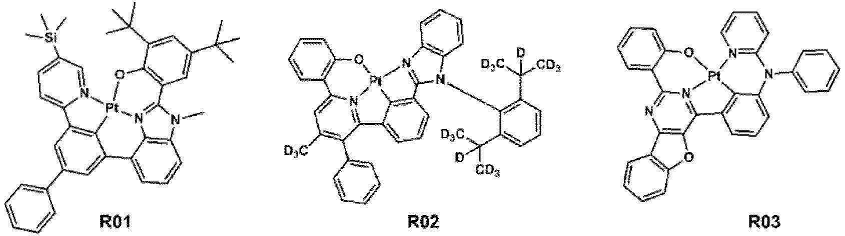

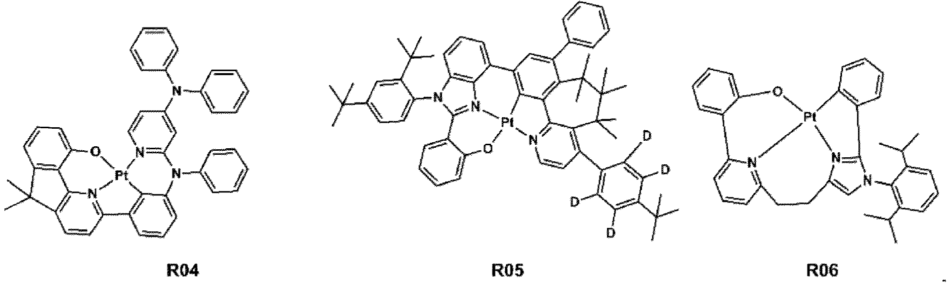

Referring to Table 2, it was confirmed that the light-emitting devices of Examples 1 to 12 had higher luminescence efficiency and the same as or lower driving voltage than those of the light-emitting devices of Comparative Examples 1 to 6. In addition, it was confirmed that the light-emitting devices of Examples 1 to 12 satisfied the maximum emission wavelength range of about 590 nm to about 670 nm.

Although the present disclosure has been described with reference to the Synthesis Examples and Examples, these examples are provided for illustrative purpose only, and one of ordinary skill in the art may understand that these examples may have one or more suitable modifications and other examples equivalent thereto. Accordingly, the scope of the present disclosure is determined by the claims.

According to one or more embodiments, an organometallic compound represented by Formula 1 may be utilized in manufacturing a light-emitting device having high efficiency and a long lifespan, and the light-emitting device may be utilized in manufacturing a high-quality electronic apparatus high efficiency and a long lifespan.

Unless otherwise defined, all terms (including technical and scientific terms) utilized herein have the same meaning as commonly understood by one of ordinary skill in the art to which this present disclosure belongs. It will be further understood that terms, such as those defined in commonly utilized dictionaries, should be interpreted as having a meaning that is consistent with their meaning in the context of the relevant art and will not be interpreted in an idealized or overly formal sense unless expressly so defined herein.

In the present disclosure, it will be understood that when an element (or region, layer, part, etc.) is referred to as being "on", "connected to" or "coupled to" another element, it can be directly on, connected or coupled to the other element or a third intervening elements may be present.

In some embodiments, "directly on" may refer to that there are no additional layers, films, regions, plates, etc., between a layer, a film, a region, a plate, etc. and the other part. For example, "directly on" may refer to two layers or two members are disposed without utilizing an additional member such as an adhesive member therebetween.

It will be understood that, although the terms first, second, etc. may be utilized herein to describe one or more suitable elements, these elements should not be limited by these terms. These terms are only utilized to distinguish one element from another element. For example, a first element could be termed a second element without departing from the teachings of the present disclosure. Similarly, a second element could be termed a first element. As utilized herein, the singular forms are intended to include the plural forms as well, unless the context clearly indicates otherwise.

In some embodiments, the terms "below," "beneath," "on," and "above" are utilized for explaining the relation of elements shown in the drawings. The terms are relative concept and are explained based on the direction shown in the drawing. In the present disclosure, when an element is referred to as being disposed "on" another element, it can be disposed under the other element.

In the present disclosure, it will be further understood that the terms "comprise(s)/include(s) " and/or "comprising/including," when utilized in the present disclosure, specify the presence of stated features, numerals, steps, operations, elements, parts, or the combination thereof, but do not preclude the presence or addition of one or more other features, numerals, steps, operations, elements, parts, or the combination thereof.

As utilized herein, the singular forms "a," "an," and "the" are intended to include the plural forms as well, unless the context clearly indicates otherwise. Further, the use of "may" when describing embodiments of the present disclosure refers to "one or more embodiments of the present disclosure".

As utilized herein, the term "substantially," "about," and similar terms are utilized as terms of approximation and not as terms of degree, and are intended to account for the inherent deviations in measured or calculated values that would be recognized by those of ordinary skill in the art. "About," or "substantially," as utilized herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this disclosure is intended to include all higher numerical limitations subsumed therein. Accordingly, Applicant reserves the right to amend this disclosure, including the claims, to expressly recite any sub-range subsumed within the ranges expressly recited herein.

In the present disclosure, when particles are spherical, "diameter" indicates a particle diameter or an average particle diameter, and when the particles are non-spherical, the "diameter" indicates a major axis length or an average major axis length. The diameter (or size) of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter (or size) is referred to as D50. D50 refers to the average diameter (or size) of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

The light-emitting device, the display device, or any other relevant electronic devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the scope as defined by the following claims.

## Claims

1. An organometallic compound represented by Formula 1: 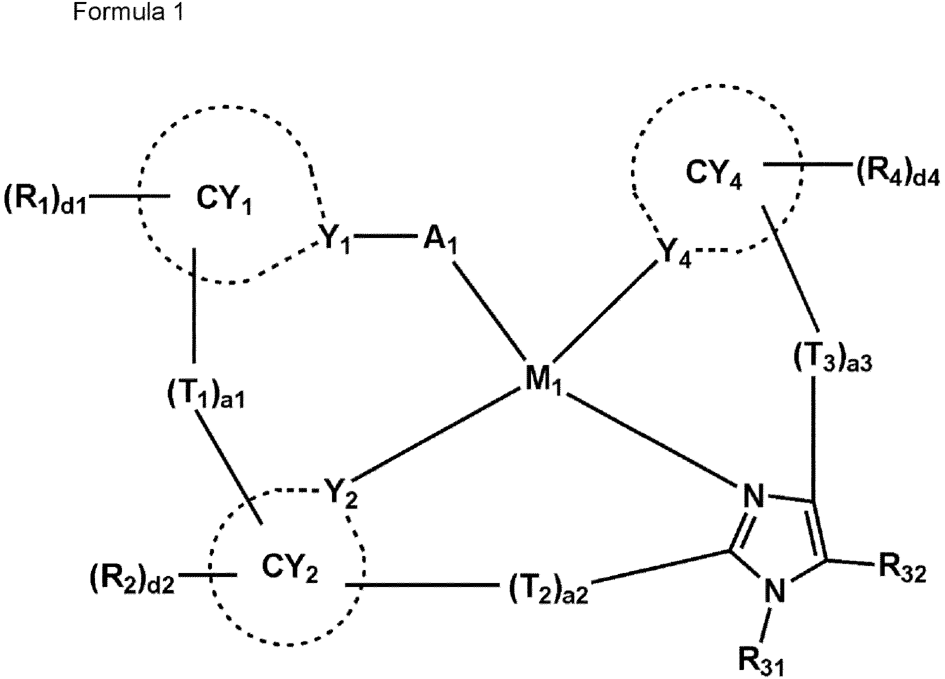
wherein, in Formula 1,
M₁ is a transition metal,
CY₁, CY₂, and CY₄ are each independently a C₃-C₆₀ carbocyclic group or a C₁-C₆₀ heterocyclic group,
Y₁, Y₂, and Y₄ are each independently C or N,
A₁ is O or S,
T₁ to T₃ are each independently a single bond, a double bond, *-N[(L₁)_{b1}-(R₁ₐ)]-*', *-B(R₁ₐ)-*', "-P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*', or *-C=C-*',
a1 to a3 are each independently an integer from 1 to 3,
* and *' each indicate a binding site to a neighboring atom, and
L₁ is a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
b1 is an integer from 1 to 3,
R₁, R₂, R₃₁, R₃₂, R₄, R₁ₐ, and R_{1b} are each independently hydrogen, deuterium, - F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
d1, d2, and d4 are each independently an integer from 0 to 20,
neighboring two or more groups of R₁, R₂, R₃₁, R₃₂, R₄, R₁ₐ, and R_{1b} are optionally bonded to each other to form a C₅-C₆₀ carbocyclic group that is unsubstituted or substituted with at least one R₁₀ₐ or a C₂-C₆₀ heterocyclic group that is unsubstituted or substituted with at least one R₁₀ₐ,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(O₁₁₎(O₁₂)(O₁₃), -N(Q₁₁)(Q₁₂), -B(Q₁₁)(Q₁₂), - C(=O)(O₁₁), -S(=O)₂(Q₁₁), -P(=O)(O₁₁)(O₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ arylalkyl group; or a C₂-C₆₀ heteroarylalkyl group.

2. The organometallic compound of claim 1, wherein
CY₄ is a polycyclic group comprising two or more condensed rings of a 6-membered ring.

3. The organometallic compound of claim 1 or 2, wherein
CY₄ is a group represented by Formula 4: 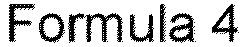 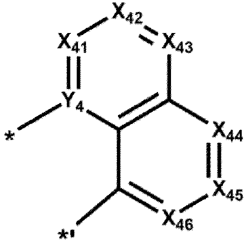
wherein, in Formula 4,
Y₄ is as defined in Formula 1,
X₄₁ is C(R₄₁) or N, X₄₂ is C(R₄₂) or N, X₄₃ is C(R₄₃) or N, X₄₄ is C(R₄₄) or N, X₄₅ is C(R₄₅) or N, and X₄₆ is C(R₄₆) or N,
R₄₁ to R₄₆ are each as defined as R₄ in Formula 1,
two or more groups of R₄₁ to R₄₆ are optionally bound to each other to form a C₅-C₆₀ carbocyclic group that is unsubstituted or substituted with at least one R₁₀ₐ or a C₂-C₆₀ heterocyclic group that is unsubstituted or substituted with at least one R₁₀ₐ, and
*' indicates a binding site to T₃ in Formula 1, and
* indicates a binding site to M₁ in Formula 1.

4. The organometallic compound of one of claims 1 to 3, wherein
at least one of R₁ in the number of d1 and at least one of R₂ in the number of d2 are linked to each other to form a C₅-C₆₀ carbocyclic group unsubstituted or substituted with R₁₀ₐ or a C₂-C₆₀ heterocyclic group unsubstituted or substituted with at least one R₁₀ₐ, and
R₁₀ₐ is as defined in Formula 1.

5. The organometallic compound of one of claims 1 to 4, wherein a group represented by 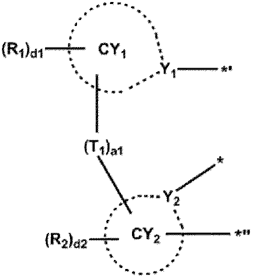 in Formula 1 is represented by Formula 2-1 or 2-2: 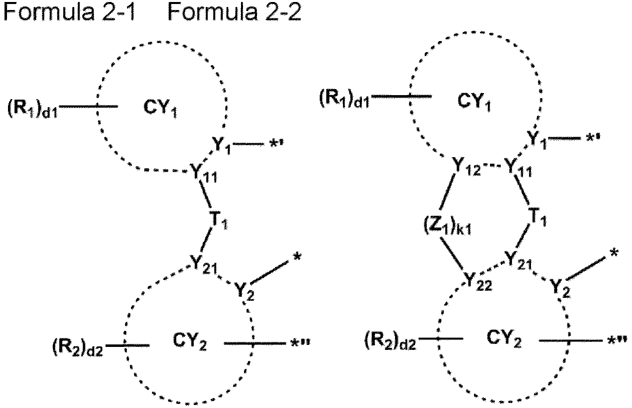
wherein, in Formulae 2-1 and 2-2,
CY₁, CY₂, Y₁, Y₂, and T₁ are each as defined in Formula 1, Y₁₁, Y₁₂, Y₂₁, and Y₂₂ are each independently C or N,
Z₁ is a single bond, a double bond, *‴-N[(L₆₀)_{b60}-(R₆₀)]-*ʺʺ, *‴-B(R₆₀)-*ʺʺ, *‴-P(R₆₀)-*ʺʺ, *‴-C(R₆₀ₐ)(R_{60b})-*ʺʺ, *‴-Si(R₆₀ₐ)(R_{60b})-*ʺʺ, *‴-Ge(R₆₀ₐ)(R_{60b})-*ʺʺ, *‴-S-*ʺʺ, *‴-Se-*ʺʺ, *‴-O-*ʺʺ, *‴-C(=O)-*ʺʺ, *‴-S(=O)-*ʺʺ, *‴-S(=O)₂-*ʺʺ, *‴-C(R₆₀)=*ʺʺ, or *‴=C(R₆₀)-*ʺʺ
k1 is an integer from 1 to 3,
L₆₀ is a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
b60 is an integer from 1 to 3,
R₆₀, R₆₀ₐ, and R_{60b} are each as defined as R₁ in Formula 1, and R₁₀ₐ is as defined in Formula 1,
*' indicates a binding site to A₁ in Formula 1,
* indicates a binding site to M₁ in Formula 1,
*" indicates a binding site to T₂ in Formula 1, and
*‴ and *ʺʺ each indicate a binding site to a neighboring atom.

6. The organometallic compound of one of claims 1 to 5, wherein a group represented by 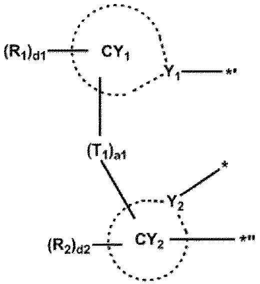 in Formula 1 is a group represented by one selected from among Formulae 2-11 to 2-13: 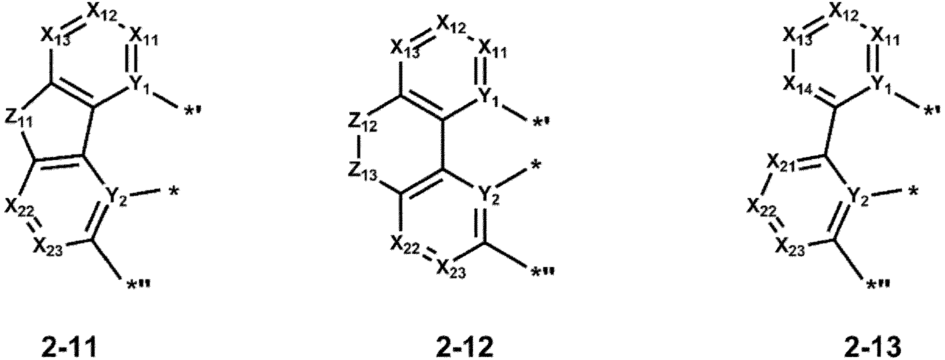
wherein, in Formulae 2-11 to 2-13,
Y₁ and Y₂ are as defined in Formula 1,
X₁₁ is C(R₁₁) or N, X₁₂ is C(R₁₂) or N, X₁₃ is C(R₁₃) or N, and X₁₄ is C(R₁₄) or N, X₂₁ is C(R₂₁) or N, X₂₂ is C(R₂₂) or N, and X₂₃ is C(R₂₃) or N,
R₁₁ to R₁₄ are each as defined as R₁ in Formula 1,
R₂₁ to R₂₃ are each as defined as R₂ in Formula 1,
two or more neighboring groups of R₁₁ to R₁₄ or R₂₁ to R₂₃ are optionally bonded to each other to form a C₅-C₆₀ carbocyclic group unsubstituted or substituted with at least one R₁₀ₐ or a C₂-C₆₀ heterocyclic group unsubstituted or substituted with at least one R₁₀ₐ,
Z₁₁ is *‴-N[(L₆₁)_{b61}-(R₆₁)]-*ʺʺ, *‴-O-*ʺʺ, *‴-S-*ʺʺ, *‴-Se-*ʺʺ, or *‴-C(R₆₁ₐ)(R_{61b})-*ʺʺ,
Z₁₂ is *‴-N[(L₆₂)_{b62}-(R₆₂)]-*ʺʺ, *‴-C(R₆₂ₐ)(R_{62b})-*ʺʺ, *‴-C(R₆₂)=*ʺʺ, or *‴=C(R₆₂)-*ʺʺ,
Z₁₃ is *‴-N[(L₆₃)_{b63}-(R₆₃)]-*ʺʺ, *‴-C(R₆₃ₐ)(R_{63b})-*ʺʺ, *‴-C(R₆₃)=*ʺʺ, or *‴=C(R₆₃)-*ʺʺ,
L₆₁ to L₆₃ are each independently a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
b61 to b63 are each independently an integer from 1 to 3,
R₆₁, R₆₁ₐ, R_{61b}, R₆₂, R₆₂ₐ, R_{62b}, R₆₃, R₆₃ₐ, and R_{63b} are each the same as defined as R₁ in Formula 1, and R₁₀ₐ is as defined in Formula 1,
*' indicates a binding site to A₁ in Formula 1,
* indicates a binding site to M₁ in Formula 1,
*" indicates a binding site to T₂ in Formula 1, and
*‴ and *ʺʺ each indicate a binding site to a neighboring atom.

7. The organometallic compound of one of claims 1 to 6, wherein a
³MLCT (a ratio of presence of triplet metal-to-ligand charge transfer) value of the organometallic compound represented by Formula 1 is 10 % or more.

8. The organometallic compound of one of claims 1 to 7, wherein
at least one selected from among Y₂ and Y₄ is N.

9. The organometallic compound of one of claims 1 to 8, wherein
R₃₁ is a group represented by Formula 3: 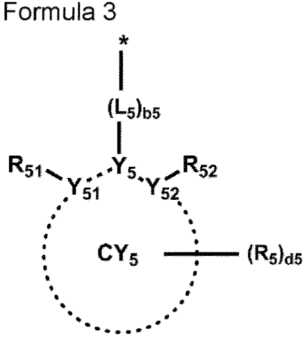
wherein, in Formula 3,
Y₅, Y₅₁, and Y₅₂ are each independently C or N,
CY₅ is a C₃-C₆₀ carbocyclic group or a C₁-C₆₀ heterocyclic group,
L₅ is a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
b5 is an integer from 1 to 3,
R₅, R₅₁, and R₅₂ are each as defined as R₁ in Formula 1,
d5 is an integer from 0 to 10, and
* indicates a binding site to a neighboring atom.

10. The organometallic compound of one of claims 1 to 9, wherein the organometallic compound is one selected from among Compounds D01 to D36:

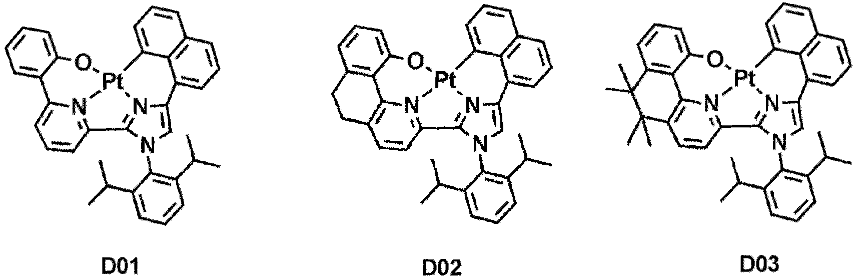

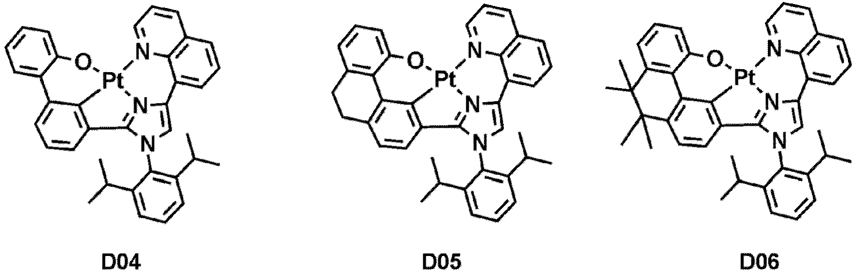

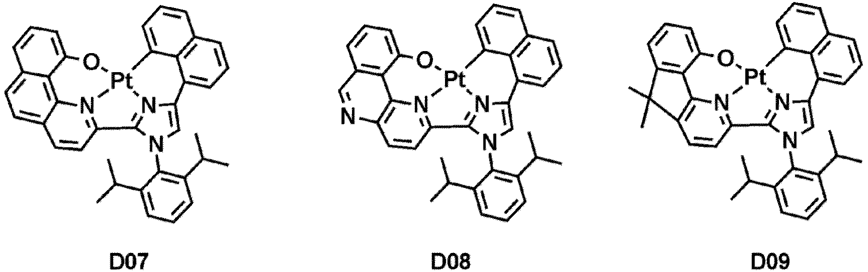

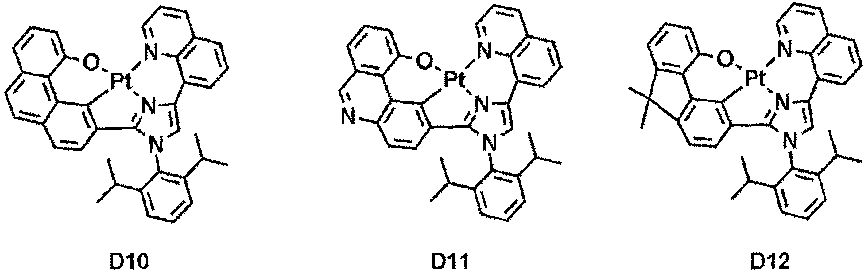

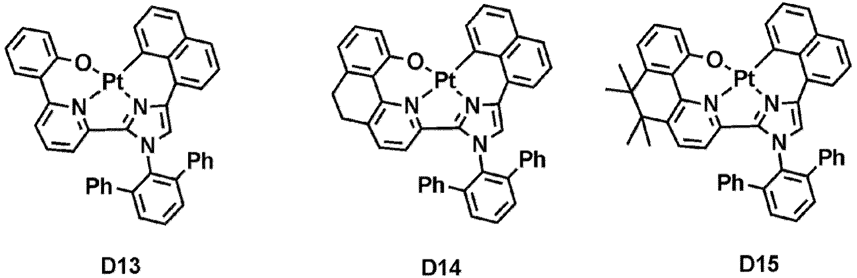

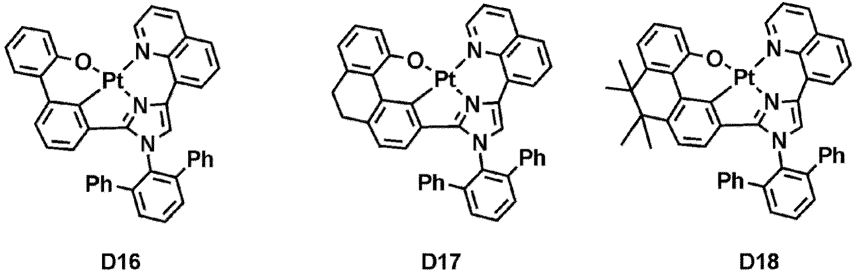

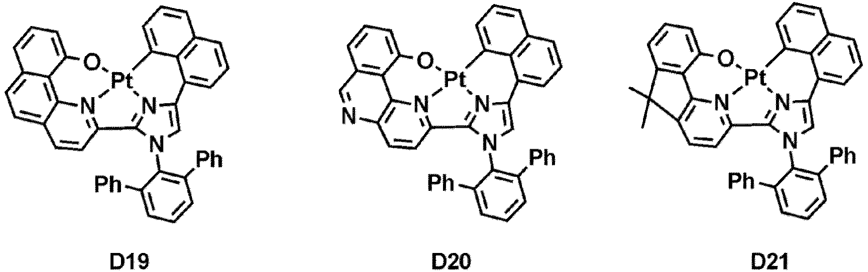

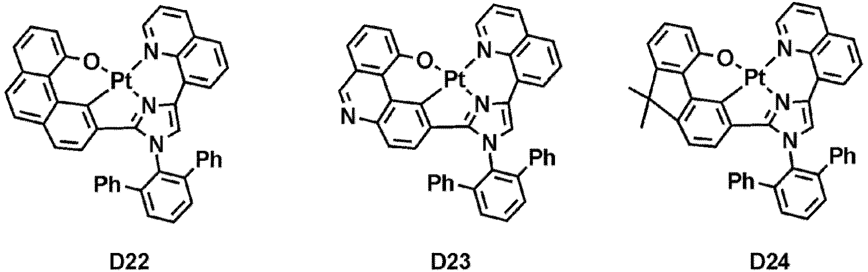

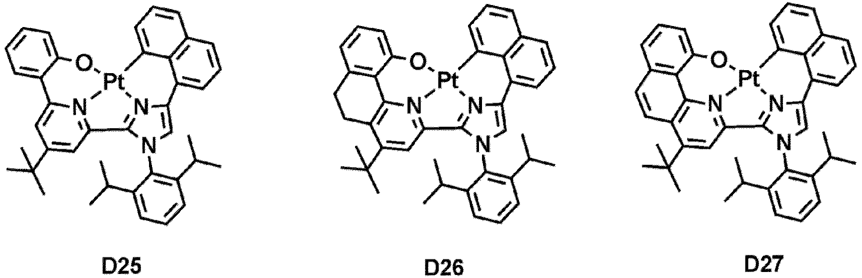

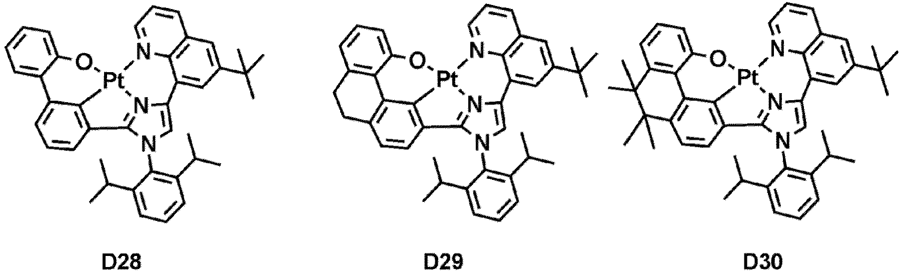

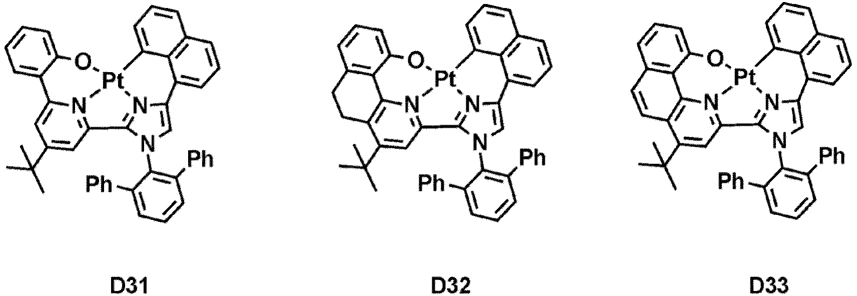

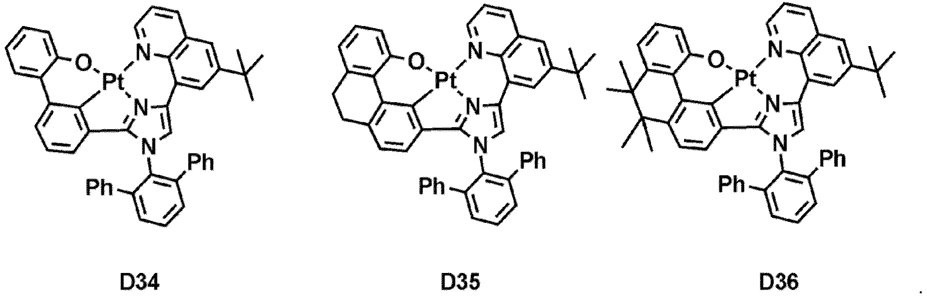

11. A light-emitting device (10), comprising:
a first electrode (110);
a second electrode (150) facing the first electrode (110);
an interlayer (130) between the first electrode (110 )and the second electrode (150) and comprising an emission layer; and
at least one organometallic compound according to one of claims 1 to 10.

12. The light-emitting device (10) of claim 11, wherein
the first electrode (110) is an anode,
the second electrode (150) is a cathode,
the interlayer (130) comprises the at least one organometallic compound,
the interlayer (130) further comprises a hole transport region between the first electrode (110) and the emission layer and an electron transport region between the emission layer and the second electrode(150),
the hole transport region comprises a hole injection layer, a hole transport layer, an emission auxiliary layer, an electron blocking layer, or any combination thereof, and
the electron transport region further comprises a hole blocking layer, an electron transport layer, an electron injection layer, or any combination thereof.

13. The light-emitting device (10) of claim 11 or 12, wherein the emission layer comprises the at least one organometallic compound according to one of claims 1 to 10.

14. The light-emitting device (10) of claim 13, wherein the emission layer further comprises a host, and an amount of the at least one organometallic compound is in a range of 0.01 wt% to 49.99 wt% based on 100 wt% of the emission layer.

15. The light-emitting device (10) of claim 13 or 14, wherein the emission layer is to emit light having a maximum emission wavelength of 590 nm to 670 nm.

16. An electronic apparatus comprising the light-emitting device (10) of one of claims 11 to 15.

17. The electronic apparatus of claim 16, further comprising
a thin-film transistor, wherein
the thin-film transistor comprises a source electrode (260) and a drain electrode (270), and
the first electrode (110) of the light-emitting device (10) is electrically connected to the source electrode (260) or the drain electrode (270) of the thin-film transistor.

18. The electronic apparatus of claim 16 or 17, further comprising a color filter, a color conversion layer, a touch screen layer, a polarizing layer, or any combination thereof.

19. The electronic apparatus of one of claims 16 to 18, further comprising:
a thin-film transistor; and
a color filter, a color-conversion layer, a touch screen layer, a polarizing layer, or any combination thereof, wherein
the thin-film transistor comprises a source electrode (260) and a drain electrode (270), and
the first electrode (110) of the light-emitting device (10) is electrically connected to the source electrode (260) or the drain electrode (270).

20. An electronic device (1) comprising the light-emitting device (10) of one of claims 11 to 15, wherein
the electronic device (10 is a flat panel display, a curved display, a computer monitor, a medical monitor, a television, an advertisement board, an indoor or outdoor lighting and/or signaling light, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a 3D display, a virtual or augmented-reality display, a vehicle (1000), a video wall comprising multiple displays tiled together, a theater or stadium screen, a phototherapy device, or a sign.

## Patentansprüche

1. Organometallische Verbindung, die durch Formel 1 wiedergegeben ist: 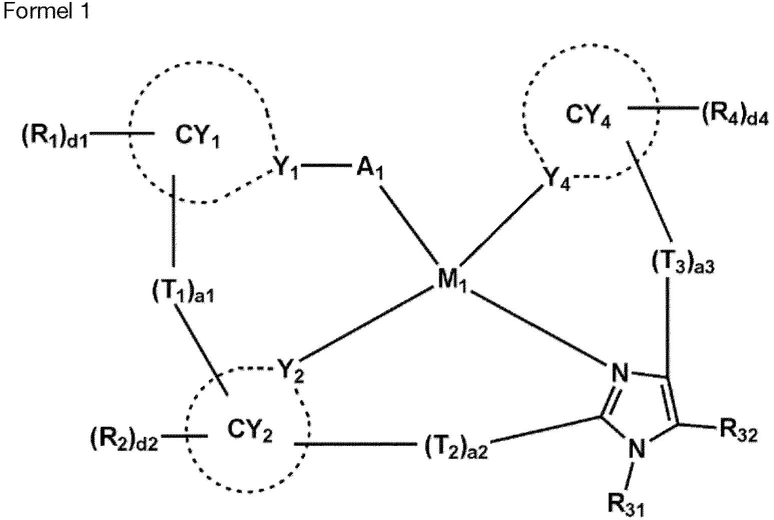
wobei in Formel 1
M₁ für ein Übergangsmetall steht,
CY₁, CY₂ und CY₄ jeweils unabhängig für eine carbocyclische C₃-C₆₀-Gruppe oder eine heterocyclische C₁-C₆₀-Gruppe stehen,
Y₁, Y₂ und Y₄ jeweils unabhängig für C oder N stehen,
A¹ für O oder S steht,
T₁ bis T₃ jeweils unabhängig für eine Einfachbindung, eine Doppelbindung, *-N[(L₁)_{b1}-(R₁ₐ)]-*', *-B(R₁ₐ)-*', *-P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*' oder *-C=C-*' stehen,
a1 bis a3 jeweils unabhängig für eine ganze Zahl von 1 bis 3 stehen,
* und *' jeweils eine Bindungsstelle an ein benachbartes Atom angeben und
L₁ für eine Einfachbindung, eine carbocyclische C₅-C₃₀-Gruppe, die unsubstituiert oder durch mindestens ein R₁₀ₐ substituiert ist, oder eine heterocyclische C₁-C₃₀-Gruppe, die unsubstituiert oder durch mindestens ein R₁₀ₐ substituiert ist, steht,
b1 für eine ganze Zahl von 1 bis 3 steht,
R₁, R₂, R₃₁, R₃₂, R₄, R₁ₐ und R_{1b} jeweils unabhängig für Wasserstoff, Deuterium, - F, -Cl, -Br, -I, eine Hydroxylgruppe, eine Cyanogruppe, eine Nitrogruppe, eine C₁-C₆₀-Alkylgruppe, die unsubstituiert oder durch mindestens ein R₁₀ₐ substituiert ist, eine C₂-C₆₀-Alkenylgruppe, die unsubstituiert oder durch mindestens ein R₁₀ₐ substituiert ist, eine C₂-C₆₀-Alkinylgruppe, die unsubstituiert oder durch mindestens ein R₁₀ₐ substituiert ist, eine C₁-C₆₀-Alkoxygruppe, die unsubstituiert oder durch mindestens ein R₁₀ₐ substituiert ist, eine carbocyclische C₃-C₆₀-Gruppe, die unsubstituiert oder durch mindestens ein R₁₀ₐ substituiert ist, eine heterozyklische C₁-C₆₀-Gruppe, die unsubstituiert oder durch mindestens ein R₁₀ₐ substituiert ist, eine C₆-C₆₀-Aryloxygruppe, die unsubstituiert oder durch mindestens ein R₁₀ₐ substituiert ist, eine C₆-C₆₀-Arylthiogruppe, die unsubstituiert oder durch mindestens ein R₁₀ₐ substituiert ist, -Si(Q₁)(Q₂)(Q₃), -N(Q₁)(Q₂), -B(Q₁)(Q₂), -C(=O)(Q₁), -S(=O)₂(Q₁) oder -P(=O)(Q₁)(Q₂) stehen,
d1, d2, and d4 jeweils unabhängig für eine ganze Zahl von 0 bis 20 stehen,
zwei oder mehr benachbarte Gruppen von R₁, R₂, R₃₁, R₃₂, R₄, R₁ₐ und R_{1b} gegebenenfalls unter Bildung einer carbocyclischen C₅-C₆₀-Gruppe, die unsubstituiert oder durch mindestens ein R₁₀ₐ substituiert ist, oder einer heterocyclischen C₂-C₆₀-Gruppe, die unsubstituiert oder durch mindestens ein R₁₀ₐ substituiert ist, aneinandergebunden sind,
R₁₀ₐ für Folgendes steht:
Deuterium, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, die jeweils unsubstituiert oder durch Deuterium, -F, -Cl, -Br, -I, eine Hydroxylgruppe, eine Cyanogruppe, eine Nitrogrupp, eine carbocyclische C₃-C₆₀-Gruppe, eine heterocyclische C₁-C₆₀-Gruppe, eine C₆-C₆₀-Aryloxygruppe, eine C₆-C₆₀-Arylthiogruppe, eine C₇-C₆₀-Arylalkylgruppe, eine C₂-C₆₀-Heteroarylalkylgruppe, -Si(Q₁₁)(Q₁₂)(Q₁₃), -N(Q11)(Q12), -B(Q11)(Q12), - C(=O)(Q₁₁), -S(=O)₂(Q₁₁), -P(=O)(Q₁₁)(Q₁₂) oder eine beliebige Kombination davon substituiert sind;
eine carbocyclische C₃-C₆₀-Gruppe, eine heterocyclische C₁-C₆₀-Gruppe, eine C₆-C₆₀-Aryloxygruppe, eine C₆-C₆₀-Arylthiogruppe, eine C₇₋C₆₀-Arylalkylgruppe oder eine C₂-C₆₀-Heteroarylalkylgruppe, die jeweils unsubstituiert oder durch Deuterium, -F, -Cl, -Br, -I, einer Hydroxylgruppe, eine Cyanogruppe, eine Nitrogruppe, eine C₁-C₆₀-Alkylgruppe, eine C₂-C₆₀-Alkenylgruppe, eine C₂-C₆₀-Alkinylgruppe, eine C₁-C₆₀-Alkoxygruppe, eine carbocyclische C₃-C₆₀-Gruppe,
eine heterocyclische C₁-C₆₀-Gruppe, eine C₆-C₆₀-Aryloxygruppe, eine C₆-C₆₀-Arylthiogruppe, eine C₇-C₆₀-Arylalkylgruppe, eine C₂-C₆₀-Heteroarylalkylgruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂) oder eine beliebige Kombinationen davon substituiert sind; oder -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) oder - P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig für Folgendes stehen: Wasserstoff; Deuterium; -F; -CI; -Br; -I; eine Hydroxylgruppe;
eine Cyanogruppe; eine Nitrogruppe; eine C₁-C₆₀-Alkylgruppe; eine C₂-C₆₀-Alkenylgruppe; eine C₂-C₆₀-Alkinylgruppe; eine C₁-C₆₀-Alkoxygruppe; eine carbocyclische C₃-C₆₀-Gruppe oder eine heterocyclische C₁-C₆₀-Gruppe, die jeweils unsubstituiert oder durch Deuterium, -F, eine Cyanogruppe, eine C₁-C₆₀-Alkylgruppe, eine C₁-C₆₀-Alkoxygruppe, eine Phenylgruppe, eine Biphenylgruppe oder eine beliebige Kombination davon substituiert sind; eine C₇-C₆₀-Arylalkylgruppe; oder eine C₂-C₆₀-Heteroarylalkylgruppe.

2. Organometallische Verbindung nach Anspruch 1, wobei CY₄ für eine polycyclische Gruppe steht, die zwei oder mehr kondensierte Ringe eines 6-gliedrigen Rings umfasst.

3. Organometallische Verbindung nach Anspruch 1 oder 2, wobei CY₄ für eine Gruppe steht, die durch Formel 4 wiedergegeben ist: 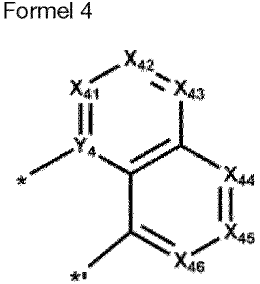
wobei in Formel 4
Y⁴ wie in Formel 1 definiert ist,
X₄₁ für C(R₄₁) oder N steht, X₄₂ für C(R₄₂) oder N steht, X₄₃ für C(R₄₃) oder N steht,
X₄₄ für C(R₄₄) oder N steht, X₄₅ für C(R₄₅) oder N steht und X₄₆ für C(R₄₆) oder N steht,
R₄₁ bis R₄₆ jeweils wie R₄ in Formel 1 definiert sind,
zwei oder mehr Gruppen von R₄₁ bis R₄₆ gegebenenfalls unter Bildung einer carbocyclischen C₅-C₆₀-Gruppe, die unsubstituiert oder durch mindestens ein R₁₀ₐ substituiert ist, oder einer heterocyclischen C₂-C₆₀-Gruppe, die unsubstituiert oder durch mindestens ein R₁₀ₐ substituiert ist, aneinandergebunden sind und
*' eine Bindungsstelle an T₃ in Formel 1 angibt und
* eine Bindungsstelle an M₁ in Formel 1 angibt.

4. Organometallische Verbindung nach einem der Ansprüche 1 bis 3, wobei mindestens eines von R₁ in der Anzahl von d1 und mindestens eines von R₂ in der Anzahl von d2 unter Bildung einer carbocyclischen C₅-C₆₀-Gruppe, die unsubstituiert oder durch R₁₀ₐ substituiert ist, oder einer heterocyclischen C₂-C₆₀-Gruppe, die unsubstituiert oder durch mindestens ein R₁₀ₐ substituiert ist, miteinander verknüpft sind und
R₁₀ₐ wie in Formel 1 definiert ist.

5. Organometallische Verbindung nach einem der Ansprüche 1 bis 4, wobei eine Gruppe, die durch 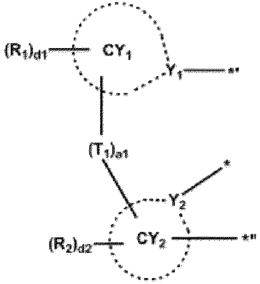 in Formel 1 wiedergegeben ist, durch Formel 2-1 oder 2-2 wiedergegeben ist: 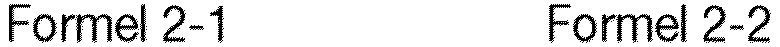 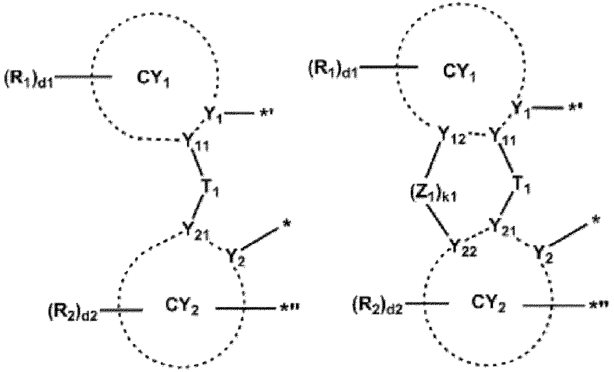
wobei in den Formeln 2-1 und 2-2
CY₁, CY₂, Y₁, Y₂ und T₁ jeweils wie in Formel 1 definiert sind,
Y₁₁, Y₁₂, Y₂₁ und Y₂₂ jeweils unabhängig für C oder N stehen,
Z₁ für eine Einfachbindung, eine Doppelbindung, *‴-N[(L₆₀)_{b60}-(R₆₀)]-*ʺʺ, *‴-B(R₆₀)-*ʺʺ, *‴-P(R₆₀)-*ʺʺ, *‴-C(R₆₀ₐ)(R_{60b})-*ʺʺ, *‴-Si(R₆₀ₐ)(R_{60b})-*ʺʺ, *‴-Ge(R₆₀ₐ)(R_{60b})-*ʺʺ, *‴-S-*ʺʺ, *‴-Se-*ʺʺ, *‴-O-*ʺʺ, *‴-C(=O)-*ʺʺ, *‴-S(=O)-*ʺʺ, *‴-S(=O)₂-*ʺʺ, *‴-C(R₆₀)=*ʺʺ oder *‴=C(R₆₀)-*ʺʺ steht,
k1 für eine ganze Zahl von 1 bis 3 steht,
L₆₀ für eine Einfachbindung, eine carbocyclische C₅-C₃₀-Gruppe, die unsubstituiert oder durch mindestens ein R₁₀ₐ substituiert ist, oder eine heterocyclische C₁-C₃₀-Gruppe, die unsubstituiert oder durch mindestens ein R₁₀ₐ substituiert ist, steht,
b60 für eine ganze Zahl von 1 bis 3 steht,
R₆₀, R₆₀ₐ und R_{60b} jeweils wie R₁ in Formel 1 definiert sind und R₁₀ₐ wie in Formel 1 definiert ist,
*' eine Bindungsstelle an A₁ in Formel 1 angibt,
* eine Bindungsstelle an M₁ in Formel 1 angibt,
*" eine Bindungsstelle an T₂ in Formel 1 angibt und
*‴ und *ʺʺ jeweils eine Bindungsstelle an ein benachbartes Atom angeben.

6. Organometallische Verbindung nach einem der Ansprüche 1 bis 5, wobei eine Gruppe, die durch 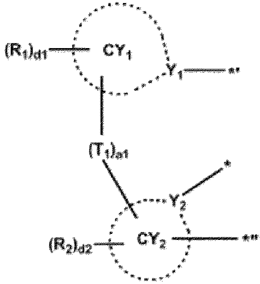 in Formel 1 wiedergegeben ist, eine Gruppe ist, die durch eine aus den Formeln 2-11 bis 2-13 ausgewählte Formel wiedergegeben ist: 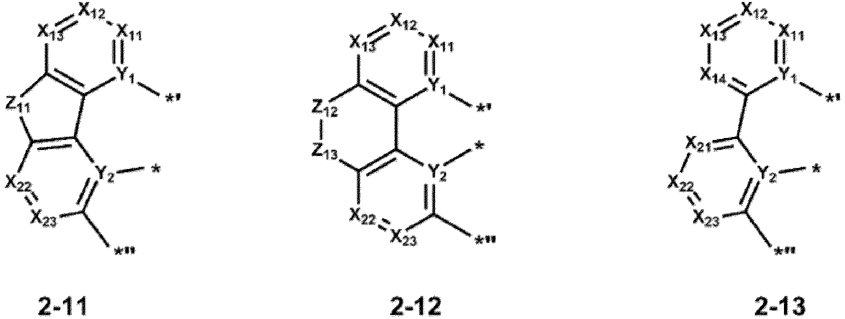
wobei in den Formel 2-11 bis 2-13
Y₁ and Y₂ wie in Formel 1 definiert sind,
X₁₁ für C(R₁₁) oder N steht, X₁₂ für C(R₁₂) oder N steht, X₁₃ für C(R₁₃) oder N steht und X₁₄ für C(R₁₄) oder N steht,
X₂₁ für C(R₂₁) oder N steht, X₂₂ für C(R₂₂) oder N steht und X₂₃ für C(R₂₃) oder N steht,
R₁₁ bis R₁₄ jeweils wie R₁ in Formel 1 definiert sind,
R₂₁ bis R₂₃ jeweils wie R₂ in Formel 1 definiert sind,
zwei oder mehr benachbarte Gruppen von R₁₁ bis R₁₄ oder R₂₁ bis R₂₃ gegebenenfalls unter Bildung einer carbocyclischen C₅-C₆₀-Gruppe, die unsubstituiert oder durch mindestens ein R₁₀ₐ substituiert ist, oder einer heterocyclischen C₂-C₆₀-Gruppe, die unsubstituiert oder durch mindestens ein R₁₀ₐ substituiert ist, aneinandergebunden sind,
Z₁₁ für *‴-N[(L₆₁)_{b61}-(R₆₁)]-*ʺʺ, *‴-O-*ʺʺ, *‴-S-*ʺʺ, *‴-Se-, *ʺʺ oder *‴-C(R₆₁ₐ)(R_{61b})-*ʺʺ steht,
Z₁₂ für *‴-N[(L₆₂)_{b62}-(R₆₂)]-*ʺʺ, *‴-C(R₆₂ₐ)(R_{62b})-*ʺʺ, *‴-C(R₆₂)=*ʺʺ oder *‴=C(R₆₂)-*ʺʺ steht,
Z₁₃ für *‴-N[(L₆₃)_{b63}-(R₆₃)]-*ʺʺ, *ʺʺ-C(R₆₃ₐ)(R_{63b})-*ʺʺ, *‴-C(R₆₃)=*ʺʺ oder *‴=C(R₆₃)-*ʺʺ steht,
L₆₁ bis L₆₃ jeweils unabhängig für eine Einfachbindung, eine carbocyclische C₅-C₃₀-Gruppe, die unsubstituiert oder durch mindestens ein R₁₀ₐ substituiert ist, oder eine heterocyclische C₁-C₃₀-Gruppe, die unsubstituiert oder durch mindestens ein R₁₀ₐ substituiert ist, stehen,
b61 bis b63 jeweils unabhängig für eine ganze Zahl von 1 bis 3 stehen, R₆₁, R₆₁ₐ, R_{61b}, R₆₂, R₆₂ₐ, R_{62b}, R₆₃, R₆₃ₐ und R_{63b} jeweils ebenso wie R₁ in Formel 1 definiert sind und R₁₀ₐ wie in Formel 1 definiert ist,
*' eine Bindungsstelle an A₁ in Formel 1 angibt,
* eine Bindungsstelle an M₁ in Formel 1 angibt,
*" eine Bindungsstelle an T₂ in Formel 1 angibt und
*‴ und *ʺʺ jeweils eine Bindungsstelle an ein benachbartes Atom angeben.

7. Organometallische Verbindung nach einem der Ansprüche 1 bis 6, wobei ein ³⁻MLCT-Wert (ein Verhältnis des Vorliegens eines Triplett-Metall-Liganden-Ladungstransfers) der durch Formel 1 wiedergegebenen organometallischen Verbindung 10 % oder mehr beträgt.

8. Organometallische Verbindung nach einem der Ansprüche 1 bis 7, wobei mindestens eines, das aus Y₂ und Y₄ ausgewählt ist, für N steht.

9. Organometallische Verbindung nach einem der Ansprüche 1 bis 8, wobei R₃₁ für eine Gruppe steht, die durch Formel 3 wiedergegeben ist: 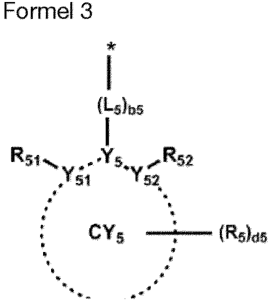
wobei in Formel 3
Y₅, Y₅₁ und Y₅₂ jeweils unabhängig für C oder N stehen;
CY₅ für eine carbocyclische C₃-C₆₀-Gruppe oder eine heterocyclische C₁-C₆₀-Gruppe steht,
L₅ für eine Einfachbindung, eine carbocyclische C₅-C₃₀-Gruppe, die unsubstituiert oder durch mindestens ein R₁₀ₐ substituiert ist, oder eine heterocyclische C₁-C₃₀-Gruppe, die unsubstituiert oder durch mindestens ein R₁₀ₐ substituiert ist, steht,
b5 für eine ganze Zahl von 1 bis 3 steht,
R₅ R₅₁ und R₅₂ jeweils wie R₁ in Formel 1 definiert sind,
d5 für eine ganze Zahl von 0 bis 10 steht und
* eine Bindungsstelle an ein benachbartes Atom angibt.

10. Organometallische Verbindung nach einem der Ansprüche 1 bis 9, wobei die organometallische Verbindung eine ist, die aus den Verbindungen D01 bis D36 ausgewählt ist:

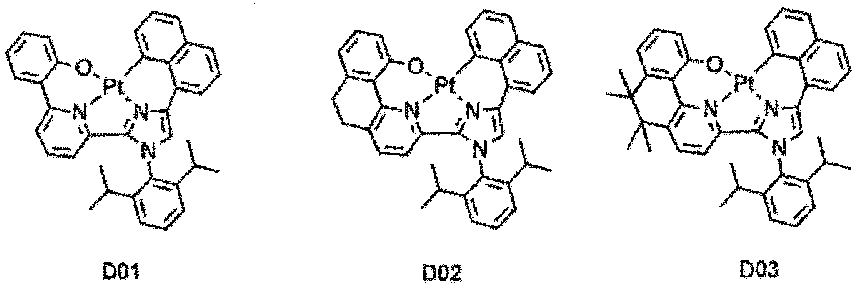

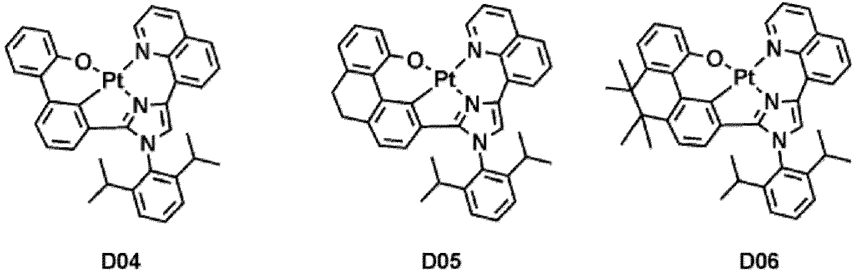

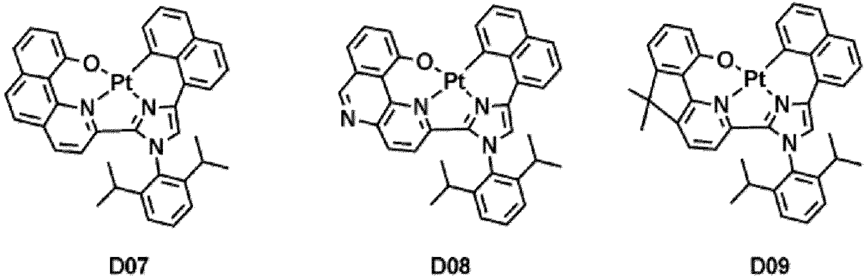

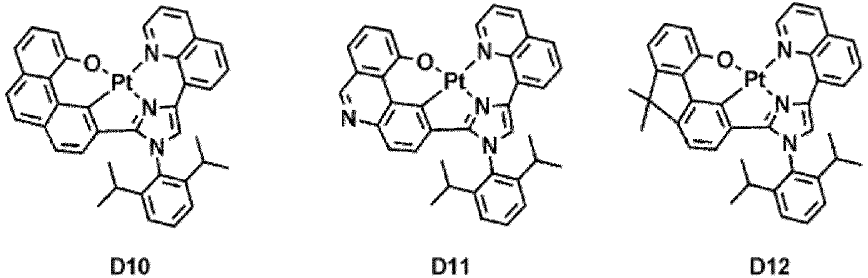

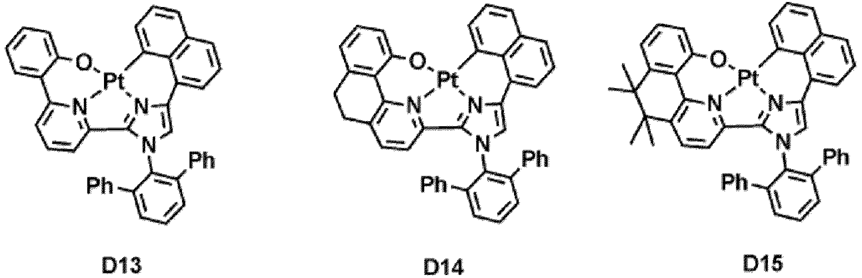

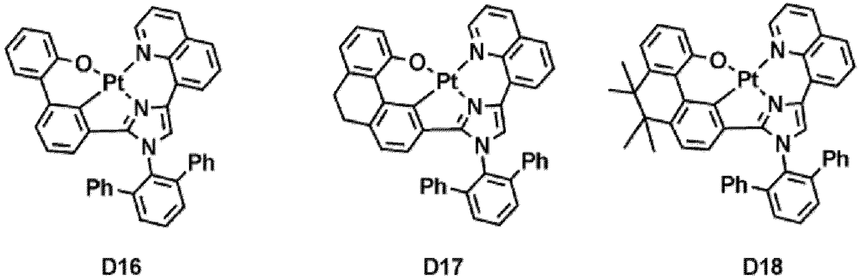

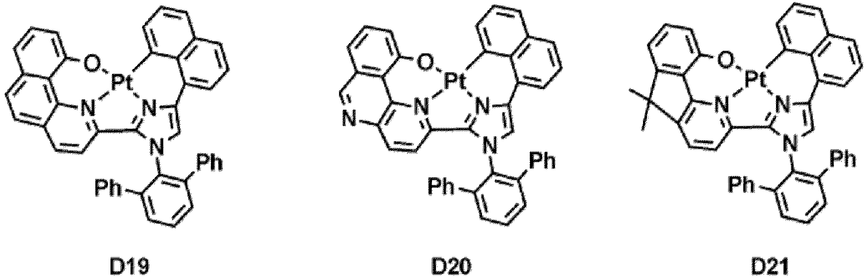

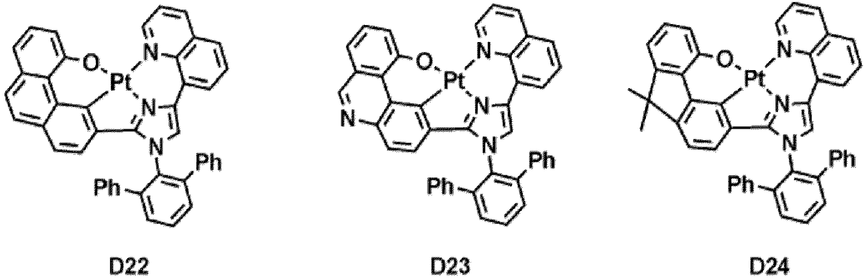

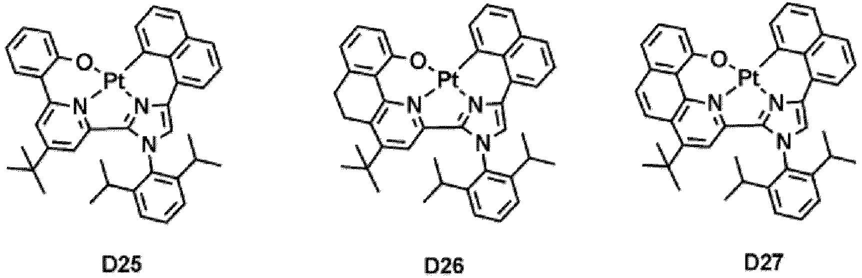

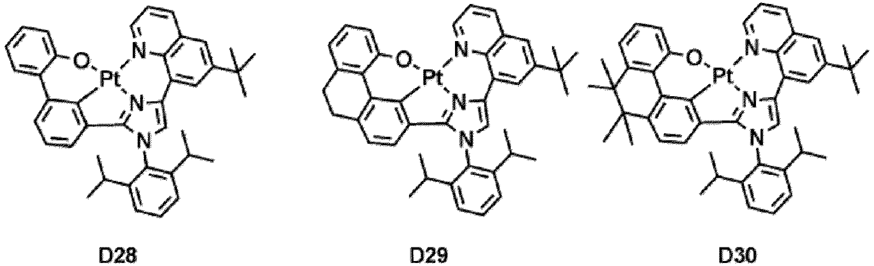

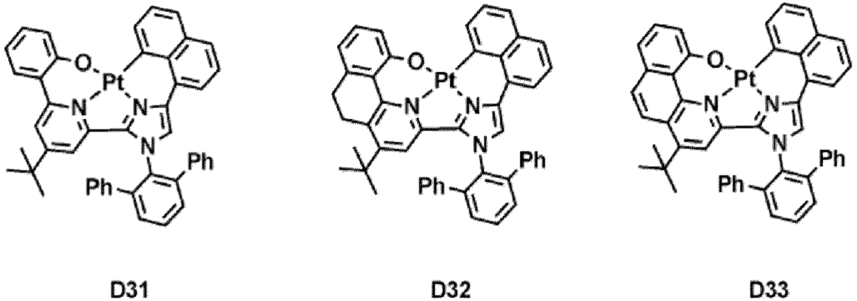

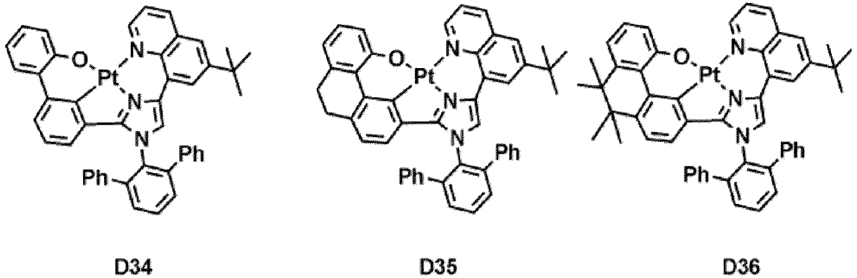

11. Leuchtvorrichtung (10), umfassend:
eine erste Elektrode (110);
eine zweite Elektrode (150), die der ersten Elektrode (110) zugewandt ist;
eine Zwischenschicht (130) zwischen der ersten Elektrode (110) und der zweiten Elektrode (150), die eine Emissionsschicht umfasst; und
mindestens eine organometallische Verbindung nach einem der Ansprüche 1 bis 10.

12. Leuchtvorrichtung (10) nach Anspruch 11, wobei
die erste Elektrode (110) eine Anode ist,
die zweite Elektrode (150) eine Kathode ist,
die Zwischenschicht (130) die mindestens eine organometallische Verbindung umfasst,
die Zwischenschicht (130) ferner einen Lochtransportbereich zwischen der ersten Elektrode (110) und der Emissionsschicht und einen Elektronentransportbereich zwischen der Emissionsschicht und der zweiten Elektrode (150) umfasst,
der Lochtransportbereich eine Lochinjektionsschicht, eine Lochtransportschicht, eine Emissionshilfsschicht, eine Elektronensperrschicht oder eine beliebige Kombination davon umfasst und
der Elektronentransportbereich ferner eine Lochsperrschicht, eine Elektronentransportschicht, eine Elektroneninjektionsschicht oder eine beliebige Kombination davon umfasst.

13. Leuchtvorrichtung (10) nach Anspruch 11 oder 12, wobei die Emissionsschicht die mindestens eine organometallische Verbindung nach einem der Ansprüche 1 bis 10 umfasst.

14. Leuchtvorrichtung (10) nach Anspruch 13, wobei die Emissionsschicht ferner einen Wirt umfasst und eine Menge der mindestens einen organometallischen Verbindung in einem Bereich von 0,01 Gew.-% bis 49,99 Gew.-% bezogen auf 100 Gew.-% der Emissionsschicht liegt.

15. Leuchtvorrichtung (10) nach Anspruch 13 oder 14, wobei vorgesehen ist, dass die Emissionsschicht Licht emittiert, das eine maximale Emissionswellenlänge von 590 nm bis 670 nm aufweist.

16. Elektronische Vorrichtung, umfassend die Leuchtvorrichtung (10) nach einem der Ansprüche 11 bis 15.

17. Elektronische Vorrichtung nach Anspruch 16, ferner umfassend
einen Dünnschichttransistor, wobei
der Dünnschichttransistor eine Source-Elektrode (260) und eine Drain-Elektrode (270) umfasst und
die erste Elektrode (110) der Leuchtvorrichtung (10) elektrisch mit der Source-Elektrode (260) oder der Drain-Elektrode (270) des Dünnschichttransistors verbunden ist.

18. Elektronische Vorrichtung nach Anspruch 16 oder 17, ferner umfassend ein Farbfilter, eine Farbumwandlungsschicht, eine Touchscreen-Schicht, eine polarisierende Schicht oder eine beliebige Kombination davon.

19. Elektronische Vorrichtung nach einem der Ansprüche 16 bis 18, ferner umfassend:
einen Dünnschichttransistor; und
ein Farbfilter, eine Farbumwandlungsschicht, eine Touchscreen-Schicht, eine polarisierende Schicht oder eine beliebige Kombination davon, wobei
der Dünnschichttransistor eine Source-Elektrode (260) und eine Drain-Elektrode (270) umfasst und
die erste Elektrode (110) der Leuchtvorrichtung (10) elektrisch mit der Source-Elektrode (260) oder der Drain-Elektrode (270) verbunden ist.

20. Elektronische Vorrichtung (1), umfassend die Leuchtvorrichtung (10) nach einem der Ansprüche 11 bis 15, wobei
die elektronische Vorrichtung (1) eine Flachbildschirmanzeige, eine gebogene Anzeige, ein Computermonitor, ein medizinischer Monitor, ein Fernseher, eine Werbetafel, eine Innen- oder Außenbeleuchtung und/oder Signalisierungsleuchte, eine Frontanzeige, eine vollständig oder teilweise transparente Anzeige, eine flexible Anzeige, eine rollbare Anzeige, eine faltbare Anzeige, eine dehnbare Anzeige, ein Laserdrucker, ein Telefon, ein Mobiltelefon, ein Tablet, ein Phablet, ein persönlicher digitaler Assistent (PDA), eine am Körper tragbare Vorrichtung, ein Laptop-Computer, eine Digitalkamera, ein Camcorder, ein Sucher, eine Mikroanzeige, eine 3D-Anzeige, eine virtuelle Anzeige oder Anzeige für erweiterte Realität, ein Fahrzeug (1000), eine Videowand, umfassend mehrere Anzeigen, die miteinander verkachelt sind, eine Kinoleinwand oder ein Stadionbildschirm, eine Fototherapievorrichtung oder ein Schild ist.

## Revendications

1. Composé organométallique représenté par la formule 1 : 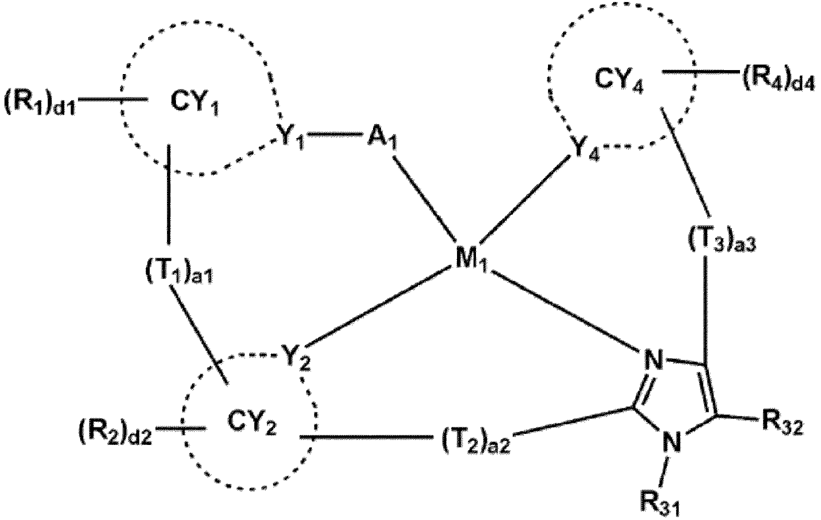
dans lequel, dans la formule 1,
M₁ est un métal de transition,
CY₁, CY₂ et CY₄ sont chacun indépendamment un groupe carbocyclique en C₃-C₆₀ ou un groupe hétérocyclique en C₁-C₆₀,
Y₁, Y₂ et Y₄ sont chacun indépendamment C ou N,
A₁ est O ou S,
T₁ à T₃ sont chacun indépendamment une liaison simple, une liaison double, *-N[(L₁)_{b1}-(R₁ₐ)]-*', *-B(R₁ₐ)-*', *-P(R₁ₐ)*', *C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*' ou *-C≡C-*',
a₁ à a₃ sont chacun indépendamment un nombre entier de 1 à 3,
* et *' indiquent chacun un site de liaison à un atome voisin, et
L₁ est une liaison simple, un groupe carbocyclique en C₅-C₃₀ qui est non substitué ou substitué par au moins un R₁₀ₐ, ou un groupe hétérocyclique en C₁-C₃₀ qui est non substitué ou substitué par au moins un R₁₀ₐ,
b1 est un nombre entier de 1 à 3,
R₁, R₂, R₃₁, R₃₂, R₄, R₁ₐ et R_{1b} sont chacun indépendamment hydrogène, deutérium, -F, -Cl, -Br, -I, un groupe hydroxyle, un groupe cyano, un groupe nitro, un groupe alkyle en C₁-C₆₀ non substitué ou substitué par au moins un R₁₀ₐ, un groupe alcényle en C₂-C₆₀ non substitué ou substitué par au moins un R₁₀ₐ, un groupe alcynyle en C₂-C₆₀ non substitué ou substitué par au moins un R₁₀ₐ, un groupe alcoxy en C₁-C₆₀ non substitué ou substitué par au moins un R₁₀ₐ, un groupe carbocyclique en C₃-C₆₀ non substitué ou substitué par au moins un R₁₀ₐ, un groupe hétérocyclique en C₁-C₆₀ non substitué ou substitué par au moins un R₁₀ₐ, un groupe aryloxy en C₆-C₆₀ non substitué ou substitué par au moins un R₁₀ₐ, un groupe arylthio en C₆-C₆₀ non substitué ou substitué par au moins un R₁₀ₐ, -Si(Q₁)(Q₂)(Q₃), -N(Q₁)(Q₂), -B(Q₁)(Q₂), -C(=O)(Q₁), - S(=O)₂(Q₁) ou -P(=O)(Q₁)(Q₂),
d1, d2 et d4 sont chacun indépendamment un nombre entier de 0 à 20,
deux groupes voisins ou plus parmi R₁, R₂, R₃₁, R₃₂, R₄, R₁ₐ et R_{1b} sont facultativement liés les uns aux autres pour former un groupe carbocyclique en C₅-C₆₀ qui est non substitué ou substitué par au moins un R₁₀ₐ ou un groupe hétérocyclique en C₂-C₆₀ qui est non substitué ou substitué par au moins un R₁₀ₐ,
R₁₀ₐ est :
deutérium, -F, -Cl, -Br, -I, un groupe hydroxyle, un groupe cyano ou un groupe nitro ;
un groupe alkyle en C₁-C₆₀, un groupe alcényle en C₂-C₆₀, un groupe alcynyle en C₂-C₆₀ ou un groupe alcoxy en C₁-C₆₀, chacun non substitué ou substitué par du deutérium,
-F, -Cl, -Br, -I, un groupe hydroxyle, un groupe cyano, un groupe nitro, un groupe carbocyclique en C₃-C₆₀, un groupe hétérocyclique en C₁-C₆₀, un groupe aryloxy en C₆-C₆₀, un groupe arylthio en C₆-C₆₀, un groupe arylalkyle en C₇-C₆₀, un groupe hétéroarylalkyle en C₂-C₆₀, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) ou -P(=O)(Q₁₁)(Q₁₂), ou toutes combinaisons de ceux-ci ;
un groupe carbocyclique en C₃-C₆₀, un groupe hétérocyclique en C₁-C₆₀, un groupe aryloxy en C₆-C₆₀, un groupe arylthio en C₆-C₆₀, un groupe arylalkyle en C₇-C₆₀ ou un groupe hétéroarylalkyle en C₂-C₆₀, chacun non substitué ou
substitué par du deutérium, -F, -Cl, -Br, -I, un groupe hydroxyle, un groupe cyano, un groupe nitro, un groupe alkyle en C₁-C₆₀, un groupe alcényle en C₂-C₆₀, un groupe alcynyle en C₂-C₆₀, un groupe alcoxy en C₁-C₆₀, un groupe carbocyclique en C₃-C₆₀, un groupe hétérocyclique en C₁-C₆₀, un groupe aryloxy en C₆-C₆₀, un groupe arylthio en C₆-C₆₀, un groupe arylalkyle en C₇-C₆₀, un groupe hétéroarylalkyle en C₂-C₆₀, -Si(Q21)(Q22)(Q23), -N(Q21)(Q22), -B(Q21)(Q22), -C(=O)(Q₂₁), -S(=O)₂(Q₂₁), -P(=O)(Q₂₁)(Q₂₂), ou toutes combinaisons de ceux-ci ; ou
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) ou -P(=O)(Q₃₁)(Q₃₂),
dans lequel Q₁ à Q₃, Q₁₁ à Q₁₃, Q₂₁ à Q₂₃, et Q₃₁ à Q₃₃ sont chacun indépendamment : hydrogène ; deutérium ; -F ; -Cl ; -Br ; -I ; un groupe hydroxyle ; un groupe cyano ; un groupe nitro ; un groupe alkyle en C₁-C₆₀ ; un groupe alcényle en C₂-C₆₀ ; un groupe alcynyle en C₂-C₆₀ ; un groupe alcoxy en C₁-C₆₀ ; un groupe carbocyclique en C₃-C₆₀ ou un groupe hétérocyclique en C₁-C₆₀, chacun non substitué ou substitué par du deutérium, -F, un groupe cyano,
un groupe alkyle en C₁-C₆₀, un groupe alcoxy en C₁-C₆₀, un groupe phényle, un groupe biphényle, ou toutes combinaisons de ceux-ci ; un groupe arylalkyle en C₇-C₆₀ ; ou un groupe hétéroarylalkyle en C₂-C₆₀.

2. Composé organométallique selon la revendication 1, dans lequel CY₄ est un groupe polycyclique comprenant deux cycles condensés ou plus d'un cycle à 6 chaînons.

3. Composé organométallique selon la revendication 1 ou 2, dans lequel CY₄ est un groupe représenté par la formule 4 : 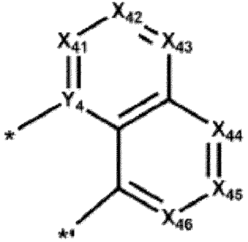 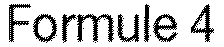
dans lequel, dans la formule 4,
Y₄ est tel que défini dans la formule 1,
X₄₁ est C(R₄₁) ou N, X₄₂ est C(R₄₂) ou N, X₄₃ est C(R₄₃) ou N, X₄₄ est C(R₄₄) ou N, X₄₅ est C(R₄₅) ou N, et X₄₆ est C(R₄₆) ou N,
R₄₁ à R₄₆ sont chacun définis comme R₄ dans la formule 1,
deux groupes ou plus parmi R₄₁ à R₄₆ sont facultativement liés les uns aux autres pour former un groupe carbocyclique en C₅-C₆₀ qui est non substitué ou substitué par au moins un R₁₀ₐ ou un groupe hétérocyclique en C₂-C₆₀ qui est non substitué ou substitué par au moins un R₁₀ₐ, et
*' indique un site de liaison à T₃ dans la formule 1, et
* indique un site de liaison à M₁ dans la formule 1.

4. Composé organométallique selon l'une des revendications 1 à 3, dans lequel au moins un des R₁ dans le nombre de d1 et au moins un des R₂ dans le nombre de d2 sont liés l'un à l'autre pour former un groupe carbocyclique en C₅-C₆₀ non substitué ou substitué par R₁₀ₐ ou un groupe hétérocyclique en C₂-C₆₀ non substitué ou substitué par au moins un R₁₀ₐ, et
R₁₀ₐ est tel que défini dans la formule 1.

5. Composé organométallique selon l'une des revendications 1 à 4, dans lequel un groupe représenté par 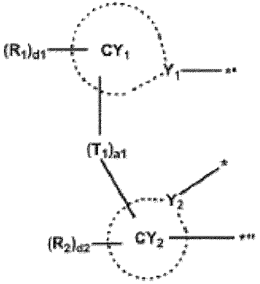 dans la formule 1 est représenté par la formule 2-1 ou 2-2 : 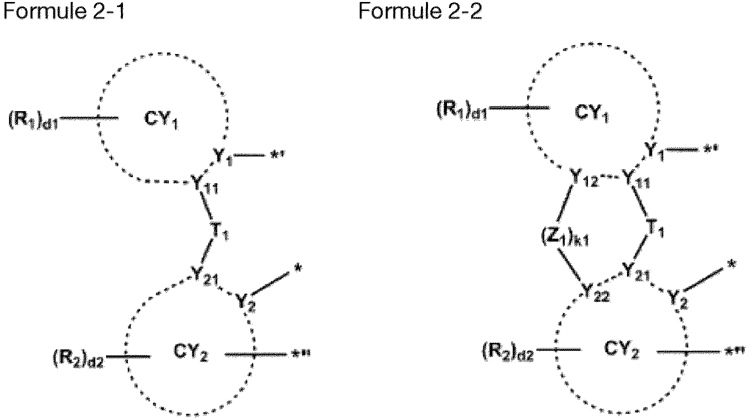
dans lequel, dans les formules 2-1 et 2-2,
CY₁, CY₂, Y₁, Y₂ et T₁ sont chacun tels que définis dans la formule 1,
Y₁₁, Y₁₂, Y₂₁ et Y₂₂ sont chacun indépendamment C ou N,
Z₁ est une liaison simple, une liaison double, *‴-N[(L₆₀)_{b60}-(R₆₀)]-*ʺʺ, *‴-B(R₆₀)-*ʺʺ, *‴-P(R₆₀)-*ʺʺ, *‴-C(R₆₀ₐ)(R_{60b})-*ʺʺ, *‴-Si(R₆₀ₐ)(R_{60b})-*ʺʺ, *‴-Ge(R₆₀ₐ)(R_{60b})-*ʺʺ, *‴-S-*ʺʺ, *‴-Se-*ʺʺ, *‴-O-*ʺʺ, *‴-C(=O)-*ʺʺ, *‴-S(=O)-*ʺʺ, *‴-S(=O)₂-*ʺʺ, *‴-C(R₆₀)=*ʺʺ ou *‴=C(R₆₀)-*ʺʺ,
k₁ est un nombre entier de 1 à 3,
L₆₀ est une liaison simple, un groupe carbocyclique en C₅-C₃₀ qui est non substitué ou substitué par au moins un R₁₀ₐ, ou un groupe hétérocyclique en C₁-C₃₀ qui est non substitué ou substitué par au moins un R₁₀ₐ,
b₆₀ est un nombre entier de 1 à 3,
R₆₀, R₆₀ₐ et R_{60b} sont chacun définis comme R₁ dans la formule 1, et R₁₀ₐ est tel que défini dans la formule 1,
*' indique un site de liaison à Aₗ dans la formule 1,
* indique un site de liaison à M₁ dans la formule 1,
*" indique un site de liaison à T₂ dans la formule 1, et
*ʺʺ et *"" indiquent chacun un site de liaison à un atome voisin.

6. Composé organométallique selon l'une des revendications 1 à 5, dans lequel un groupe représenté par 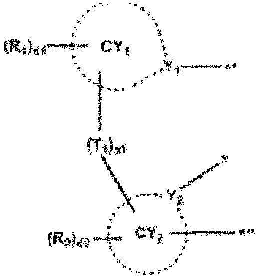 dans la formule 1 est un groupe représenté par une choisie parmi les formules 2-11 à 2-13 : 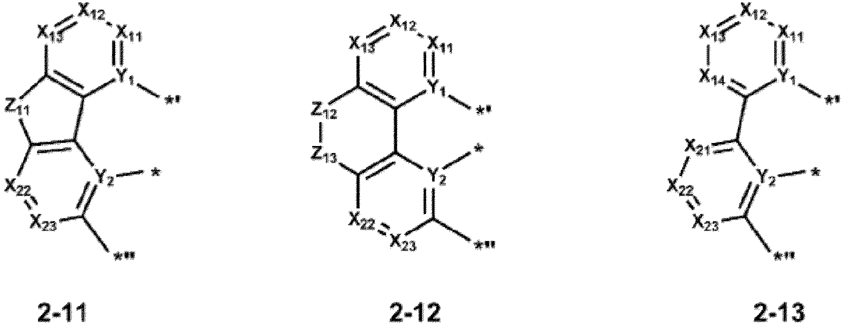
dans lequel, dans les formules 2-11 à 2-13,
Y₁ et Y₂ sont tels que définis dans la formule 1,
X₁₁ est C(R₁₁) ou N, X₁₂ est C(R₁₂) ou N, X₁₃ est C(R₁₃) ou N, et X₁₄ est C(R₁₄) ou N,
X₂₁ est C(R₂₁) ou N, X₂₂ est C(R₂₂) ou N, et X₂₃ est C(R₂₃) ou N,
R₁₁ à R₁₄ sont chacun définis comme R₁ dans la formule 1,
R₂₁ à R₂₃ sont chacun définis comme R₂ dans la formule 1,
deux groupes voisins ou plus parmi R₁₁ à R₁₄ ou R₂₁ à R₂₃ sont facultativement liés les uns aux autres pour former un groupe carbocyclique en C₅-C₆₀ non substitué ou substitué par au moins un R₁₀ₐ ou un groupe hétérocyclique en C₂-C₆₀ non substitué ou substitué par au moins un R₁₀ₐ,
Z₁₁ est *‴-N[(L₆₁)_{b61}-(R₆₁)]-*ʺʺ, *‴-O-*ʺʺ, *‴-S-*ʺʺ, *'"-Se-*"", ou *‴-C(R₆₁ₐ)(R_{61b})-*ʺʺ,
Z₁₂ est *‴-N[(L₆₂)_{b62}-(R₆₂)]-*ʺʺ, *‴-C(R₆₂ₐ)(R_{62b})-*ʺʺ, *‴-C(R₆₂)=*ʺʺ, ou *‴=C(R₆₂)-*ʺʺ,
Z₁₃ est *‴-N[(L₆₃)_{b63}-(R₆₃)]-*ʺʺ, *‴-C(R₆₃ₐ)(R_{63b})-*ʺʺ, *‴-C(R₆₃)-*ʺʺ-, ou *‴=C(R₆₃)-*ʺʺ,
L₆₁ à L₆₃ sont chacun indépendamment une liaison simple, un groupe carbocyclique en C₅-C₃₀, non substitué ou substitué par au moins un R₁₀ₐ, ou un groupe carbocyclique en C₁-C₃₀ non substitué ou substitué par au moins un R₁₀ₐ,
b61 à b63 sont chacun indépendamment un nombre entier de 1 à 3, R₆₁, R₆₁ₐ, R_{61b}, R₆₂, R₆₂ₐ, R_{62b}, R₆₃, R₆₃ₐ et R_{63b} sont chacun identiques définis comme R₁ dans la formule 1, et R₁₀ₐ est tel que défini dans la formule 1,
*' indique un site de liaison à A₁ dans la formule 1,
* indique un site de liaison à M₁ dans la formule 1,
*" indique un site de liaison à T₂ dans la formule 1, et
*‴ et *"" indiquent chacun un site de liaison à un atome voisin.

7. Composé organométallique selon l'une des revendications 1 à 6, dans lequel une valeur ³MLCT (un rapport entre la présence de métal triplet et le transfert de charge de ligand) du composé organométallique représenté par la formule 1 est de 10 % ou plus.

8. Composé organométallique selon l'une des revendications 1 à 7, dans lequel au moins un choisi parmi Y₂ et Y₄ est N.

9. Composé organométallique selon l'une des revendications 1 à 8, dans lequel R₃₁ est un groupe représenté par la formule 3 : 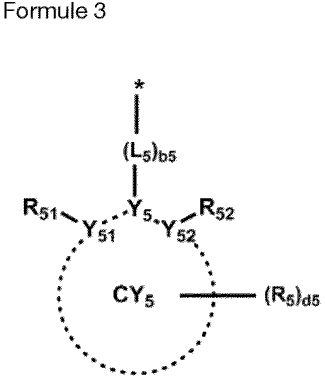
dans lequel, dans la formule 3,
Y₅, Y₅₁ et Y₅₂ sont chacun indépendamment C ou N,
CY₅ est un groupe carbocyclique en C₃-C₆₀ ou un groupe hétérocyclique en C₁-C₆₀,
L₅ est une liaison simple, un groupe carbocyclique en C₅-C₃₀ qui est non substitué ou substitué par au moins un R₁₀ₐ, ou un groupe hétérocyclique en C₁-C₃₀ qui est non substitué ou substitué par au moins un R₁₀ₐ,
b5 est un nombre entier de 1 à 3,
R₅, R₅₁ et R₅₂ sont chacun définis comme R₁ dans la formule 1,
d5 est un nombre entier de 0 à 10, et
* indique un site de liaison à un atome voisin.

10. Composé organométallique selon l'une des revendications 1 à 9,
le composé organométallique étant choisi parmi les composés D01 à D36 :

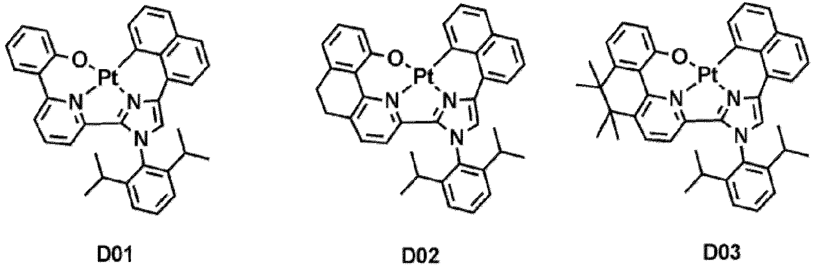

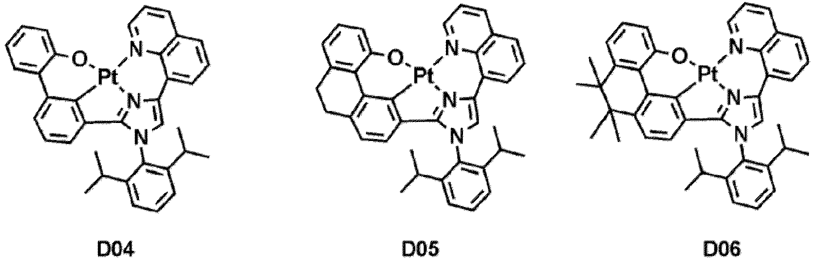

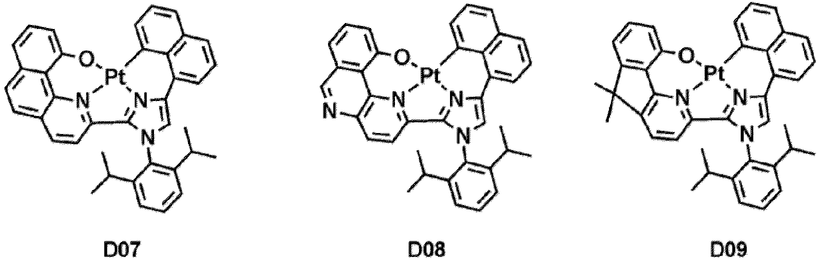

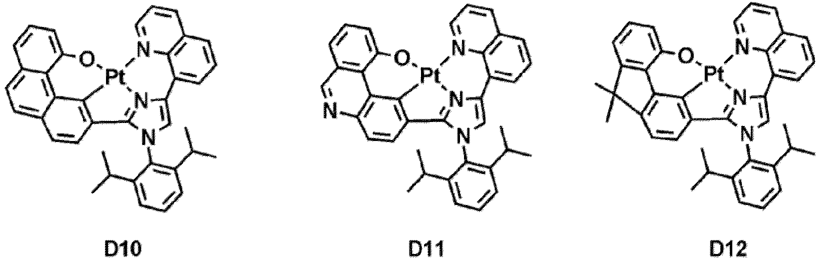

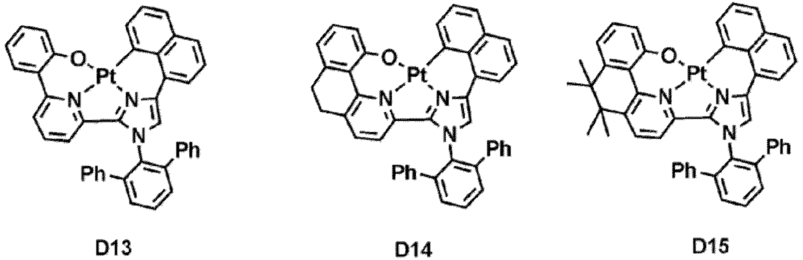

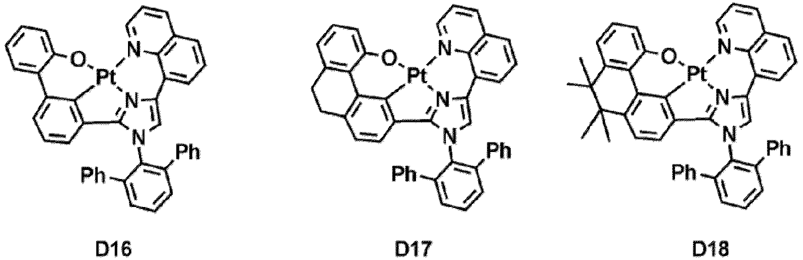

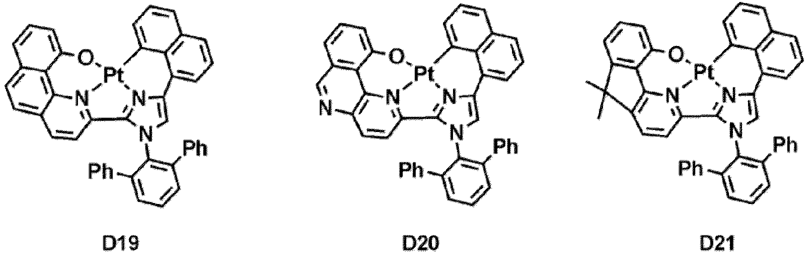

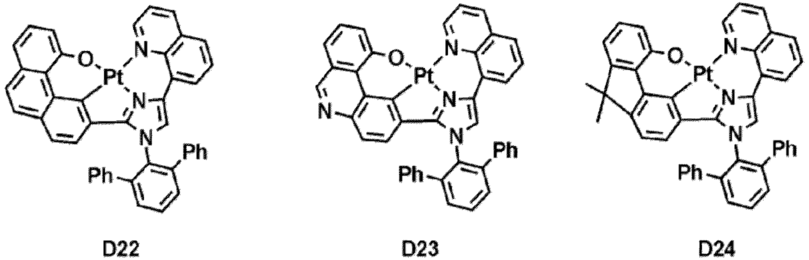

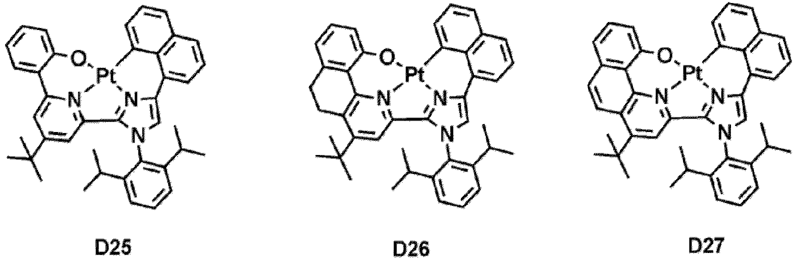

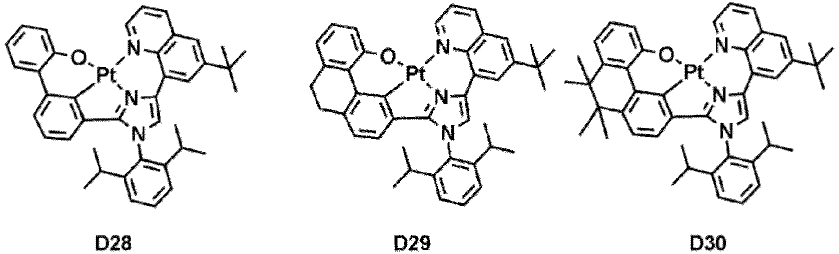

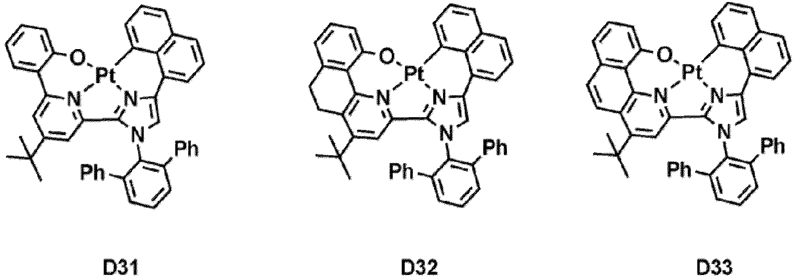

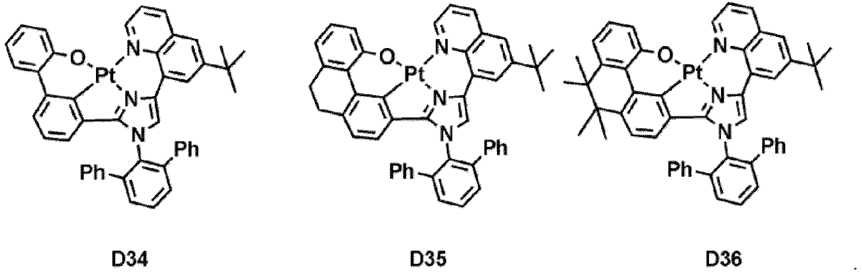

11. Dispositif d'émission de lumière (10), comprenant :
une première électrode (110) ;
une seconde électrode (150) faisant face à la première électrode (110) ;
une couche intermédiaire (130) entre la première électrode (110) et la seconde électrode (150) et comprenant une couche d'émission (150) ; et
au moins un composé organométallique selon l'une des revendications 1 à 10.

12. Dispositif d'émission de lumière (10) selon la revendication 11, dans lequel
la première électrode (110) est une anode,
la seconde électrode (150) est une cathode,
la couche intermédiaire (130) comprend l'au moins un composé organométallique,
la couche intermédiaire (130) comprend en outre une région de transport de trous entre la première électrode (110) et la couche d'émission et une région de transport d'électrons entre la couche d'émission et la seconde électrode (150),
la région de transport de trous comprend une couche d'injection de trous, une couche de transport de trous, une couche auxiliaire d'émission, une couche de blocage d'électrons, ou toutes combinaisons de celles-ci, et
la région de transport d'électrons comprend en outre une couche de blocage de trous, une couche de transport d'électrons, une couche d'injection d'électrons, ou toutes combinaisons de celles-ci.

13. Dispositif d'émission de lumière (10) selon la revendication 11 ou 12, dans lequel la couche d'émission comprend l'au moins un composé organométallique selon l'une des revendications 1 à 10.

14. Dispositif d'émission de lumière (10) selon la revendication 13, dans lequel la couche d'émission comprend en outre un hôte, et une quantité de l'au moins un composé organométallique est dans une plage de 0,01 % en poids à 49,99 % en poids sur la base de 100 % en poids de la couche d'émission.

15. Dispositif d'émission de lumière (10) selon la revendication 13 ou 14, dans lequel la couche d'émission est destinée à émettre une lumière ayant une longueur d'onde d'émission maximale de 590 nm à 670 nm.

16. Appareil électronique comprenant le dispositif d'émission de lumière (10) de l'une des revendications 11 à 15.

17. Appareil électronique selon la revendication 16, comprenant en outre
un transistor à couche mince, dans lequel
le transistor à couche mince comprend une électrode de source (260) et une électrode de drain (270), et
la première électrode (110) du dispositif d'émission de lumière (10) est connectée électriquement à l'électrode de source (260) ou à l'électrode de drain (270) du transistor à couche mince.

18. Appareil électronique selon la revendication 16 ou 17, comprenant en outre un filtre coloré, une couche de conversion de couleur, une couche d'écran tactile, une couche de polarisation, ou toutes combinaisons de ceux-ci.

19. Appareil électronique selon l'une des revendications 16 à 18, comprenant en outre :
un transistor à couche mince ; et
un filtre coloré, une couche de conversion de couleur, une couche d'écran tactile, une couche polarisante, ou toutes combinaisons de ceux-ci, dans lequel le transistor à couche mince comprend une électrode de source (260) et une électrode de drain (270), et
la première électrode (110) du dispositif d'émission de lumière (10) est connectée électriquement à l'électrode de source (260) ou à l'électrode de drain (270).

20. Dispositif électronique (1) comprenant le dispositif d'émission de lumière (10) de l'une des revendications 11 à 15,
le dispositif électronique (1) étant un afficheur plat, un afficheur incurvé, un moniteur d'ordinateur, un moniteur médical, une télévision, un panneau publicitaire, une lampe d'éclairage et/ou de signalisation d'intérieur ou d'extérieur, un dispositif de visualisation tête haute, un afficheur totalement ou partiellement transparent, un afficheur flexible, un afficheur enroulable, un afficheur pliable, un afficheur étirable, une imprimante laser, un téléphone, un téléphone mobile, une tablette, une phablette, un assistant numérique personnel (PDA), un dispositif vestimentaire, un ordinateur portable, un appareil photo numérique, un caméscope, un viseur, un microafficheur, un afficheur 3D, un afficheur à réalité virtuelle ou augmentée, un véhicule (1000), une vidéomosaïque comprenant de multiples afficheurs en mosaïque, un écran de théâtre ou de stade, un dispositif de photothérapie, ou une enseigne.
